# EUROPEAN PATENT APPLICATION

(11) **EP 4 757 557 A1**
(43) Date of publication of application: **10.06.2026**
(21) Application number: 24852239.3
(22) Date of filing: 02.08.2024
(51) Int. Cl.: H10K 59/121, H10K 71/20, H10K 59/122, H10K 59/35, H10K 59/80, H10K 59/12

(54) **METHOD FOR MANUFACTURING ORGANIC LIGHT-EMITTING DISPLAY DEVICE**

(30) Priority: 04.08.2023 KR 20230102412; 09.11.2023 KR 20230154628; 11.06.2024 KR 20240075900; 17.07.2024 KR 20240094563
(71) Applicant: Yas Co., Ltd., Paju-si, Gyeonggi-do 10857 (KR); Ahn, Byungchul, Seoul 06574 (KR)
(72) Inventor: AHN, Byungchul, Seoul 06574 (KR)
(74) Representative: Epping - Hermann - Fischer
(86) International application number: PCT/KR2024/011453
(87) International publication number: WO 2025/033885

(57) **Abstract**

A method for manufacturing an organic light-emitting display device may form an anode electrode on each of a plurality of subpixels, form a plurality of banks between the plurality of subpixels, and form a plurality of protrusion parts on the plurality of banks. Also, the method for manufacturing an organic light-emitting display device may form a first connection structure on a first side portion of a first protrusion part adjacent to a red subpixel, and form a first organic light-emitting element on the red subpixel using a first photolithography process. In addition, the method for manufacturing an organic light-emitting display device may form a second connection structure on a second side portion of the first protrusion part adjacent to a green subpixel and a first side portion of a second protrusion part, and form a second organic light-emitting element on the green subpixel using a second photolithography process. In addition, the method for manufacturing an organic light-emitting display device may form a third connection structure on a second side portion of the second protrusion part adjacent to a blue subpixel, and form a third organic light-emitting element on the blue subpixel using a third photolithography process.

## Description

### [Technical Field]

The embodiment relates to a method for manufacturing an organic light-emitting display device.

### [Background Art]

As the demand for portable information media increases, an attempt to apply an organic light-emitting display device to various lightweight and thin information electronic devices is expanding. Recently, the organic light-emitting display device is being applied to product groups such as a mobile PC and an automobile rather than TV or a mobile phone. Since the organic light-emitting display device applied to the mobile PC or the automobile is driven as still image for a long time, long lifespan is required. In order to have long lifespan, the extraction of light from the organic light-emitting element should be maximized. In addition, in order to reduce the cost, it is necessary to expand the technology to be able to produce organic light-emitting elements on a substrate 110 of not only 8.5^{th} generation (2200x2,500mm) but also 10.5^{th} generation (3370x2940mm). In order to produce long-lifespan organic light-emitting element, each subpixel with a top emission structure and a side-by-side structure must be implemented as a structure of an organic light-emitting element with two or more stacks.

The structure of such an organic light-emitting element may be obtained through a deposition equipment using a fine metal mask (FMM, hereinafter referred to as FMM). However, the deposition method using FMM has the problem of low productivity because the production logistics must be produced only in a cluster method rather than an in-line method. In addition, there is a problem of low pixel position accuracy (PPA) between the FMM and the substrate. Accordingly, the emission area ratio (EAR) is small, which limits the product life. Here, the emission area ratio is the value obtained by dividing the emission area of the subpixel by the area of the subpixel.

Therefore, the development of a new deposition method to solve the aforementioned problems and an organic light-emitting display device having a new structure of the organic light-emitting element using the new deposition method is very urgent.

### [Disclosure]

### [Technical Problem]

An object of the embodiment is to solve the foregoing and other problems.

Another object of the embodiment is to provide an organic light-emitting display device having a novel structure.

Another object of the embodiment is to provide an organic light-emitting display device capable of improving the lifespan.

Another object of the embodiment is to provide an organic light-emitting display device capable of improving productivity and yield.

Another object of the embodiment is to provide an organic light-emitting display device capable of improving image quality.

The technical problems of the embodiments are not limited to those described in this item and comprise those that may be understood through the description of the invention.

### [Technical Solution]

In order to achieve the above or other objects, according to one aspect of the embodiment, a method for manufacturing an organic light-emitting display device, comprising: forming an anode electrode in each of a red subpixel, a green subpixel, and a blue subpixel on a substrate; forming a first bank between the red subpixel and the green subpixel and a second bank between the green subpixel and the blue subpixel; forming a first protrusion part and a second protrusion part on each of the first bank and the second bank, respectively; forming a first connection structure on a first side portion of the first protrusion part adjacent to the red subpixel, and forming a first organic light-emitting element on the red subpixel using a first photolithography process; forming a second connection structure on a second side portion of the first protrusion part adjacent to the green subpixel and a first side portion of the second protrusion part, and forming a second organic light-emitting element on the green subpixel using a second photolithography process; and forming a third connection structure on a second side portion of the second protrusion part adjacent to the blue subpixel, and forming a third organic light-emitting element in the blue subpixel using a third photolithography process, wherein the first organic light-emitting element to the third organic light-emitting element each comprises the anode electrode, an organic light-emitting layer comprising a hole injection layer, and a cathode electrode, wherein the first connection structure to the third connection structure each comprises an auxiliary electrode electrically connected to the cathode electrode in contact with an end of the hole injection layer, and wherein the forming of the first bank and the second bank comprises: forming an open structure configured to isolate the hole injection layer in the first bank and the second bank, respectively.

The forming of the open structure may comprise forming a blocking layer that is inwardly recessed from a first side portion and a second side portion of the first bank and a first side portion and a second side portion of the second bank, respectively.

The forming of the first organic light-emitting element may comprise depositing and patterning a first organic light-emitting layer comprising a first hole injection layer and a first cathode electrode on the substrate to form the first organic light-emitting layer and the first cathode electrode on the red subpixel and the first bank. The first cathode electrode may be in contact with an end of the first hole injection layer and the auxiliary electrode of the first connection structure.

The first organic light-emitting layer may be isolated corresponding to a first open structure formed on the first side portion of the first bank.

The forming of the second organic light-emitting element may comprise depositing and patterning a second organic light-emitting layer comprising a second hole injection layer and a second cathode electrode on the substrate to form the second organic light-emitting layer and the second cathode electrode on the green subpixel, the first bank, and the second bank. The second cathode electrode may be in contact with an end of the second hole injection layer and the auxiliary electrode of the second connection structure.

The second organic light-emitting layer may be isolated corresponding to a second open structure formed on the second side portion of the first bank and the first side portion of the second bank.

The forming of the third organic light-emitting element may comprise depositing and patterning a third organic light-emitting layer comprising a third hole injection layer and a third cathode electrode on the substrate to form the third organic light-emitting layer and the third cathode electrode on the blue subpixel and the second bank. The third cathode electrode may be in contact with an end of the third hole injection layer and the auxiliary electrode of the third connection structure.

The third organic light-emitting layer may be isolated corresponding to a third open structure formed on the second side portion of the second bank.

The forming of the cathode electrode may comprise forming a first conductive layer configured to electrically connect to the auxiliary electrode, and the first challenge layer may comprise a Mg:Ag alloy.

The forming of the cathode electrode may comprise forming a first conductive layer and a second conductive layer on the first conductive layer to electrically connect to the auxiliary electrode, the first conductive layer may comprise a Mg:Ag alloy, and the second conductive layer may comprise a transparent conductive oxide material.

The method may further comprise forming a first color filter layer to a third color filter layer on the first organic light-emitting element to the third organic light-emitting element.

The method may further comprise forming an encapsulation layer on the first organic light-emitting element, the second organic light-emitting element, and the third organic light-emitting element.

### [Advantageous Effects]

The effects of the organic light-emitting display device according to the embodiment are described as follows.

According to at least one of the embodiments, there is an advantage that the process is simplified and the process cost can be reduced because there is no need to use an FMM.

According to at least one of the embodiments, there is an advantage that the EAR within the subpixel is increased because there is no need to use an FMM, so that the lifespan can be improved.

According to at least one of the embodiments, there is an advantage that the productivity, yield, and material utilization efficiency can be improved by depositing the organic light-emitting element on a large-area substrate in an in-line deposition system.

Additional scope of applicability of the embodiments will become apparent from the detailed description that follows. However, since various changes and modifications within the idea and scope of the embodiments may be clearly understood by those skilled in the art, the detailed description and specific embodiments, such as preferred embodiments, should be understood as being given by way of example only.

### [Description of Drawings]

FIG. 1 is a plan view schematically illustrating an organic light-emitting display device according to a first embodiment.
FIG. 2 is a plan view illustrating one pixel of FIG. 1.
FIG. 3 is a circuit diagram illustrating an organic light-emitting display device according to an embodiment.
FIG. 4A is a cross-sectional view taken along line A-A' in the pixel of FIG. 2.
FIG. 4B is a cross-sectional view taken along line B-B' in the pixel of FIG. 2.
FIGS. 5A to 5O illustrate a manufacturing process of an organic light-emitting display device according to a first embodiment.
FIG. 6 is an enlarged cross-sectional view of an asymmetric open-connection structure in FIG. 5O.
FIG. 7 is a cross-sectional view illustrating an open structure in FIG. 6.
FIGS. 8A to 8E illustrate a forming process of an open structure according to an embodiment.
FIGS. 9A to 9P illustrate a two-mask process for forming an asymmetric open-connection structure according to an embodiment.
FIGS. 10A to 10H illustrate a one-mask process for forming an asymmetric open-connection structure according to an embodiment.
FIGS. 11A to 11C illustrate another modification process of the process of FIGS. 10E to 10G.
FIGS. 12A to 12D illustrate a process in which a residual film is generated in a process of forming a red subpixel.
FIG. 13A illustrates a residual film generated in a process of forming a red subpixel.
FIG. 13B illustrates a process in which a residual film is not generated.
FIGS. 14A to 14D illustrate a process of forming a red subpixel so that no residual film is generated on the second side portion of the first protrusion part adjacent to the green subpixel.
FIGS. 15A to 15K illustrate a detailed process for forming a red subpixel using a first JIT process technology.
FIGS. 16A to 16J illustrate a detailed process for forming a green subpixel using the first JIT process technology.
FIGS. 17A to 17K illustrate a detailed process for forming a blue subpixel using the first JIT process technology.
FIG. 18 illustrates a substrate structure immediately before performing a second JIT process technology.
FIG. 19 illustrates a first process for forming a connection structure using the second JIT process technology before forming a green organic light-emitting element.
FIG. 20 illustrates a second process for forming a connection structure using the second JIT process technology before forming a green organic light-emitting element.
FIGS. 21A to 21K illustrate a detailed process for forming a red subpixel using the second JIT process technology.
FIGS. 22A to 22M illustrate detailed processes for forming green subpixels and blue subpixels using the second JIT process technology.
FIG. 23 illustrates a substrate structure immediately before performing a third JIT process technology.
FIG. 24 illustrates a process for forming a connection structure before forming a green organic light-emitting element using the third JIT process technology.
FIG. 25 illustrates an organic light-emitting display device manufactured using the third JIT process technology.

The sizes, shapes, dimensions, etc. of elements illustrated in the drawings may differ from actual ones. In addition, even if the same elements are illustrated in different sizes, shapes, dimensions, etc. between the drawings, this is only an example on the drawing, and the same elements have the same sizes, shapes, dimensions, etc. between the drawings.

### [Mode for Invention]

Hereinafter, the embodiment disclosed in this specification will be described in detail with reference to the accompanying drawings, but the same or similar elements are given the same reference numerals regardless of reference numerals, and redundant descriptions thereof will be omitted. The suffixes 'module' and 'unit' for the elements used in the following descriptions are given or used interchangeably in consideration of ease of writing the specification, and do not themselves have a meaning or role that is distinct from each other. In addition, the accompanying drawings are for easy understanding of the embodiment disclosed in this specification, and the technical idea disclosed in this specification is not limited by the accompanying drawings. Also, when an element such as a layer, region or substrate is referred to as being 'on' another element, this means that there may be directly on the other element or be other intermediate elements therebetween.

Hereinafter, an organic light-emitting display device having a side-by-side structure manufactured using a photolithography process is disclosed. This structure is called Ph-SbS (side-by-side structure by photolithography). By using the photolithography process, the process can be simplified and the process cost can be reduced because there is no need to use FMM. In addition, the EAR within the subpixel may be increased, so that the lifespan can be improved. In addition, since the organic light-emitting element is deposited on a large-area substrate in an in-line deposition system, productivity, yield, and material utilization efficiency can be improved.

Hereinafter, the red subpixel SPr may be named as a first subpixel, the green subpixel SPg may be named as a second subpixel, and the blue subpixel SPb may be named as a third subpixel. In addition, the red organic light-emitting element 120r may be named as a first organic light-emitting element, the green organic light-emitting element 120g may be named as a second organic light-emitting element, and the blue organic light-emitting element 120b may be named as a third organic light-emitting element.

Hereinafter, the organic light-emitting display device 100 is a top-emission type in which light is emitted in the upper direction of the substrate 110 to display an image, but a bottom-emitting type in which light is emitted in the lower direction of the substrate 110 to display an image may also be included in the technical idea of the present invention.

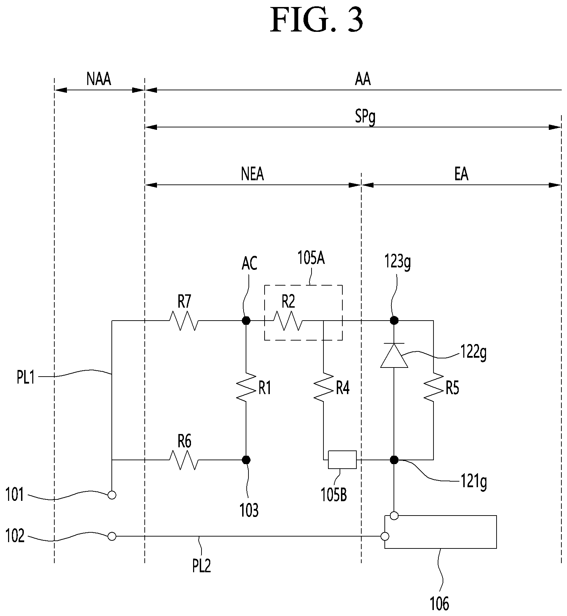

Hereinafter, the drawing reference numeral of the auxiliary electrode may be given as AC as illustrated in FIG. 3 unless a separate drawing reference numeral is given.

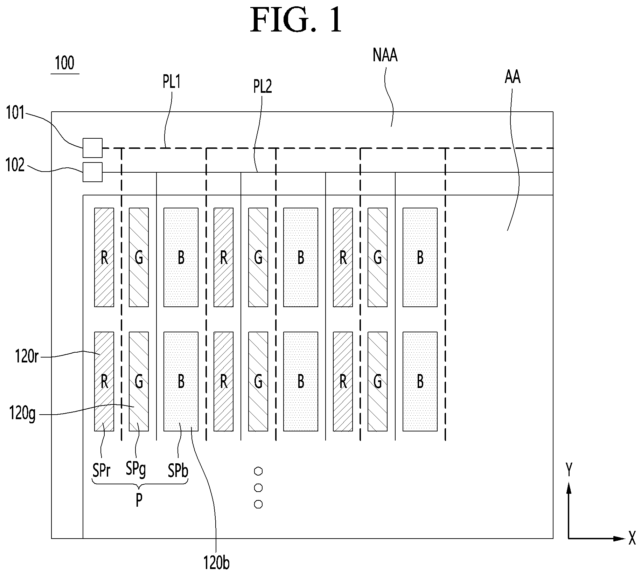

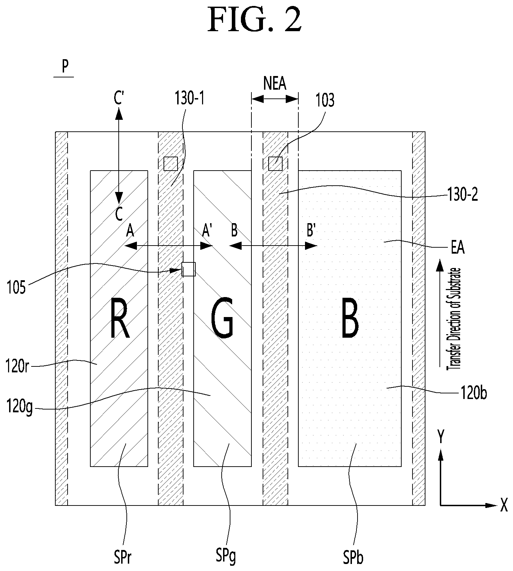

FIG. 1 is a plan view schematically illustrating an organic light-emitting display device according to a first embodiment. FIG. 2 is a plan view illustrating one pixel of FIG. 1.

Referring to FIGS. 1 and 2, the organic light-emitting display device 100 according to the first embodiment may comprise a plurality of pixels P arranged in a matrix. The plurality of pixels P may be positioned in a display region AA. The remaining region excluding the display region AA may be a non-display region NAA.

Each pixel P may comprise, for example, a red subpixel SPr, a green subpixel SPg, and a blue subpixel SPb. For example, a red organic light-emitting element 120r may be disposed in the red subpixel SPr, a green organic light-emitting element 120g may be disposed in the green subpixel SPg, and a blue organic light-emitting element 120b may be disposed in the blue subpixel SPb. The drawing illustrates that one pixel P comprises three subpixels SPr, SPg, and SPb, but more subpixels may be included.

The drawing illustrates that the area of the blue subpixel SPb is greater than the area of the red subpixel SPr or the area of the green subpixel SPg, but other variations are possible.

Each of the subpixels SPr, SPg, and SPb may comprise an emission region EA and a non-emission region NEA. The light-emission region EA is a region where the organic light-emitting element 120r, 120g, and 120b of each the subpixels SPr, SPg, and SPb is disposed, and the non-emission region NEA may be the remaining region excluding the emission region EA in each of the subpixels SPr, SPg, and SPb.

Meanwhile, a first power line PL1 and a second power line PL2 may be provided to supply power to each of the subpixels SPr, SPg, and SPb. A first power terminal 101 may be electrically connected to one end of the first power line PL1, and a second power terminal 102 may be electrically connected to one end of the second power line PL2. The first power terminal 101 and the second power terminal 102 may be electrically connected to a power supply unit (not illustrated) to receive a first potential voltage and a second potential voltage. The second potential voltage is greater than the first potential voltage, and the first potential voltage may be grounded.

The first power line PL1 and the second power line PL2 may be disposed between the non-emission region NEA along a first direction X. The first power line PL1 and the second power line PL2 may be electrically connected to each of the subpixels SPr, SPg, and SPb.

A contact pad 103 may be positioned in the non-emission region NEA. The first power line PL1 may be electrically connected to the contact pad 103.

The auxiliary electrode (AC in FIG. 3) may be positioned in the non-emission region NEA. The auxiliary electrode AC may be positioned in the non-emission region NEA along a second direction Y, but is not limited thereto.

The auxiliary electrode AC may be positioned in the non-emission region NEA adjacent to each of the subpixels SPr, SPg, and SPb. The auxiliary electrode AC may be electrically connected to the first power line PL1 via the contact pad 103.

The first power line PL1, the contact pad 103, and the auxiliary electrode AC may be disposed in different layers.

The auxiliary electrode AC may be electrically connected to the cathode electrodes of the adjacent organic light-emitting elements 120r, 120g, and 120b of the adjacent subpixels SPr, SPg, and SPb. For example, when the auxiliary electrode AC is positioned between the red subpixel SPr and the green subpixel SPg, the auxiliary electrode AC may be electrically connected to the cathode electrode of the red organic light-emitting element 120r and the cathode electrode of the green organic light-emitting element 120g.

Therefore, the auxiliary electrode AC may supply the first potential voltage from the first power line PL1 to the cathode electrodes of the respective organic light-emitting elements 120r, 120g, and 120b.

Meanwhile, the second power line PL2 may be electrically connected to a driving circuit 106 of each of the subpixels SPr, SPg, and SPb, for example, the driving transistor, but is not limited thereto. Accordingly, when a specific subpixel is selected in response to a scan signal provided through a specific gate line, light having a luminance corresponding to the current flowing in the driving transistor of the specific subpixel may be emitted by the first potential voltage of the first power line PL1 and the second potential voltage of the second power line PL2.

The plurality of organic light-emitting elements 120r, 120g, and 120b may be disposed in a stripe shape along the second direction Y. That is, the plurality of organic light-emitting elements 120r, 120g, and 120b may be disposed continuously without being separated along the second direction Y, respectively. For example, the red organic light-emitting elements 120r may be disposed continuously along the second direction Y, the green organic light-emitting elements 120g may be disposed continuously along the second direction Y, and the blue organic light-emitting elements 120b may be disposed continuously along the second direction Y.

As another example, the plurality of organic light-emitting elements 120r, 120g, and 120b may be separated into pixel P units or row-line units along the second direction Y. That is, the red organic light-emitting element 120r may be separated into pixel P units or row-line units along the second direction Y, the green organic light-emitting element 120g may be separated into pixel P units or row-line units along the second direction Y, and the blue organic light-emitting element 120b may be separated into pixel P units or row-line units along the second direction Y.

The red subpixel SPr, the green subpixel SPg, and the blue subpixel SPb may be alternately arranged in a column-line unit along the first direction X. That is, the red subpixel SPr, the green subpixel SPg, and the blue subpixel SPb having different colors may be sequentially positioned along the first direction X to implement an organic light-emitting display device having a side-by-side structure.

Meanwhile, an asymmetric open-connection (AOC) structure 105 may be positioned in a non-emission region NEA. In an embodiment, the asymmetric open-connection structure 105 may comprise a connection structure 105A and an open structure 105B. Due to the different ratios of depth and gap in the undercut structures of the connection structure 105A and the open structure 105B, it can be named as the asymmetric open-connection structure 105. The depth may represent a width in a horizontal direction of the undercut structure, and the gap may represent a width in a vertical direction of the undercut structure.

As will be described later, a lateral leakage current between a plurality of subpixels SPr, SPg, and SPb can be prevented by the asymmetric open-connection structure 105. The lateral leakage current may mean a leakage current flowing between adjacent subpixels SPr, SPg, and SPb along the first direction X. In addition, an electrical short between the anode electrode and the cathode electrode in the corresponding subpixels SPr, SPg, and SPb can be prevented by the asymmetric open-connection structure 105. Therefore, by using the asymmetric open-connection structure 105, color spot due to leakage current can be enhanced and luminescence efficiency and luminance may be significantly improved.

The connection structure 105A may be a structure that electrically connects the auxiliary electrode AC to the cathode electrode of each of the organic light-emitting elements 120r, 120g, and 120b. The open structure 105B may be a structure that separates layers comprising low-resistance organic light-emitting materials of each of the organic light-emitting elements 120r, 120g, and 120b, such as a hole injection layer, a charge generation layer, etc., thereby preventing an electrical short between the anode electrode and the cathode electrode and reducing leakage current between subpixels. The asymmetric open-connection structure 105 may also be called a 'paradoxical open-connection' structure.

FIG. 3 is a circuit diagram illustrating an organic light-emitting display device according to an embodiment. FIG. 3 may be a circuit diagram for an electrical connection from the first power terminal 101 and the second power terminal 102 to the green subpixel SPg in FIG. 2. The circuit diagram illustrated in FIG. 2 may be equally applied to a circuit diagram for an electrical connection from the first power terminal 101 and the second power terminal 102 to the red subpixel SPr or the blue subpixel SPb.

As illustrated in FIG. 3, the first power terminal 101 and the second power terminal 102 may be disposed in the non-display region NAA, and the first power line PL1 and the second power line PL2 may be disposed in the non-display region NAA and the display region AA.

The contact pad 103 may be disposed in the non-emission area NEA and may be electrically connected to the first power line PL1. The first power line PL1 may be electrically connected to the auxiliary electrode AC through the contact pad 103.

The organic light-emitting element 120g may be disposed in the emission area EA of the subpixel SPg, and the connection structure 105A and the open structure 105B may be disposed in the non-emission area NEA. The asymmetric open-connection structure 105 illustrated in FIG. 2 may be configured by the connection structure 105A and the open structure 105B. The auxiliary electrode AC may be electrically connected to the cathode electrode 123g of the organic light-emitting element 120g through the connection structure 105A. The hole injection layer of the organic light-emitting element 120g may be electrically isolated by the open structure 105B between the anode electrode 121g and the cathode electrode 123g.

As illustrated in FIG. 3, various resistances may be formed between each component. Each resistance may be defined as follows.
R1: Contact resistance between the contact pad 103 and the auxiliary electrode AC
R2: Resistance between the auxiliary electrode AC and the cathode electrode
R4: Resistance between the anode electrode 121g and the cathode electrode 123g due to the hole injection layer, etc., disposed in the horizontal direction
R5: Resistance between the anode electrode 121g and the cathode electrode 123g due to the plurality of organic light-emitting layers disposed in the vertical direction
R6: Resistance between the first power line PL1 and the contact pad 103
R7: Resistance between the first power line PL1 and the auxiliary electrode AC

Among the above-mentioned resistances, since the hole injection layer, etc., forming the fourth resistance R4 is made of a low-resistance organic light-emitting material, leakage current easily flows through the hole injection layer, etc. When leakage current flows through the hole injection layer, etc., the electrical short between the anode electrode 121g and the cathode electrode 123g may cause light not to be emitted from the corresponding subpixels SPr, SPg, and SPb, or the luminance of the light may be significantly lower than the desired luminance.

In the embodiment, the hole injection layer corresponding to the open structure 105B may be isolated by the open structure 105B, thereby blocking the leakage current flowing through the hole injection layer, etc.

In the embodiment, the cathode electrode 123g may be easily connected to the auxiliary electrode AC through the connection structure 105A, and the deposition area of the organic light-emitting element 120g may be maximized, thereby improving the luminescence efficiency.

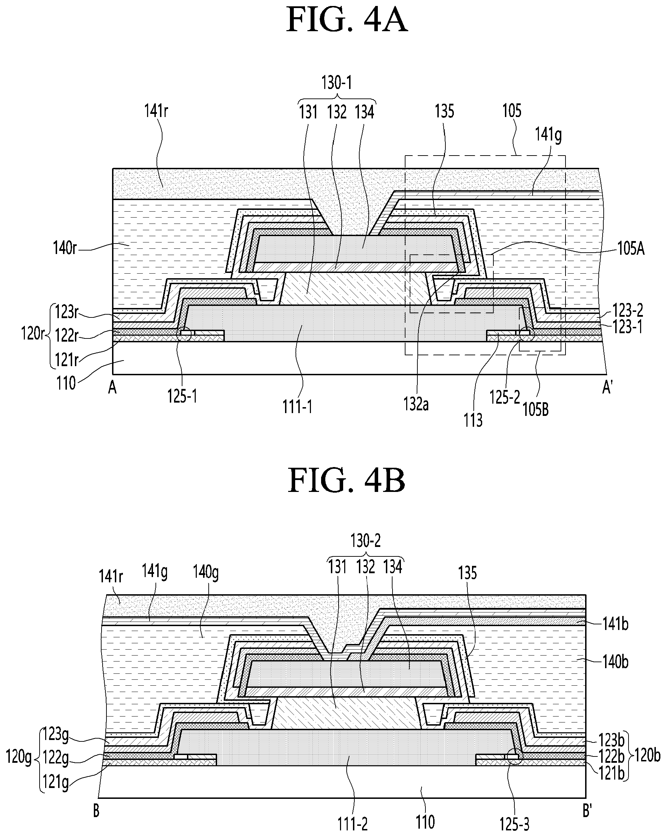

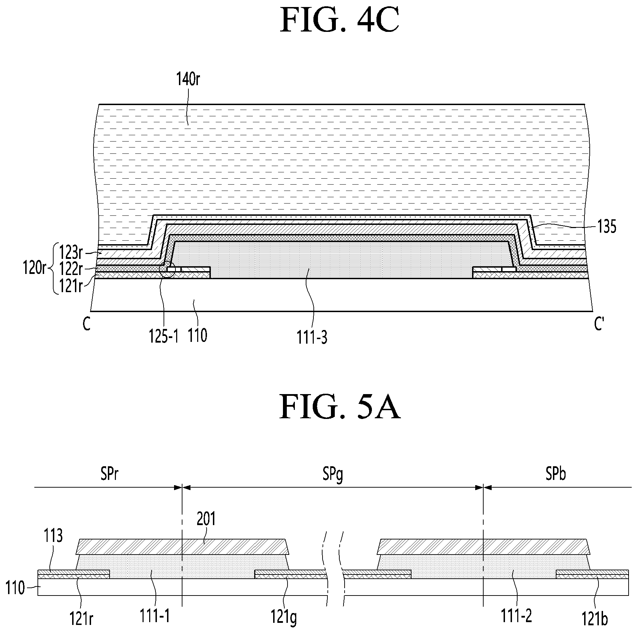

FIG. 4A is a cross-sectional view taken along the line A-A' in the pixel of FIG. 2. FIG. 4B is a cross-sectional view taken along the line B-B' in the pixel of FIG. 2. FIG. 4C is a cross-sectional view taken along the line C-C' in the pixel of FIG. 2.

Referring to FIG. 1, FIG. 2, and FIG. 4A to FIG. 4C, an organic light-emitting display device according to an embodiment may comprise a plurality of banks 111-1 and 111-2, a plurality of protrusion parts 130-1 and 130-2, a plurality of organic light-emitting elements 120r, 120g, and 120b, etc.

A plurality of banks 111-1 and 111-2, a plurality of protrusion parts 130-1 and 130-2, and a plurality of organic light-emitting elements 120r, 120g, and 120b may be disposed on a substrate 110. A plurality of banks 111-1 and 111-2, a plurality of protrusion parts 130-1 and 130-2, and/or a plurality of organic light-emitting elements 120r, 120g, and 120b may be disposed on the substrate 110 in a stripe shape along the second direction Y, respectively. In this instance, subpixels of the same color may be disposed along the second direction Y. For example, a plurality of red subpixels SPr may be disposed in a stripe shape along the second direction Y. The banks 111-1 and 111-2 may comprise an inorganic material or an organic material. For example, the banks 111-1 and 111-2 may comprise an inorganic material such as SiNx, SiON, etc.

Meanwhile, as illustrated in FIG. 4C, the transverse banks 111-3 may be disposed in a row-line unit along the second direction Y. Alternatively, the protrusion parts may not be disposed in a row-line unit along the second direction Y. That is, the protrusion part along the second direction Y may not be disposed on the transverse bank 111-3.

The first bank 111-1 and the second bank 111-2 may be called longitudinal banks to distinguish them from the transverse bank 111-3.

The plurality of subpixels SPr, SPg, and SPb may be separated from each other by the plurality of banks 111-1 and 111-2. The first bank 111-1 may be disposed between the red subpixel SPr and the green subpixel SPg, and the second bank 111-2 may be disposed between the green subpixel SPg and the blue subpixel SPb. Although not illustrated, the third bank may be disposed between the blue subpixel SPb and another red subpixel SPr.

The plurality of organic light-emitting elements 120r, 120g and 120b may be spatially separated and electrically isolated from each other by the plurality of banks 111-1 and 111-2. Accordingly, the lateral leakage current between the plurality of subpixels SPr, SPg and SPb may be blocked, so that color spot can be enhanced and the luminescence efficiency and luminance can be improved.

The red organic light-emitting element 120r may be disposed in the red subpixel SPr, the green organic light-emitting element 120g may be disposed in the green subpixel SPg, and the blue organic light-emitting element 120b may be disposed in the blue subpixel SPb.

The plurality of banks 111-1 and 111-2 may have a lattice shape. For example, the banks 111-1 and 111-2 may be disposed along the perimeter of the subpixels SPr, SPg and SPb. That is, the plurality of banks 111-1 and 111-2 may be disposed between the adjacent subpixels SPr, SPg and SPb along the first direction X, and between the adjacent subpixels SPr, SPg and SPb along the second direction Y. In this instance, the adjacent subpixels SPr, SPg and SPb along the first direction X may have different colors, while the adjacent subpixels SPr, SPg and SPb along the second direction Y may have the same color.

The plurality of organic light-emitting elements 120r, 120g and 120b may be separated from each other by the plurality of banks 111-1 and 111-2. The plurality of banks 111-1 and 111-2 may be disposed to distinguish the plurality of organic light-emitting elements 120r, 120g and 120b, respectively. The red organic light-emitting element 120r and the green organic light-emitting element 120g may be separated by the first bank 111-1, and the green organic light-emitting element 120g and the blue organic light-emitting element 120b may be separated by the second bank 111-2.

Meanwhile, the organic light-emitting display device according to the embodiment may comprise an open structure 105B in an edge region of each of the plurality of banks 111-1 and 111-2. For example, the open structure 105B may be disposed in an edge region of the lower side of each of the plurality of banks 111-1 and 111-2, but is not limited thereto.

The open structure 105B may be disposed in an edge region of the banks 111-1 and 111-2 between the subpixels SPr, SPg, and SPb along the first direction X. The open structure 105B may be disposed in an edge region of the banks 111-1 and 111-2 between subpixels SPr, SPg, and SPb along the second direction Y.

When the organic light-emitting elements 120r, 120g and 120b are deposited on the banks 111-1 and 111-2, some layers of the organic light-emitting elements 120r, 120g and 120b may be isolated by the open structure 105B. For example, the open structure 105B may isolate the low-resistance layers of each of the organic light-emitting elements 120r, 120g and 120b. The low-resistance layers may comprise, for example, a hole injection layer, a charge generation layer, etc. The low-resistance layer may mean a layer having a resistance value lower than the resistance value of a high-resistance layer, for example, an organic light-emitting layer, an electron transport layer, an electron injection layer, etc.

For example, the organic light-emitting layers 122r, 122g and 122b of the organic light-emitting elements 120r, 120g and 120b may have separation structures 125-1 to 125-3 corresponding to the open structure 105B. The separation structures 125-1 to 125-3 may mean a shape in which some layers of the organic light-emitting layers 122r, 122g and 122b are isolated. Accordingly, in the separation structures 125-1 to 125-3, for example, a hole injection layer, a charge generation layer, etc. may be isolated.

The open structure 105B may comprise at least one or more blocking layer 113 which is inwardly recessed from the side portion of the banks 111-1 and 111-2. An undercut structure may be formed in the edge region of the banks 111-1 and 111-2 by the blocking layer 113. The blocking layer 113 may comprise a silicon-based inorganic material, a metal, etc. As the metal, aluminum (Al), molybdenum (Mo), a molybdenum alloy, etc. may be used, but is not limited thereto.

In the case where the organic light-emitting elements 120r, 120g, and 120b are deposited on the banks 111-1 and 111-2 on which the undercut structure is formed in this way, some layers corresponding to the undercut structure, i.e., a hole injection layer, a charge generation layer, etc., among the organic light-emitting layers 122r, 122g, and 122b of the organic light-emitting elements 120r, 120g, and 120b, may be isolated.

Meanwhile, as described above, the organic light-emitting elements 120r, 120g, and 120b corresponding to the subpixels SPr, SPg, and SPb may be disposed, respectively.

The red organic light-emitting element 120r may comprise an anode electrode 121r, a red organic light-emitting layer 122r, a cathode electrode 123r, etc. The red organic light-emitting layer 122r may be disposed on the anode electrode 121r, and the cathode electrode 123r may be disposed on the red organic light-emitting layer 122r. The green organic light-emitting element 120g may comprise an anode electrode 121g, a green organic light-emitting layer 122g, a cathode electrode 123g, etc. The green organic light-emitting layer 122g may be disposed on the anode electrode 121g, and the cathode electrode 123g may be disposed on the green organic light-emitting layer 122g. The blue organic light-emitting element 120b may comprise an anode electrode 121b, a blue organic light-emitting layer 122b, a cathode electrode 123b, etc. The blue organic light-emitting layer 122b may be disposed on the anode electrode 121b, and the cathode electrode 123b may be disposed on the blue organic light-emitting layer 122b.

The anode electrode 121r, 121g, and 121b may comprise a plurality of conductive layers. The anode electrode 121r, 121g, and 121b may have a triple structure composed of ITO/Ag alloy/ITO. The anode electrode 121r, 121g, and 121b may have a triple structure composed of ITO/Ag alloy/(Ti, Mo, or MoTi).

One end of the anode electrode 121r, 121g and 121b may be disposed below the bank 111-1 and 111-2. That is, one end of the bank 111-1 and 111-2 may be disposed on one end of the anode electrode 121r, 121g and 121b. One end of the anode electrode 121r, 121g and 121b may vertically overlap with the bank 111-1 and 111-2.

The red organic light-emitting layer 122r, the green organic light-emitting layer 122g and the blue organic light-emitting layer 122b may comprise at least a hole injection layer comprising a low-resistance organic light-emitting material.

Meanwhile, one end of the hole injection layer and/or the charge generation layer may be in contact with the cathode electrode 123r, 123g, and 123b. In addition, the lower surface of the hole injection layer may be in contact with the anode electrode 121r, 121g, and 121b. In this instance, since the resistance of the hole injection layer is small, a leakage current may flow between the anode electrode 121r, 121g, and 121b and the cathode electrode 123r, 123g, and 123b, and an electrical short may occur between the anode electrode 121r, 121g, and 121b and the cathode electrode 123r, 123g, and 123b.

However, according to an embodiment, since the hole injection layer and/or the charge generation layer are isolated by the open structure 105B disposed in the edge region of the bank 111-1 and 111-2, the anode electrode 121r, 121g, and 121b and the cathode electrode 123r, 123g, and 123b may be electrically disconnected, so that an electrical short can be prevented.

Meanwhile, the organic light-emitting display device according to the embodiment may comprise a plurality of protrusion parts 130-1 and 130-2.

The plurality of organic light-emitting elements 120r, 120g, and 120b may be spatially separated and electrically isolated from each other by the plurality of protrusion parts 130-1 and 130-2. Accordingly, the lateral leakage current between the plurality of subpixels SPr, SPg, and SPb may be blocked, so that color spot can be enhanced and the luminescence efficiency and luminance can be improved.

The plurality of protrusion parts 130-1 and 130-2 may be disposed on the upper side of the plurality of banks 111-1 and 111-2. The first protrusion part 130-1 may be disposed on the upper side of the first bank 111-1 between the red subpixel SPr and the green subpixel SPg. The second protrusion part 130-2 may be disposed on the upper side of the second bank 111-2 between the green subpixel SPg and the blue subpixel SPb.

The left side portion and the right side portion of the protrusion part 130-1 and 130-2 may have shapes that are symmetrical with respect to the center normal of the protrusion part 130-1 and 130-2, but are not limited thereto. For example, the left side portion and right side portion of the protrusion parts 130-1 and 130-2 may each have an undercut structure. In this instance, the undercut structure on the left side portion and the undercut structure on the right side portion may have shapes that are symmetrical with respect to the center normal of the protrusion part 130-1 and 130-2.

The protrusion part 130-1 and 130-2 may have a connecting structure 105A comprising an auxiliary electrode AC electrically connected to the cathode electrode 123r, 123g, and 123b.

The protrusion part 130-1 and 130-2 may comprise a first layer 131 and a second layer 132 on the first layer 131.

The side portion of the first layer 131 may be recessed into the inside of the protrusion part from the side portion of the second layer 132. Accordingly, an undercut structure may be formed on the side portion of the protrusion part by the first layer 131 and the second layer 132. The undercut structure may have a cave shape. For example, the undercut structure may have a U-cave shape. Accordingly, the undercut structure may be called a cave, a U-cave, a cave portion, etc. In order to form the undercut structure, the first layer 131 and the second layer 132 may have different etching selectivity. For example, the first layer 131 may comprise a material having a high etching rate, and the second layer 132 may comprise a material having a low etching rate. Accordingly, when the first layer 131 and the second layer 132 are etched after a photosensitive pattern is formed on the second layer 132, the side portion of the first layer 131 may be etched faster than the side portion of the second layer 132, so that the undercut structure can be formed on the side portion of the protrusion part 130-1 and 130-2.

The first layer 131 and/or the second layer 132 may comprise a metal or a conductive oxide material having excellent electrical conductivity. As the metal, titanium (Ti), molybdenum (Mo), molybdenum-titanium (MoTi), aluminum (Al), copper (Cu), and alloys thereof may be used. As the conductive oxide material, ITO, IZO, etc. may be used.

Meanwhile, by adjusting the target-source distance of the evaporation source (or the evaporation source device), the deposition material may be deposited on the substrate 110 at different deposition angles. The target-source distance may be the distance between the evaporation source and the substrate 110. The deposition angle may be the angle of a virtual line between the evaporation source and the lower edge 132a of the second layer 132 with respect to the normal direction. For example, the larger the target-source distance, the smaller the deposition angle can be. The smaller the deposition angle, the closer the layer formed by the deposition material may be deposited to the adjacent subpixel. The larger the deposition angle, the closer the corresponding layer may be deposited to the protrusion part 130-1 and 130-2.

As illustrated in FIGS. 4A, 4B, and 4C, since the deposition materials are deposited at different deposition angles, one end of the organic light-emitting layer 122r, 122g, and 122b and one end of the first conductive layer 123-1 of the cathode electrode 123r, 123g, and 123b may be positioned differently from each other.

The cathode electrode 123r, 123g, and 123b may comprise a plurality of conductive layers 123-1 and 123-2. For example, the cathode electrode 123r, 123g and 123b may comprise a first conductive layer 123-1 and a second conductive layer 123-2 on the first conductive layer 123-1, but three or more conductive layers may be included.

One end of the organic light-emitting layer 122r, 122g and 122b and one end of the first conductive layer 123-1 may be positioned on the upper side of the bank 111-1 and 111-2. For example, one end of the organic light-emitting layer 122r, 122g and 122b may be positioned closer to the first layer 131 than one end of the first conductive layer 123-1.

The second conductive layer 123-2 may be disposed on the entire region of the substrate 110. The second conductive layer 123-2 may be deposited by using a sputtering process. That is, the second conductive layer 123-2 may be disposed on the upper side of the first conductive layer 123-1 of each of the subpixels SPr, SPg, and SPb, the upper side of the bank 111-1 and 111-2, and the side portion and upper side of the protrusion part 130-1 and 130-2. The second conductive layer 123-2 may be in contact with the side portion of the first layer 131 and/or the lower side of the second layer 132.

For example, the first conductive layer 123-1 may comprise a metal having excellent electrical conductivity, and the second conductive layer 123-2 may comprise a conductive oxide material. For example, the first conductive layer 123-1 may comprise a Mg:Ag alloy, and the second conductive layer 123-2 may comprise ITO, IZO, etc.

The Mg:Ag alloy may be formed as the first conductive layer 123-1 through deposition using an evaporation source. However, since the step coverage characteristics of Mg:Ag are not good, it is difficult for the deposition material comprising the Mg:Ag alloy to be deposited deep inside the undercut structure of the connection structure 105A. In addition, when the uniformity of the film thickness of the first conductive layer 123-1 comprising the Mg:Ag alloy is insufficient or the process margin is insufficient, the first conductive layer 123-1 may not be electrically connected to the auxiliary electrode AC included in the connection structure 105A, resulting in poor electrical connection.

To solve this problem, a conductive oxide material such as ITO having excellent step coverage characteristics may be deposited on the substrate 110 by using a sputtering process, so that it can be deposited deep inside the undercut structure of the connection structure 105A. Accordingly, the second conductive layer 123-2 may be stably deposited on the side portion of the first layer 131, which is the auxiliary electrode AC, so that electrical connection failure between the auxiliary electrode AC and the cathode electrode 123r, 123g, and 123b comprising the first conductive layer 123-1 and the second conductive layer 123-2 can be prevented. In addition, since the uniformity of the film thickness of the first conductive layer is secured, the stability of the production quality can be improved.

When the second conductive layer 123-2 is formed on the first conductive layer 123-1, there is no need to adjust or manage the deposition angle to deposit the first conductive layer 123-1 by using an evaporation source. In addition, even if the organic light-emitting layers 122r, 122g and 122b by using an evaporation source as well as the first conductive layer 123-1 are freely deposited regardless of the deposition angle, the organic light-emitting layers 122r, 122g and 122b may be deposited on the corresponding subpixels SPr, SPg and SPb, and the cathode electrodes 123r, 123g and 123b may be stably connected to the auxiliary electrodes AC of the protrusion parts 130-1 and 130-2 by the second conductive layer 123-2. Therefore, when configured by a combination of the aforementioned connection structure 105A and open structure 105B, productivity and material utilization efficiency can be improved through a freer deposition process.

In addition, when the organic light-emitting display device is implemented in a top emission manner, the luminescence efficiency can be improved by utilizing constructive interference between the anode electrode 121r, 121g and 121b and the cathode electrode 123r, 123g and 123b, by using the cathode electrode 123r, 123g and 123b comprising the first conductive layer 123-1 comprising the Ag:Mg alloy and the anode electrode 121r, 121g and 121b comprising the transflective material.

Meanwhile, the protrusion part 130-1 and 130-2 may comprise a fourth layer 134 on the second layer 132. The fourth layer 134 may be omitted. The fourth layer 134 may comprise an inorganic material such as SiO₂, SiNx, or SiONx. The fourth layer 134 may comprise a conductive oxide material such as ITO. The fourth layer 134 may act as a stopper for the second layer 132. As described above, in order to form a side-by-side structure, the red subpixel SPr, the green subpixel SPg, and the blue subpixel SPb may be etched twice, respectively. At this time, when these two etchings are performed, the area or thickness of the second layer 132 may change. In this instance, the deposition angle determined by the edge 132a on the lower side of the second layer 132 becomes different, and the deposition area of each subpixel SPr, SPg, and SPb becomes different, resulting in a decrease in image quality.

In order to solve the above-mentioned problem, when a fourth layer 134 that acts as a stopper is formed on the second layer 132, even if etching is performed twice, the etching of the second layer 132 may be suppressed or prevented by the fourth layer 134, so that the deposition angle determined by the edge 132a on the lower side of the second layer 132 can be fixed. Accordingly, since the deposition area in each of the subpixels SPr, SPg, and SPb is secured as the target area, the image quality can be improved.

Although not illustrated, the third layer may be disposed below the first layer 131, but is not limited thereto. The third layer may comprise a material having a low etching rate. The third layer may comprise a metal or a conductive oxide material having excellent electrical conductivity. The third layer may comprise an inorganic material having a low etching rate.

When the third layer comprises a metal or a conductive oxide material, the third layer may be an auxiliary electrode AC.

The etching rate of the third layer may be the same as or slower than the etching rate of the second layer 132. When the second layer 132 and the third layer are etched simultaneously, since the etching rate of the third layer is the same as or slower than the etching rate of the second layer 132, the side portion of the third layer may be positioned on the same vertical line as the side portion of the second layer 132 or may be disposed to extend further in the direction of the adjacent subpixel from the side portion of the second layer 132.

Meanwhile, the organic light-emitting display device according to the embodiment may comprise an encapsulation layer 135. The encapsulation layer 135 may be a blocking layer that prevents moisture, etc. from penetrating into the organic light-emitting element 120r, 120g, and 120b.

Meanwhile, the organic light-emitting display device according to the embodiment may comprise a plurality of color filter layers 140r, 140g, and 140b and a plurality of encapsulation layers 141r, 141g, and 141b.

The plurality of color filter layer 140r, 140g, and 140b may comprise a resin material. The plurality of encapsulation layer 141r, 141g, and 141b may comprise a plurality of layers. Some layers of the plurality of layers may comprise an inorganic material and other layers may comprise an organic material.

The red color filter layer 140r may be disposed in the red subpixel SPr. The red color filter layer 140r may be disposed on the red organic light-emitting element 120r in the red subpixel SPr, so that only red light corresponding to the target red wavelength band set in the red color filter layer 140r among the wavelength bands of red light emitted from the red organic light-emitting element 120r may be emitted.

The green color filter layer 140g may be disposed on the green subpixel SPg. The green color filter layer 140g may be disposed on the green organic light-emitting element 120g in the green subpixel SPg, so that only green light corresponding to the target green wavelength band set in the green color filter layer 140g among the wavelength bands of green light emitted from the green organic light-emitting element 120g may be emitted.

The blue color filter layer 140b may be disposed on the blue subpixel SPb. The blue color filter layer 140b is disposed on the blue organic light-emitting element 120b in the blue subpixel SPb, so that only blue light corresponding to the target blue wavelength band set in the blue color filter layer among the wavelength bands of blue light emitted from the blue organic light-emitting element 120b may be emitted.

Each of the plurality of color filter layers 140r, 140g and 140b may have a color filter function that allows only color light of a preset wavelength band to be emitted.

As described above, the plurality of color filter layers 140r, 140g, and 140b may further enhance the color purity of each color compared to when there is no color filter layer, and in particular, may play a role in enhancing the change in color purity according to the viewing angle in an organic light-emitting display device having an upper emission structure. Currently, a polarizing plate may be attached to remove light reflected by the reflective material of the anode electrodes 121r, 121g, and 121b when external light is incident, but the most important role of the plurality of color filter layers 140r, 140g, and 140b is that the plurality of color filter layers 140r, 140g, and 140b may absorb external light to improve the contrast ratio and further contribute to cost reduction by removing the polarizing plate.

Meanwhile, the plurality of color filter layers 140r, 140g, and 140b may have the function of a photosensitive pattern for forming a pattern of the encapsulation layer 135, the cathode electrode 123r, 123g, and 123b, and the organic light-emitting layer 122r, 122g, and 122b, respectively.

As illustrated in FIG. 4A, the encapsulation layer 135, the cathode electrode 123r, and the red organic light-emitting layer 122r may be etched using the red color filter layer 140r, so that they may be formed only in the red subpixel SPr. In this instance, one end of the encapsulation layer 135, one end of the cathode electrode 123r, and one end of the red organic light-emitting layer 122r on the first protrusion part 130-1may be positioned on the same vertical line or diagonal line.

As illustrated in FIG. 4B, the encapsulation layer 135, the cathode electrode 123g, and the green organic light-emitting layer 122g may be etched using the green color filter layer 140g, so that they may be formed only in the green subpixel SPg. In this instance, one end of the encapsulation layer 135, one end of the cathode electrode 123g, and one end of the green organic light-emitting layer 122g on the first protrusion part 130-1 may be positioned on the same vertical line or diagonal line.

As illustrated in FIG. 4C, the encapsulation layer 135, the cathode electrode 123b, and the blue organic light-emitting layer 122b may be etched using the blue color filter layer 140b, so that they may be formed only in the blue subpixel SPb. In this instance, one end of the encapsulation layer 135, one end of the cathode electrode 123b, and one end of the blue organic light-emitting layer 122b on the first protrusion part 130-1 may be positioned on the same vertical line or diagonal line.

As an example, the blue organic light-emitting element 120b, the green organic light-emitting element 120g, and the red organic light-emitting element 120r may be formed in that order, but is not limited thereto.

Meanwhile, the encapsulation layer 141r, 141g, and 141b may comprise a plurality of layers comprising organic materials or inorganic materials.

The encapsulation layers 141r, 141g, and 141b may protect the plurality of color filter layers 140r, 140g, and 140b made of resin materials from being etched. For example, when a blue encapsulation layer 141b is formed on a blue color filter layer 140b used for patterning a blue organic light-emitting element 120b, the blue encapsulation layer 141b can prevent the etching of the blue color filter layer 140b while the green organic light-emitting element 120g is etched. Similarly, when a green encapsulation layer 141g is formed on a green color filter layer 140g used for patterning a green organic light-emitting element 120g, the green encapsulation layer 141g can prevent the etching of the green color filter layer 140g while the red organic light-emitting element 120r is etched. Accordingly, the red encapsulation layer 141r, the green encapsulation layer 141g, and the blue encapsulation layer 141b may serve as stoppers to prevent etching.

Meanwhile, the plurality of color filter layers 140r, 140g, and 140b may each comprise a light scattering agent or a light diffusing agent. Since light is scattered or diffused by the light scattering agent or the light diffusing agent, the luminescence efficiency can be improved.

Meanwhile, the red encapsulation layer 141r, the green encapsulation layer 141g, and the blue encapsulation layer 141b may each comprise a plurality of layers comprising an inorganic material and an organic material.

The red encapsulation layer 141r may be disposed on the red color filter layer 140r, the green encapsulation layer 141g may be disposed on the green color filter layer 140g, and the blue encapsulation layer 141b may be disposed on the blue color filter layer 140b.

The red encapsulation layer 141r, the green encapsulation layer 141g, and the blue encapsulation layer 141b may each comprise at least one or more layer. For example, the red encapsulation layer 141r, the green encapsulation layer 141g, and the blue encapsulation layer 141b may each comprise a first inorganic layer, an organic layer on the first inorganic layer, a second inorganic layer on the organic layer, etc., but are not limited thereto. The first inorganic layer and the second inorganic layer may comprise an inorganic material such as SiNx, and the organic layer may comprise a resin material, but are not limited thereto.

According to an embodiment, a plurality of subpixels SPr, SPg, and SPb may be sequentially formed to manufacture an organic light-emitting display device having a side-by-side structure. For example, a blue organic light-emitting element 120b, a blue color filter layer 140b, and a blue encapsulation layer 141b may be formed and patterned on the entire region of the substrate 110 using a photolithography process, so that a blue subpixel SPb may be formed. Thereafter, a green organic light-emitting element 120g, a green color filter layer 140g, and a green encapsulation layer 141g may be formed and patterned on the entire region of the substrate 110 using a photolithography process, so that a green subpixel SPg may be formed. Thereafter, a red organic light-emitting element 120r, a red color filter layer 140r, and a red encapsulation layer 141r may be formed and patterned using a photolithography process, so that a red subpixel SPr may be formed.

Meanwhile, in the first embodiment (FIGS. 1 and 2), the red organic light-emitting element 120r, the green organic light-emitting element 120g, and the blue organic light-emitting element 120b may be disposed in a stripe shape along the second direction Y.

In contrast, although not illustrated, the red organic light-emitting element 120r, the green organic light-emitting element 120g, and the blue organic light-emitting element 120b may be disposed spaced apart from each other in a dot shape. The red organic light-emitting element 120r may be disposed **in** the red subpixel SPr, the green organic light-emitting element 120g may be disposed in the green subpixel SPg, and the blue organic light-emitting element 120b may be disposed in the blue subpixel SPb. One pixel P may be configured by the red subpixel SPr, the green subpixel SPg, and the blue subpixel SPb.

For example, the red organic light-emitting element 120r and the green organic light-emitting element 120g may be isolated by one row line along the second direction Y, respectively. For example, the blue organic light-emitting element 120b may be isolated by two row lines along the second direction Y.

For example, the area of the blue organic light-emitting element 120b may be greater than the area of the red organic light-emitting element 120r or the green organic light-emitting element 120g. The length of the blue organic light-emitting element 120b in the second direction Y may be similar to the sum of the width of the red organic light-emitting element 120r and the width of the green organic light-emitting element 120g, but is not limited thereto.

In a pixel structure in which the red organic light-emitting element 120r, the green organic light-emitting element 120g, and the blue organic light-emitting element 120b are spaced apart from each other in a dot shape, there is no connection structure (105A of FIG. 4A) between adjacent subpixels along the first direction X, but an asymmetric open-connection structure 105, that is, a connection structure 105A and an open structure 105B, may be provided at least two or more edges of each of the subpixels SPr, SPg, and SPb along the second direction Y.

FIGS. 5A to 5O illustrate a manufacturing process of an organic light-emitting display device according to the first embodiment.

As illustrated in FIG. 5A, anode electrodes 121r, 121g, and 121b and a blocking layer 113 may be each formed on the red subpixel SPr, the green subpixel SPg, and the blue subpixel SPb on the substrate 110 using a first photosensitive pattern (not illustrated).

The substrate 110 may comprise a material having excellent insulating performance. For example, the substrate 110 may comprise a plastic material, a resin material, glass, etc. The substrate 110 may comprise a rigid material or a flexible material.

The anode electrodes 121r, 121g, and 121b may be formed to be spaced apart from each other between the red subpixel SPr, the green subpixel SPg, and the blue subpixel SPb. The blocking layer 113 may be formed to be spaced apart from each other between the red subpixel SPr, the green subpixel SPg, and the blue subpixel SPb.

The anode electrode 121r, 121g, and 121b may comprise a plurality of conductive layers. The anode electrode 121r, 121g, and 121b may have a triple structure composed of ITO/Ag alloy/ITO. The anode electrode 121r, 121g, and 121b may have a triple structure composed of ITO/Ag alloy/(Ti, Mo, or MoTi).

The blocking layer 113 may comprise a silicon-based inorganic material, a metal such as molybdenum (Mo), etc. Aluminum (Al), molybdenum (Mo), a molybdenum alloy, etc. may be used as the metal, but are not limited thereto.

The first photosensitive pattern may be removed.

An inorganic film and a photosensitive film may be formed on the substrate 110, and the photosensitive film may be patterned to form a second photosensitive pattern 201.

The inorganic film may comprise an inorganic material or an organic material. For example, the inorganic film may comprise an inorganic material such as SiNx, SiON, etc.

A first bank 111-1 and a second bank 111-2 may be formed by etching the inorganic film using the second photosensitive pattern 201. The inorganic film 111a may be etched until the blocking layer 113 is exposed in the red subpixel SPr, the green subpixel SPg, and the blue subpixel SPb.

The first bank 111-1 may be formed on the substrate 110 between the red subpixel SPr and the green subpixel SPg. The first bank 111-1 may be disposed on an edge region of the blocking layer 113 between the red subpixel SPr and the green subpixel SPg. The second bank 111-2 may be formed on the substrate 110 between the green subpixel SPg and the blue subpixel SPb. The second bank 111-2 may be disposed on an edge region of the blocking layer 113 between the green subpixel SPg and the blue subpixel SPb.

The blocking layer 113 may be etched using the second photosensitive pattern 201, thereby forming the open structure 105B. The open structure 105B may have an undercut structure in which a side portion of the blocking layer 113 is inwardly recessed from a side portion of the first bank 111-1 and/or the second bank 111-2.

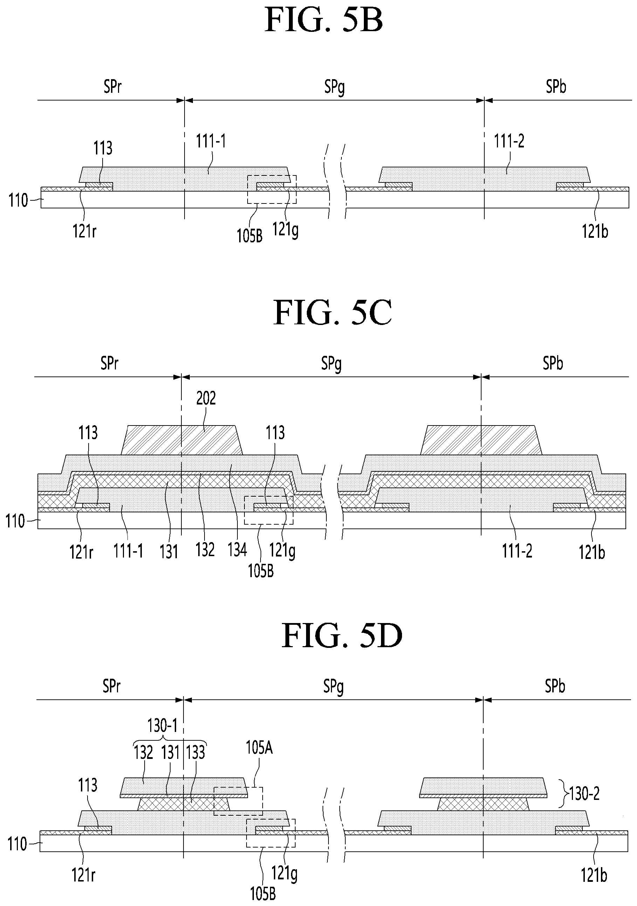

As illustrated in FIG. 5B, the second photosensitive pattern 201 may be removed.

As illustrated in FIG. 5C, the first layer 131, the second layer 132, the fourth layer 134, and the photosensitive film may be formed on the substrate 110, and the photosensitive film may be patterned to form a third photosensitive pattern 202. The fourth layer 134 may be omitted.

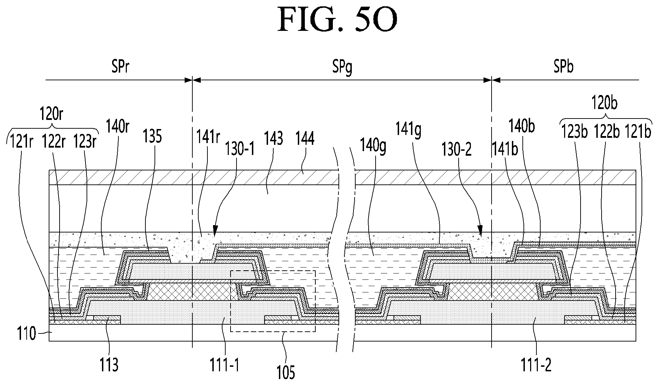

The first layer and the second layer 132 may have different etching selectivity. For example, the etching rate of the first layer 131 may be higher than the etching rate of the second layer 132. At least one of the first layer 131 or the second layer 132 may be an auxiliary electrode for connecting to the cathode electrode (123r, 123g, 123b of FIG. 5O). The auxiliary electrode may be connected to the first power line (PL1 in FIG. 3). Therefore, the cathode electrode 123r, 123g, and 123b may be electrically connected to the first power line PL1 through the auxiliary electrode.

The first layer 131 and/or the second layer 132 may comprise a metal or a conductive oxide material having excellent electrical conductivity. As the metal, titanium (Ti), molybdenum (Mo), molybdenum-titanium (MoTi), aluminum (Al), copper (Cu), an alloy thereof, etc. may be used. As the conductive oxide material, ITO, IZO, etc. may be used.

The fourth layer 134 may comprise an inorganic material such as SiO₂, SiNx, or SiONx. The fourth layer 134 may comprise a conductive oxide material such as ITO. The fourth layer 134 may act as a stopper for the second layer 132. That is, the fourth layer 134 may be used as an etch-stop layer.

Although not illustrated, a third layer may be formed below the first layer 131. That is, the third layer may be formed on the substrate 110, and the first layer 131 may be formed on the third layer. The third layer may comprise, for example, a metal having excellent electrical conductivity or a conductive oxide material. Accordingly, the third layer may be an auxiliary electrode.

As illustrated in FIG. 5D, the fourth layer 134, the second layer 132, and the first layer 131 may be etched using the third photosensitive pattern 202, thereby forming the first protrusion part 130-1 and the second protrusion part 130-2 each having the connection structure 105A. The first protrusion part 130-1 may be formed on the first bank 111-1 between the red subpixel SPr and the green subpixel SPg, and the second protrusion part 130-2 may be formed on the second bank 111-2 between the green subpixel SPg and the blue subpixel SPb.

Since the etching rate of the first layer 131 is greater than the etching rate of the second layer 132, the side portion of the first layer 131 may be etched faster than the side portion of the second layer 132, so that an undercut structure of the connection structure 105A in which the side portion of the first layer 131 is inwardly recessed from the side portion of the second layer 132 may be formed.

When the fourth layer 134 is used as an etch-stop layer, the second layer 132 formed below the fourth layer 134 may be protected from etching by the fourth layer 134, so that the side portion of the second layer 132 and the side portion of the fourth layer 134 may be positioned on the same vertical line or diagonal line.

Meanwhile, although not illustrated, the blocking layer 113 may not be etched in the process illustrated in FIG. 5B, and may also be etched together with the etching of the first layer 131, the second layer, and the fourth layer 134 in the process illustrated in FIG. 5D. Accordingly, since the connection structure 105A and the open structure 105B are formed in batches using the same photosensitive pattern 202, the number of masks can be reduced, the process can be simplified, and the cost can be reduced.

The third photosensitive pattern 202 may be removed.

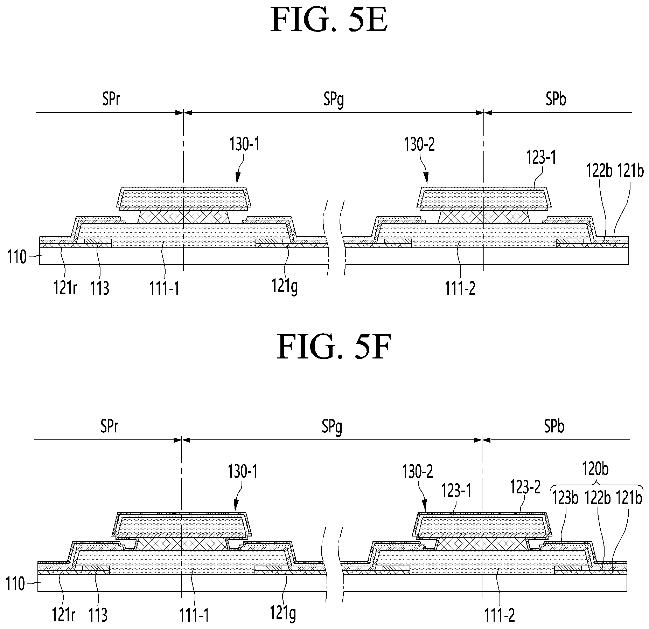

As illustrated in FIG. 5E, a blue organic light-emitting layer 122b and a first conductive layer 123-1 may be formed on the substrate 110.

Although not illustrated, the blue organic light-emitting layer 122b may comprise a hole injection layer, etc. In the case of a blue organic light-emitting element 120b having a two-stack structure, the blue organic light-emitting layer 122b may comprise a hole injection layer, a charge generation layer, etc.

The first conductive layer 123-1 may comprise a single layer comprising a metal such as a Mg:Ag alloy. When a deposition material made of a metal such as a Mg:Ag alloy is deposited on the substrate 110, the first conductive layer 123-1 may be formed on one side region of each of the blue subpixel SPb, the first bank 111-1 and the second bank 111-2. Since the deposition material is not deposited on the inner side of the undercut structure of the connection structure 105A, the first conductive layer 123-1 may not be electrically connected to the auxiliary electrode.

As illustrated in FIG. 5F, a second conductive layer 123-2 and an encapsulation layer (not illustrated) may be formed on the first conductive layer 123-1.

The second conductive layer 123-2 may comprise a conductive oxide material such as ITO. The encapsulation layer may comprise an inorganic material.

A conductive oxide material such as ITO may have excellent step coverage characteristics. Accordingly, since the deposition material made of the conductive oxide material is deposited on the substrate 110 through a sputtering process, the second conductive layer 123-2 may be formed not only on one side region of each of the blue subpixel SPb, the first bank 111-1 and the second bank 111-2, but also on the inner side of the undercut structure of the connection structure 105A. Accordingly, the second conductive layer 123-2 may be electrically connected to the auxiliary electrode in the connection structure 105A of the second protrusion part 130-2.

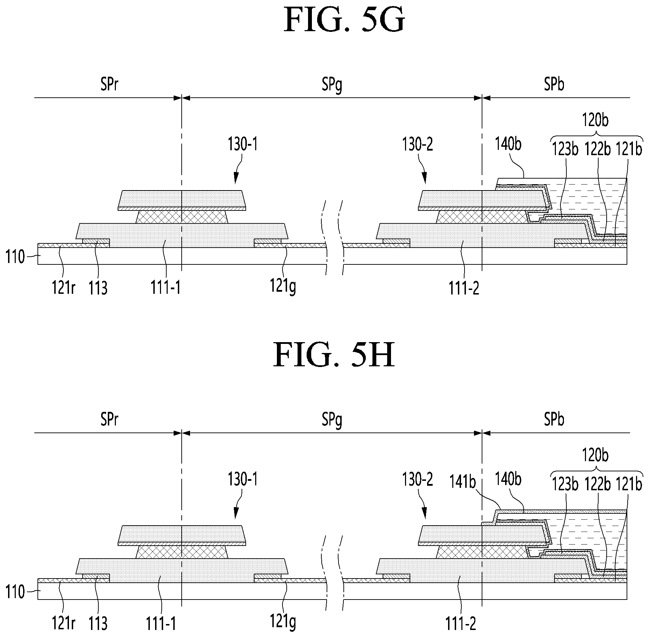

As illustrated in FIG. 5G, a blue color filter layer 140b may be formed on the second conductive layer 123-2. The blue color filter layer 140b may comprise a resin material.

Using a fourth photosensitive pattern (not illustrated), the blue color filter layer 140b, the encapsulation layer, the second conductive layer 123-2, the first conductive layer 123-1, and the blue organic light-emitting layer 122b may be etched, so that the blue color filter layer 140b, the encapsulation layer, the second conductive layer 123-2, the first conductive layer 123-1, and the blue organic light-emitting layer 122b can be formed in the blue subpixel SPb. The blue color filter layer 140b, the encapsulation layer, the second conductive layer 123-2, the first conductive layer 123-1, and the blue organic light-emitting layer 122b may be formed on one side region of the second protrusion part 130-2.

The cathode electrode 123b may be configured by the first conductive layer 123-1 and the second conductive layer 123-2. A blue organic light-emitting element 120b may be configured by an anode electrode 121b, a blue organic light-emitting layer 122b, and a cathode electrode 123b formed in a blue subpixel SPb.

The fourth photosensitive pattern may be removed.

As illustrated in FIG. 5H, a blue encapsulation layer 141b may be formed on the substrate 110.

The blue encapsulation layer 141b may be etched using a fifth photosensitive pattern (not illustrated), so that the blue encapsulation layer 141b may be formed on the blue color filter layer 140b in the blue subpixel SPb.

The fifth photosensitive pattern may be removed.

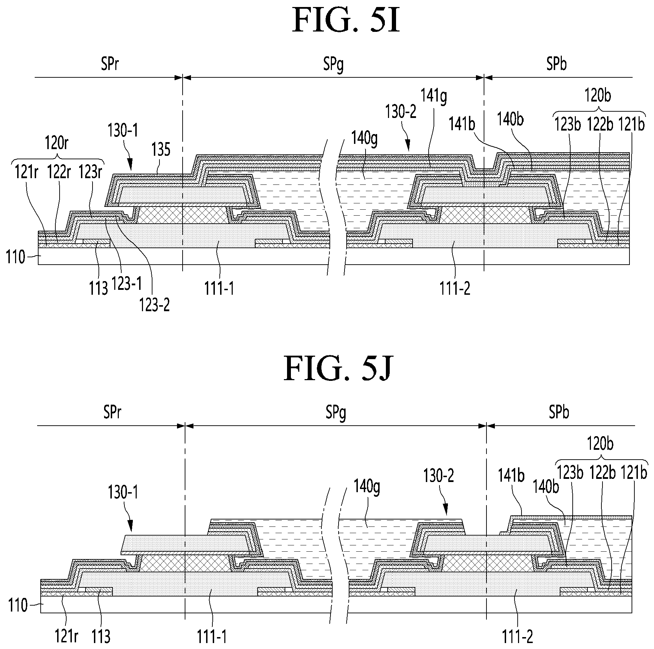

As illustrated in FIG. 5I, a green organic light-emitting layer 122g, a first conductive layer 123-1, a second conductive layer 123-2, and an encapsulation layer 135 may be formed on a substrate 110. A cathode electrode 123g may be configured by the first conductive layer 123-1 and the second conductive layer 123-2. Accordingly, a green organic light-emitting element 120g may be configured by the anode electrode 121g, the green organic light-emitting layer 122g, and the cathode electrode 123g in a green subpixel SPg.

The first conductive layer 123-1 comprising a metal such as Mg:Ag may be not connected to the auxiliary electrode, and the second conductive layer 123-2 comprising a conductive oxide material such as ITO may be connected to the auxiliary electrode in each of the connection structure 105A of the first protrusion part 130-1 and the connection structure 105A of the second protrusion part 130-2.

Although not illustrated, the green organic light-emitting layer 122g may comprise a hole injection layer, etc. In the case of the green organic light-emitting element 120g having a two-stack structure, the green organic light-emitting layer 122g may comprise a hole injection layer, a charge generation layer, etc.

As illustrated in FIG. 5J, a green color filter layer 140g may be formed on the substrate 110. The green color filter layer 140g may comprise a resin material.

Using a sixth photosensitive pattern (not illustrated), the green color filter layer 140g, the encapsulation layer 135, the cathode electrode 123g, and the green organic emission layer 122g may be etched, so that the green color filter layer 140g, the encapsulation layer 135, the cathode electrode 123g, and the green organic emission layer 122g can be formed in the green subpixel SPg. The green color filter layer 140g, the encapsulation layer 135, the cathode electrode 123g, and the green organic emission layer 122g may be formed on one side region of the first protrusion part 130-1 and the other side region of the second protrusion part 130-2.

The sixth photosensitive pattern may be removed.

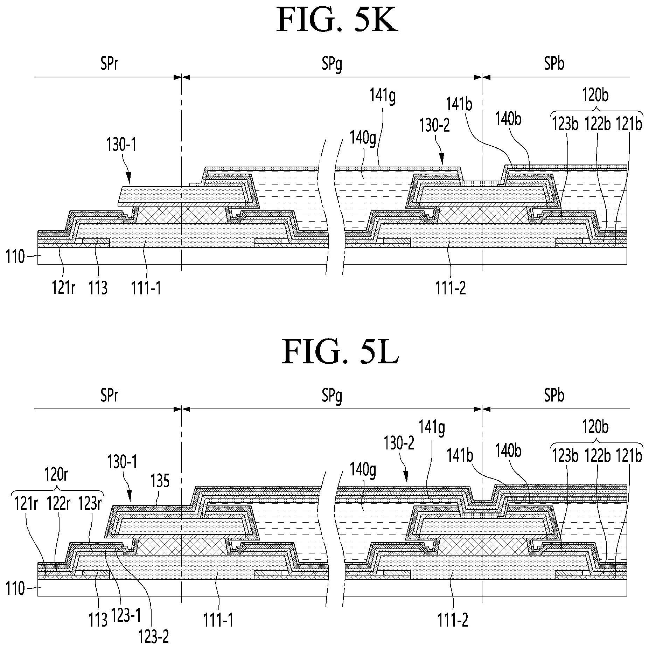

As illustrated **in** FIG. 5K, a green encapsulation layer 141g may be formed on the substrate 110.

Using a seventh photosensitive pattern (not illustrated), the green encapsulation layer 141g may be etched so that the green encapsulation layer 141g can be formed on the green color filter layer 140g in the blue subpixel SPb and the green subpixel SPg. Although not illustrated, the green encapsulation layer 141g may not be formed in the blue subpixel SPb.

The seventh photosensitive pattern may be removed.

As illustrated in FIG. 5L, a red organic light-emitting layer 122r, a first conductive layer 123-1, a second conductive layer 123-2, and an encapsulation layer 135 may be formed on the substrate 110. A cathode electrode 123r may be configured by the first conductive layer 123-1 and the second conductive layer 123-2. Therefore, a red organic light-emitting element 120r may be configured by the anode electrode 121r, the red organic light-emitting layer 122r, and the cathode electrode 123r in the red subpixel SPr.

The first conductive layer 123-1 comprising a metal such as Mg:Ag may be not connected to the auxiliary electrode, and the second conductive layer 123-2 comprising a conductive oxide material such as ITO may be connected to the auxiliary electrode in the connection structure 105A of the first protrusion part 130-1.

Although not illustrated, the red organic light-emitting layer 122r may comprise a hole injection layer, etc. In the case of the red organic light-emitting element 120r having a two-stack structure, the red organic light-emitting layer 122r may comprise a hole injection layer, a charge generation layer, etc.

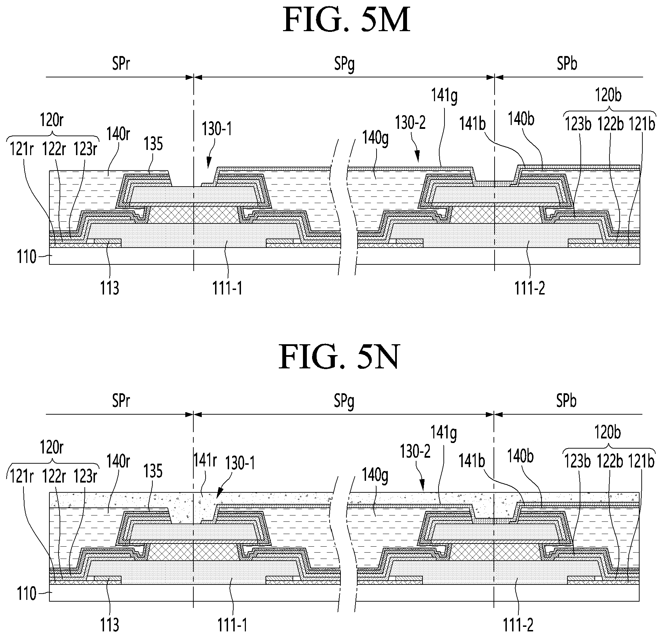

As illustrated in FIG. 5M, a red color filter layer 140r may be formed on the substrate 110. The red color filter layer 140r may comprise a resin material.

Using an eighth photosensitive pattern (not illustrated), the red color filter layer 140r, the encapsulation layer 135, the cathode electrode 123r, and the red organic light-emitting layer 122r may be etched, so that the red color filter layer 140r, the encapsulation layer 135, the cathode electrode 123r, and the red organic light-emitting layer 122r can be formed **in** the red subpixel SPr. The red color filter layer 140r, the encapsulation layer 135, the cathode electrode 123r, and the red organic light-emitting layer 122r may be formed on the other side region of the first protrusion part 130-1.

The eighth photosensitive pattern may be removed.

As illustrated in FIG. 5N, a red encapsulation layer 141r may be formed on the substrate 110.

Using a ninth photosensitive pattern (not illustrated), the red encapsulation layer 141r may be etched so that the red encapsulation layer 141r may be formed on the red color filter layer 140r in the blue subpixel SPb, the green subpixel SPg, and the red subpixel SPr. Although not illustrated, the red encapsulation layer 141r may not be formed **in** the blue subpixel SPb and the green subpixel SPg.

The ninth photosensitive pattern may be removed.

As illustrated in FIG. 5O, a plurality of encapsulation layers 143 and 144 may be formed on the substrate 110. For example, the encapsulation layer 143 may comprise a resin material such as polycaprolactone (PCL), and the encapsulation layer 144 may comprise an inorganic material such as silicon nitride (SiNx).

Thereafter, a pad open process is performed using a tenth photosensitive pattern (not illustrated), so that the first power line (PL1 of FIG. 3) can be electrically connected to the auxiliary electrode through the contact pad 103, as illustrated **in** FIG. 3. The tenth photosensitive pattern may be removed.

Thereafter, after a defect inspection process, a repair process, etc. are performed, a protective film may be attached to the substrate 110, so that an organic light-emitting display device can be manufactured.

In the above, it is described that the blue organic light-emitting element 120b, the green organic light-emitting element 120g, and the red organic light-emitting element 120r are formed in the order, but the order may be changed.

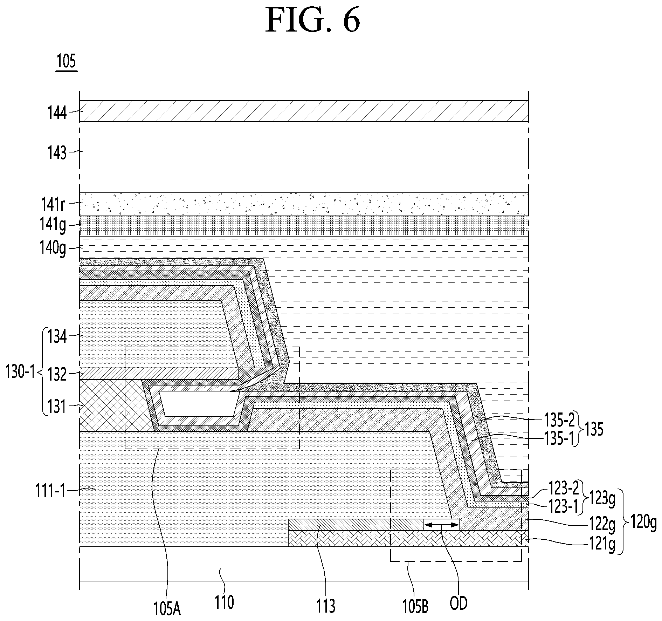

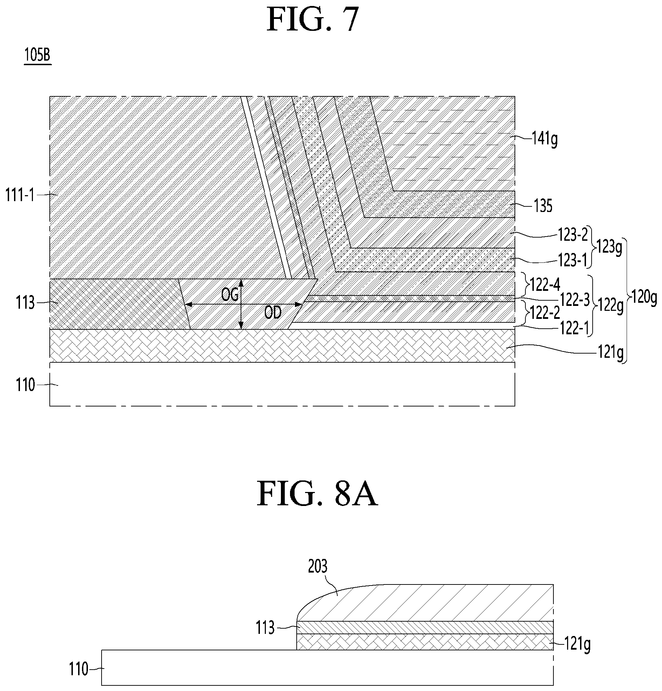

FIG. 6 is an enlarged cross-sectional view of the asymmetric open-connection structure in FIG. 5O. FIG. 7 is a cross-sectional view illustrating the open structure in FIG. 6.

The drawing illustrates the connection structure 105A of the first protrusion part 130-1 and the open structure 105B formed in the first bank 111-1, but the same may be applied to the connection structure of the second protrusion part 130-2 and the open structure formed in the second bank 111-2.

As illustrated in FIG. 6, the connection structure 105A of the first protrusion part 130-1 may have an undercut structure. The green organic light-emitting layer 122g and the first conductive layer 123-1 may be formed **in** the green subpixel SPg by the undercut structure of the connection structure 105A. At this time, even if the first conductive layer 123-1 is not electrically connected to the auxiliary electrode, that is, the first layer 131 and/or the second layer 132, the second conductive layer 123-2 may be electrically connected to the auxiliary electrode in the connection structure 105A. Accordingly, the stability of the electrical connection of the cathode electrode 123g comprising the first conductive layer 123-1 and the second conductive layer 123-2 can be secured.

As illustrated in FIG. 6 and FIG. 7, the green organic light-emitting layer 122g may be isolated by the open structure 105B. The green organic light-emitting element 120g may comprise a hole injection layer, a charge generation layer, etc. In this instance, the hole injection layer and/or the charge generation layer may be isolated corresponding to the open structure 105B. Accordingly, the leakage current flowing through the hole injection layer or the charge generation layer between the anode electrode 121g and the cathode electrode 123g can be blocked, thereby improving the luminescence efficiency and luminance.

The open structure 105B may have an open depth OD and an open gap OD. The open depth OD may be a depth at which the blocking layer 113 is etched. The open gap OD may be a thickness of the blocking layer 113. It is necessary to design the open depth OD and the open gap OD so that at least the charge generation layer is isolated while the cathode electrode 123b of the blue organic light-emitting element 120b having the smallest thickness is not isolated.

Meanwhile, as illustrated in FIG. 5O, the red organic light-emitting layer 122r and the green organic light-emitting layer 122g may be separated from each other on the upper side of the first protrusion part 130-1, and the green organic light-emitting layer 122g and the blue organic light-emitting layer 122b may be separated from each other on the upper side of the second protrusion part 130-2. Accordingly, the leakage current flowing in the first direction X between the red subpixel SPr, the green subpixel SPg, and the blue subpixel SPb, i.e., the lateral leakage current, can be blocked, thereby improving the luminescence efficiency and luminance.

Meanwhile, as described above, the open structure 105B may be formed by the blocking layer 113. During the formation of the open structure 105B, yield management such as dark spot defects is very important.

The anode electrode 121r, 121g, and 121b may have a triple structure composed of ITO/Ag alloy/ITO. The anode electrode 121r, 121g, and 121b may be formed through wet etching. During wet etching, a compound by silver (Ag) may be generated and may remain as particles. Therefore, the removal of particles composed of a compound by Ag may be important for yield management.

In addition, particles generated during dry etching of layers other than the anode electrode 121r, 121g, and 121b may also remain on the surface of the anode electrode 121r, 121g, and 121b, causing dark spot defects.

Referring to FIGS. 8A to 8E, a method of forming an open structure 105B to remove these particles will be described.

FIGS. 8A to 8E illustrate a process for forming an open structure according to an embodiment. The drawings illustrate a process for forming an open structure 105B in a first bank 111-1 adjacent to a green subpixel SPg, but the same process may be applied to a process for forming an open structure in a second bank 111-2.

As illustrated in FIG. 8A, an anode electrode 121g and a blocking layer 113 may be formed on a substrate 110, and a photosensitive pattern 203 may be formed on the blocking layer 113.

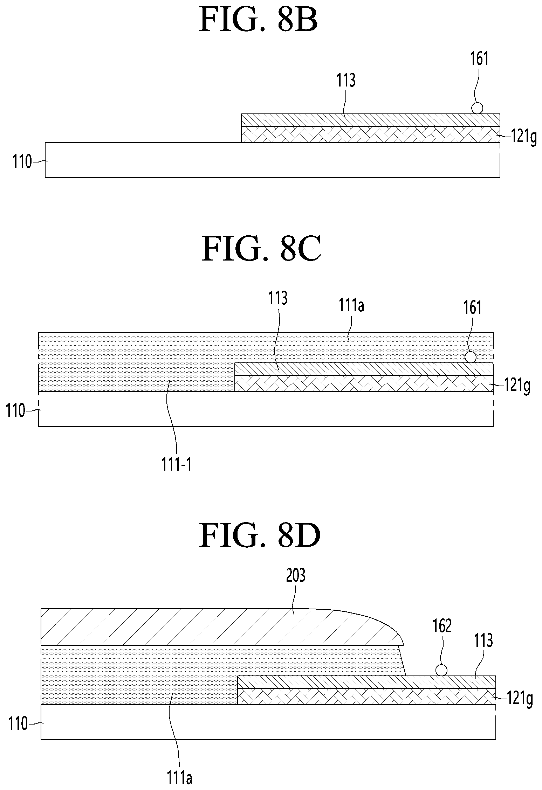

As illustrated in FIG. 8B, the anode electrode 121g and the blocking layer 113 may be etched using the photosensitive pattern 203, so that an anode electrode 121g and the blocking layer 113 can be formed in a green subpixel SPg.

The photosensitive pattern 203 may be removed.

When the photosensitive pattern 203 is removed, the particles 161 may remain on the upper surface of the blocking layer 113.

As illustrated in FIG. 8C, an inorganic film 111a may be formed on the substrate 110. In this instance, the particles 161 may be positioned between the blocking layer 113 and the inorganic film 111a without being removed.

As illustrated in FIG. 8D, a photosensitive pattern 203 may be formed on the inorganic film 111a. The inorganic film 111a may be etched using the photosensitive pattern 203, so that a first bank 111-1 can be formed between the red subpixel SPr and the green subpixel SPg.

Since the inorganic film 111a is etched until the blocking layer 113 is exposed, the particles 161 remaining on the upper surface of the blocking layer 113 can be removed through this etching process.

However, another particles 162 may remain on the upper surface of the blocking layer 113 through the etching of the inorganic film 111a.

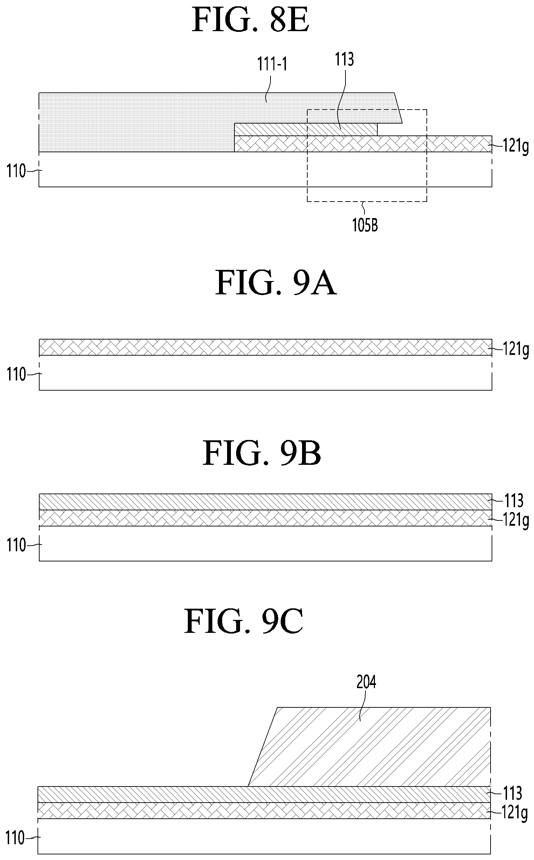

As illustrated in FIG. 8E, the blocking layer 113 may be etched using the photosensitive pattern 203 to form an open structure 105B.

Since the blocking layer 113 is etched until the anode electrode 121g is exposed, another particles 162 remaining on the upper surface of the blocking layer 113 can be removed.

The photosensitive pattern 203 may be removed. The photosensitive pattern 203 may be the second photosensitive pattern 201 illustrated in FIG. 5A.

After each etching process is performed above, a cleaning process may be performed.

In addition to the formation process of the open structure 105B as described above, the particles 161 and 162 generated during wet etching or dry etching may be removed through the cleaning process performed after each etching process, thereby preventing poor image quality and improving yield.

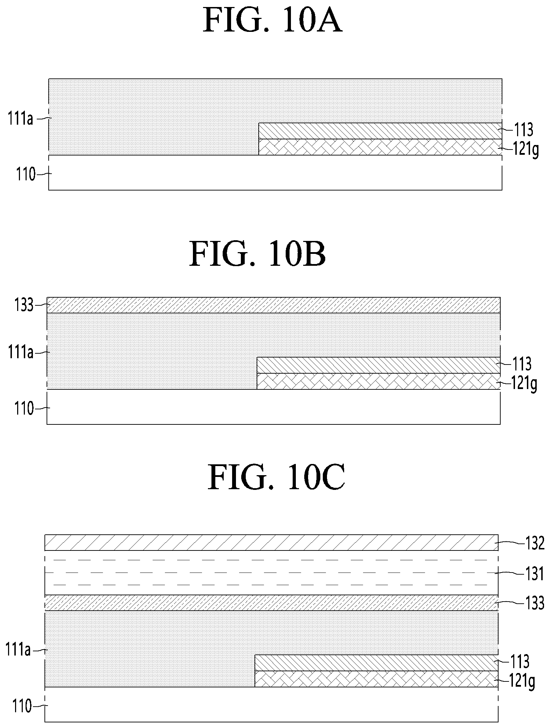

Meanwhile, the asymmetric open-connection structure 105 according to the embodiment may be formed through a two-mask process (FIGS. 9A to 9P) or a one-mask process (FIGS. 10A to 10H).

### [Two-mask process]

FIGS. 9A to 9P illustrate a two-mask process for forming an asymmetric open-connection structure according to the embodiment. The drawing illustrates a process of forming an open structure 105B in the first bank 111-1 adjacent to the green subpixel SPg, but the same process may be applied to a process of forming an open structure in the second bank 111-2.

As illustrated in FIG. 9A, after the substrate 110 is cleaned, an anode electrode 121g may be formed on the substrate 110.

Specifically, by sequentially depositing ITO, Ag alloy, and ITO on the substrate 110, an anode electrode 121g composed of ITO/Ag alloy/ITO may be formed on the substrate 110.

As illustrated in FIG. 9B, after the substrate 110 is cleaned, a blocking layer 113 such as molybdenum (Mo) may be formed on the anode electrode 121g. Instead of molybdenum (Mo), a silicon-based inorganic material may be used.

As illustrated in FIG. 9C, after the substrate 110 is cleaned, a photosensitive pattern 204 may be formed on the blocking layer 113.

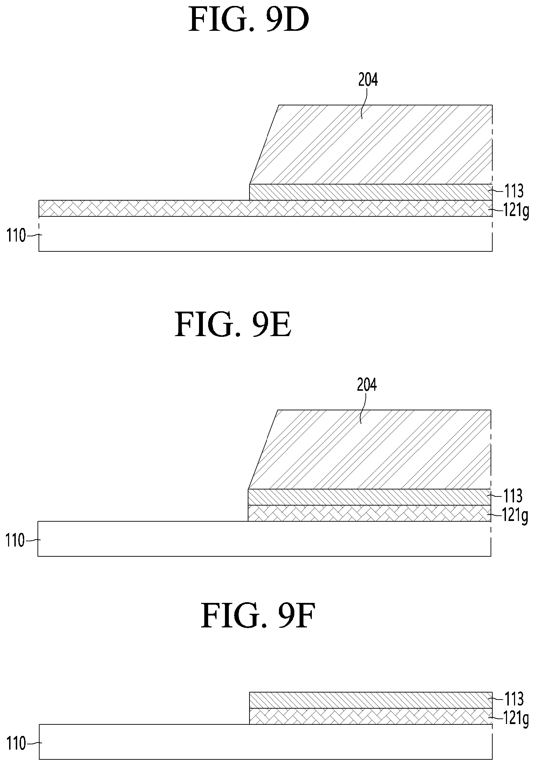

As illustrated in FIG. 9D, the blocking layer 113 may be wet-etched using the photosensitive pattern 204.

As illustrated in FIG. 9E, the ITO/Ag alloy/ITO of the anode electrode 121g may be etched in batches using the photosensitive pattern 204. The side portion of the blocking layer 113 and the side portion of the anode electrode 121g may be positioned on the same vertical line or diagonal line, but are not limited thereto.

As illustrated in FIG. 9F, the photosensitive pattern 204 may be removed.

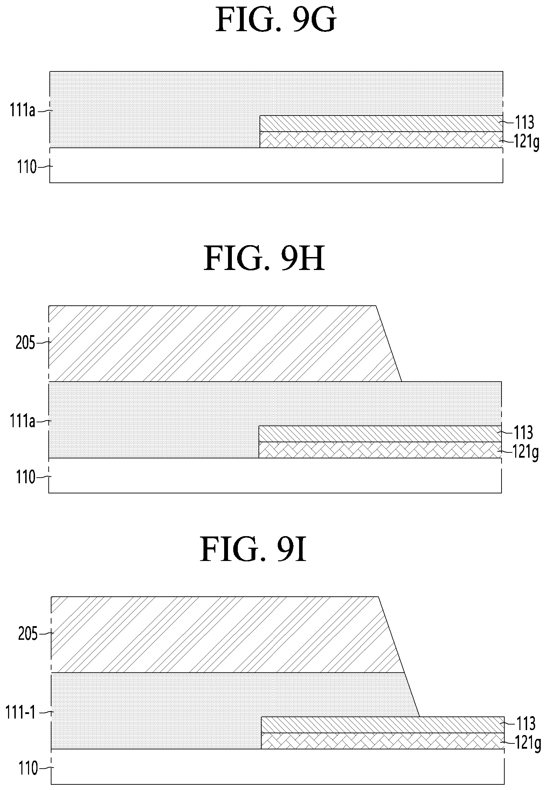

As illustrated in FIG. 9G, after the substrate 110 is cleaned, an inorganic film 111a, such as silicon nitride (SiNx), may be deposited on the substrate 110.

As illustrated in FIG. 9H, after the substrate 110 is cleaned, a photosensitive pattern 205 may be formed on the inorganic film 111a.

As illustrated in FIG. 9I, after the substrate 110 is cleaned, the inorganic film 111a may be dry etched using the photosensitive pattern 205, thereby forming a first bank 111-1. The first bank 111-1 may be formed on the substrate 110 between the red subpixel SPr and the green subpixel SPg.

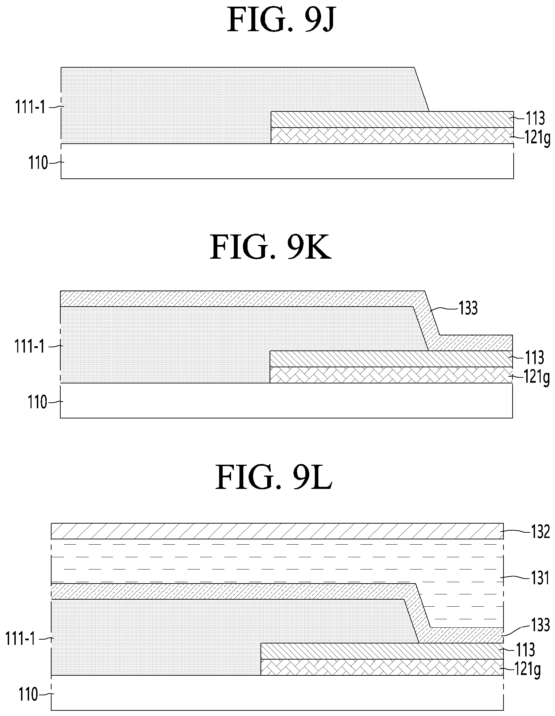

As illustrated in FIG. 9J, the photosensitive pattern 205 may be removed.

As illustrated in FIG. 9K, after the substrate 110 is cleaned, titanium (Ti) may be deposited on the substrate 110 to form a third layer 133.

As illustrated in FIG. 9L, a first layer 131 and a second layer 132 may be formed by sequentially depositing aluminum (Al) and titanium (Ti) on a third layer 133.

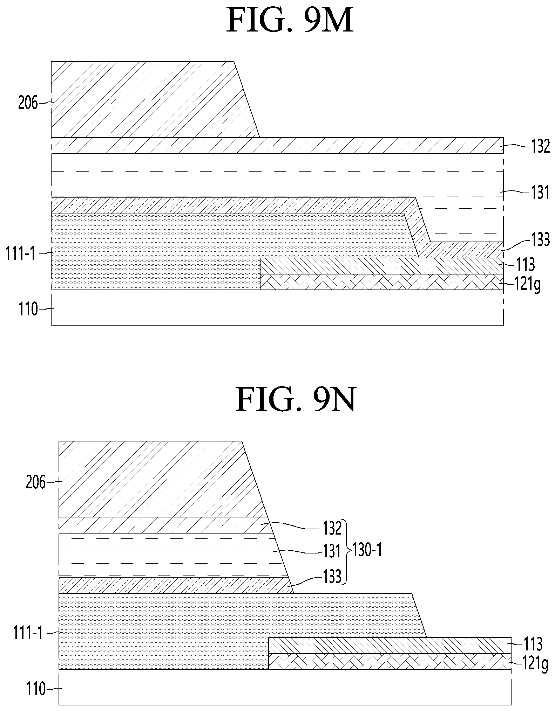

As illustrated in FIG. 9M, after the substrate 110 is cleaned, a photosensitive pattern 206 may be formed on the second layer 132.

As illustrated in FIG. 9N, after the substrate 110 is cleaned, the second layer 132, the first layer 131, and the third layer 133 may be sequentially dry-etched using the photosensitive pattern 206 to form the first protrusion part 130-1.

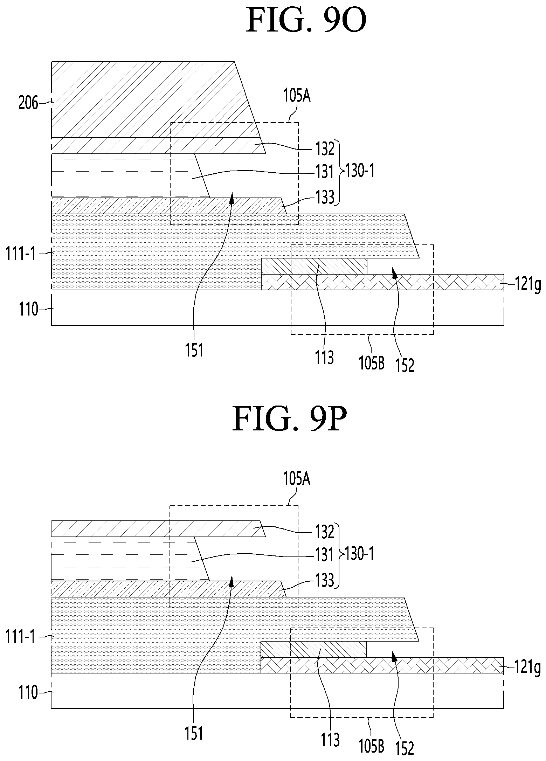

As illustrated **in** FIG. 9O, after the substrate 110 is cleaned, the first layer 131 and the blocking layer 113 may be wet-etched using the photosensitive pattern 206 to form the connecting structure 105A and the open structure 105B simultaneously. An asymmetric open-connection structure 105 may be configured by the connection structure 105A and the open structure 105B.

Accordingly, the connection structure 105A may be formed with an undercut structure in which the side portion of the first layer 131 is inwardly recessed from the side portion of the second layer 132 or the side portion of the third layer 133. In addition, the open structure 105B may be formed with an undercut structure in which the side portion of the blocking layer 113 is inwardly recessed from the side portion of the first bank 111-1.

As illustrated in FIG. 9P, the photosensitive pattern 206 may be removed. Thereafter, whether a driving circuit provided in each subpixel of the substrate 110, for example, at least one or more transistor, is defective may be inspected.

### [One-mask process]

FIGS. 10A to 10H illustrate a one-mask process for forming an asymmetric open-connection structure according to an embodiment. The drawings illustrate a process for forming an open structure 105B in a first bank 111-1 adjacent to a green subpixel SPg, but the same process may be applied to a process for forming an open structure in a second bank 111-2.

Since the process for forming an anode electrode 121g and a blocking layer 113 in a green subpixel SPg is the same as FIGS. 9A to 9F, a detailed description thereof will be omitted.

As illustrated in FIG. 10A, after the substrate 110 is cleaned, an inorganic film 111a, such as silicon nitride (SiNx), may be deposited on the substrate 110.

As illustrated in FIG. 10B, after the substrate 110 is cleaned, titanium (Ti) may be deposited on the substrate 110, thereby forming a third layer 133.

As illustrated in FIG. 10C, aluminum (Al) and titanium (Ti) may be sequentially deposited on the third layer 133, thereby forming a first layer 131 and a second layer 132.

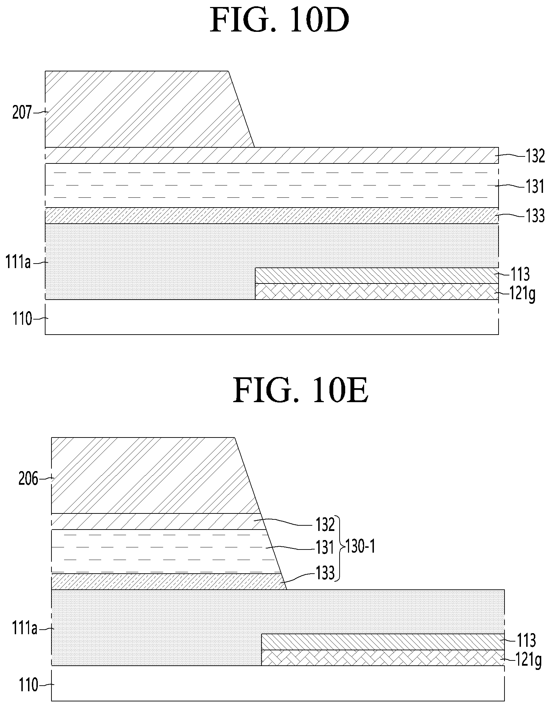

As illustrated in FIG. 10D, after the substrate 110 is cleaned, a photosensitive pattern 207 may be formed on the second layer 132.

As illustrated in FIG. 10E, after the substrate 110 is cleaned, the second layer 132, the first layer 131, and the third layer 133 may be sequentially dry-etched using the photosensitive pattern 207 to form a first protrusion part 130-1.

For example, the second layer 132 may be etched through dry etching using CF₄/O₂ gas. For example, the first layer 131 may be etched through dry etching using Cl and/or HCl gas. For example, the third layer 133 may be etched through dry etching using CF₄/O₂ gas.

A side portion of the second layer 132, a side portion of the first layer 131, and a side portion of the third layer 133 may be positioned on the same vertical line or diagonal line.

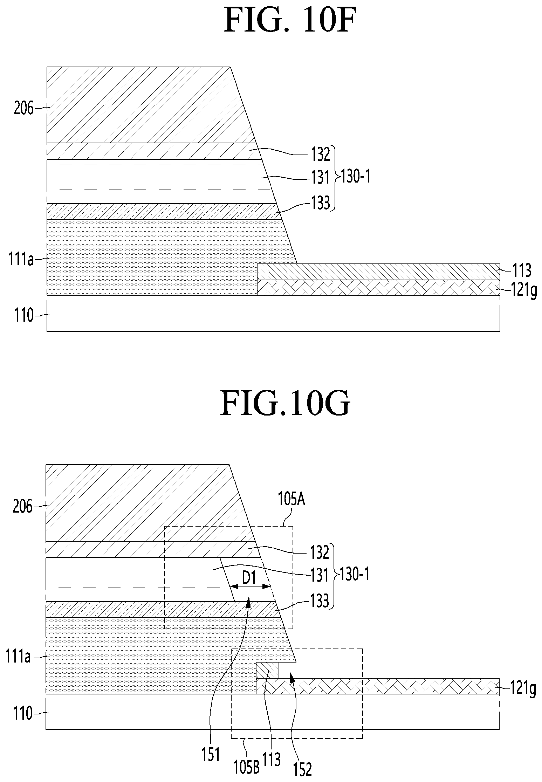

As illustrated in FIG. 10F, after the substrate 110 is cleaned, the inorganic film 111a may be dry-etched using the photosensitive pattern 207 to form a first bank 111-1. Accordingly, the first protrusion part 130-1 and the first bank 111-1 may be formed using the same photosensitive pattern 207.

For example, the inorganic film 111a may be etched through dry etching using CF₄ and He gases.

As illustrated in FIG. 10G, after the substrate 110 is cleaned, the first layer 131 and the blocking layer 113 may be wet-etched using the photosensitive pattern 207 to simultaneously form the connection structure 105A and the open structure 105B, each having an undercut structure. An asymmetric open-connection structure 105 may be configured by the connection structure 105A and the open structure 105B.

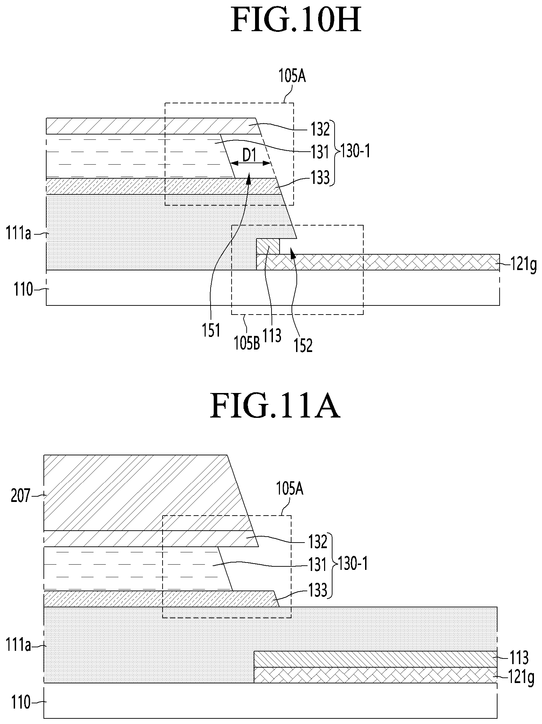

As illustrated in FIG. 10H, the photosensitive pattern 207 may be removed. Thereafter, the driving circuit provided in each of the subpixels SPr, SPg, and SPb of the substrate 110, for example, at least one or more transistor, may be inspected for defects.

Meanwhile, as illustrated in FIGS. 11A to 11C, other modifications of the above-described one-mask process (FIGS. 10A to 10H) are also possible.

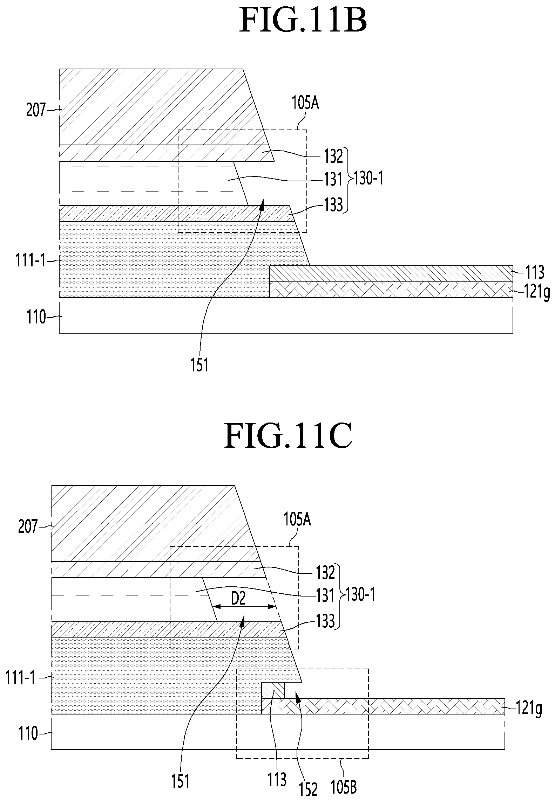

FIGS. 11A to 11C illustrate another modification process of the process of FIGS. 10E to 10G. The process illustrated in FIG. 11A may correspond to the process illustrated in FIG. 10E, the process illustrated in FIG. 11B may correspond to the process illustrated in FIG. 10F, and the process illustrated in FIG. 11C may correspond to the process illustrated in FIG. 10G.

As illustrated in FIG. 11A, the second layer 132 may be etched using the photosensitive pattern 207 through dry etching using CF₄/O₂ gas.

Unlike FIG. 10E, the first layer 131 may be etched through wet etching. Aluminum (Al), which forms the first layer 131, may be rapidly etched by wet etching. Accordingly, a connection structure 105A having an undercut structure that is recessed inwardly from the side portion of the second layer 132 may be formed.

For example, the third layer 133 may be etched through dry etching using CF₄/O₂ gas.

Similar to FIG. 10F, as illustrated in FIG. 11B, the inorganic film 111a may be etched using the photosensitive pattern 207 through dry etching using CF₄ and He gas, thereby forming the first bank 111-1.

As illustrated in FIG. 11C, the blocking layer 113 may be wet etched using the photosensitive pattern 207, thereby forming the open structure 105B.

When the blocking layer 113 is wet etched, the first layer 131 may also be etched. Accordingly, the opening depth D2 of the connection structure 105A illustrated in FIG. 11C may be greater than the opening depth D1 of the connection structure 105A illustrated in FIG. 10G. Therefore, when the connection structure 105A having a large opening depth D2 is required, it may be preferable that the processes illustrated in FIGS. 11A to 11C be performed.

Meanwhile, in an organic light-emitting display device having a side-by-side structure manufactured using a photolithography process, a red subpixel SPr, a green subpixel SPg, and a blue subpixel SPb may be sequentially formed. For example, after a red organic light-emitting layer 122r, an encapsulation layer 135, etc. are deposited on a substrate 110, the red organic light-emitting layer 122r, an encapsulation layer 135 may be etched to form only a red subpixel SPr. In such an etching process, the photosensitive film or the encapsulation layer 135 may not be removed from the undercut structure of the connection structure 105A of the first protrusion part 130-1, i.e., the U-cave, so that a residual film may be generated.

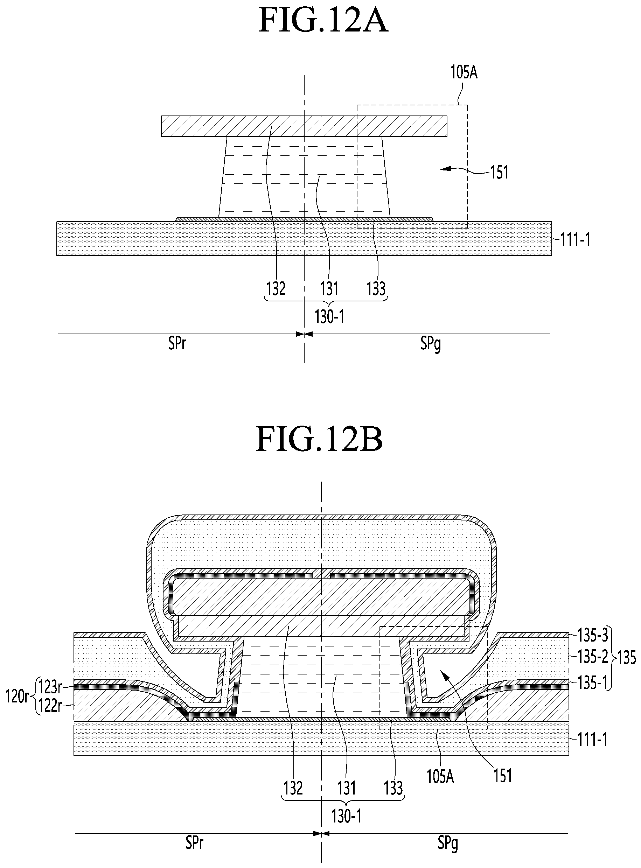

Referring to FIGS. 12A to 12D, the generation of a residual film will be described.

FIGS. 12A to 12D illustrate the appearance of a residual film generated in a process of forming a red subpixel. The first protrusion part 130-1 is illustrated in the drawing, but the same may be applied to the second protrusion part 130-2.

As illustrated in FIG. 12A, a first protrusion part 130-1 having a connection structure 105A may be formed on a first bank 111-1. A substrate 110 may be provided under the first bank 111-1.

As illustrated in FIG. 12B, a red organic light-emitting element 120r and an encapsulation layer 135 may be formed on the substrate 110. A cathode electrode 123r of the red organic light-emitting element 120r may be electrically connected to a first layer 131 and a third layer 133 of the first protrusion part 130-1. The first layer 131 and the third layer 133 may be used as auxiliary electrodes.

The encapsulation layer 135 may comprise a first-first insulating layer 135-1, a first-second insulating layer 135-2, and a first-third insulating layer 135-3. For example, the first-first insulating layer 135-1 may comprise an inorganic material such as silicon oxide (SiOx), the first-second insulating layer 135-2 may comprise an inorganic material such as silicon nitride (SiNx), and the first-third insulating layer 135-3 may comprise an inorganic material such as silicon oxide (SiOx), but is not limited thereto.

The encapsulation layer 135 may be formed in an undercut structure of the connection structure 105A, i.e., a U-cave portion.

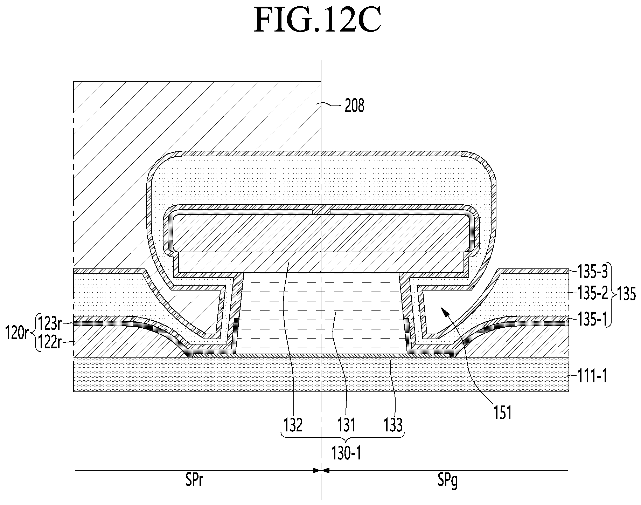

As illustrated in FIG. 12C, a photosensitive pattern 208 may be formed on the substrate 110. The photosensitive pattern 208 may be formed on one side region of each of the red subpixel SPr and the first protrusion part 130-1.

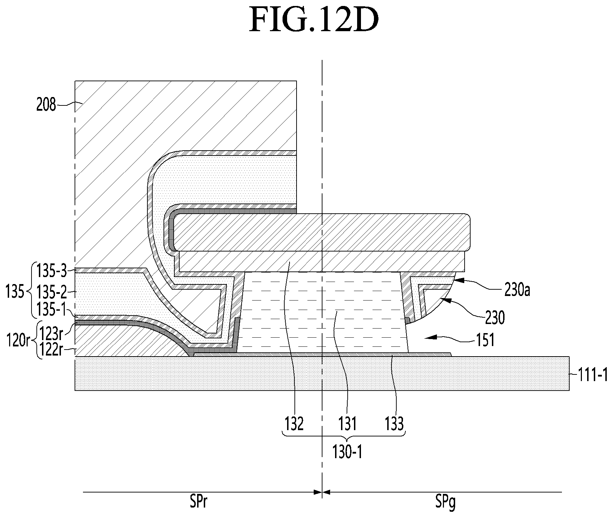

As illustrated **in** FIG. 12D, the encapsulation layer 135, a cathode electrode 123r of the red organic light-emitting element 120r, and a red organic light-emitting layer 122r may be dry-etched using the photosensitive pattern 208, so that the encapsulation layer 135, the cathode electrode 123r, and the red organic light-emitting layer 122r can be formed only on one side region of the red subpixel SPr and the first protrusion part 130-1.

However, the encapsulation layer 135 or the photosensitive pattern 208 may remain as residual films 230 and 230a in the undercut structure of the first protrusion part 130-1 adjacent to the green subpixel SPg. These residual films 230 and 230a may remain between the side portion of the first layer 131 and the lower side of the second layer 132 of the first protrusion part 130-1.

The photosensitive pattern 208 may comprise a transparent resin material having high purity, low water vapor transmission rate (WVTR), etc. Even if a removal process of the photosensitive pattern 208 is performed, a part of the photosensitive pattern 208 may remain without being removed inside the undercut structure, thereby forming the residual films as the resin layer 136.

Since these residual films 230 and 230a may be foreign substances that help form new moisture penetration passages, causing poor image quality such as dark spots, they must be removed.

In particular, the residual films 230 and 230a become penetration passages for developers, etchants, and strippers in the wet process. In addition, in the dry process, they become penetration passages for moisture after the product is completed, which may be fatal to the product's lifespan by causing dark spots in long-term reliability. Since the subpixels formed last, such as the blue subpixel SPb, undergo two patternings to form the red subpixel SPr and the green subpixel SPg, the dark spots caused by the residual films 230 and 230a may increase even more, further increasing the defect rate.

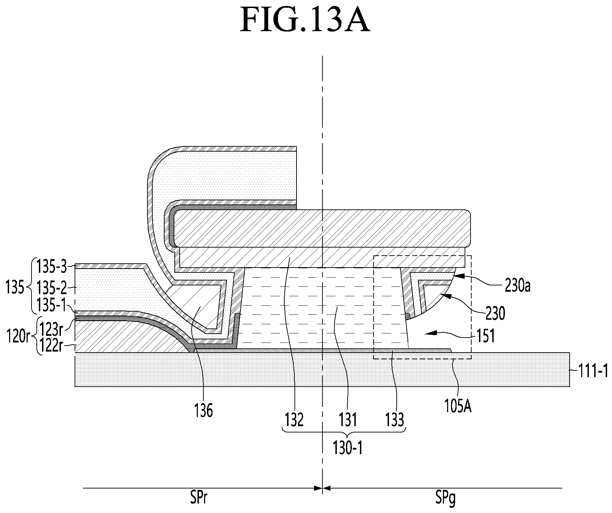

FIG. 13A illustrates a residual film generated in the process of forming a red subpixel.

As illustrated in FIG. 13A, when the connection structure 105A is formed on a first side portion of the first protrusion part 130-1 adjacent to the green subpixel SPg before forming the green subpixel SPg, residual films 230 and 230a may be formed on the undercut structure of the connection structure 105A.

As illustrated in FIG. 13A, the encapsulation layer 135 and the red organic light-emitting element 120r formed on the substrate 110 may be dry etched, so that the encapsulation layer 135 and the cathode electrode 123r and the red organic light-emitting layer 122r of the red organic light-emitting element 120r may be formed on one side region of the red subpixel SPr and the first protrusion part 130-1.

Thereafter, an ashing process may be performed, so that the photosensitive pattern (208 in FIG. 12D) can be stripped and can remain in the undercut structure on both side portions of the first protrusion part 130-1. The ashing process may be performed as an anisotropic process.

Moisture penetration may be blocked by the photosensitive pattern 208 remaining in the undercut structure on both side portions of the first protrusion part 130-1.

The encapsulation layer 135 and the photosensitive pattern 208 may remain in the undercut structure of the first protrusion part 130-1. The encapsulation layer 135 and the photosensitive pattern 208 remaining in the undercut structure of the first protrusion part 130-1 adjacent to the red subpixel SPr may play a role in preventing moisture penetration. However, the encapsulation layer 135 and the photosensitive pattern 208 remaining in the undercut structure of the first protrusion part 130-1 adjacent to the green subpixel SPg or the undercut structure of the second protrusion part 130-2 adjacent to the blue subpixel SPb may cause a dark spot in the green subpixel SPg or the blue subpixel SPb.

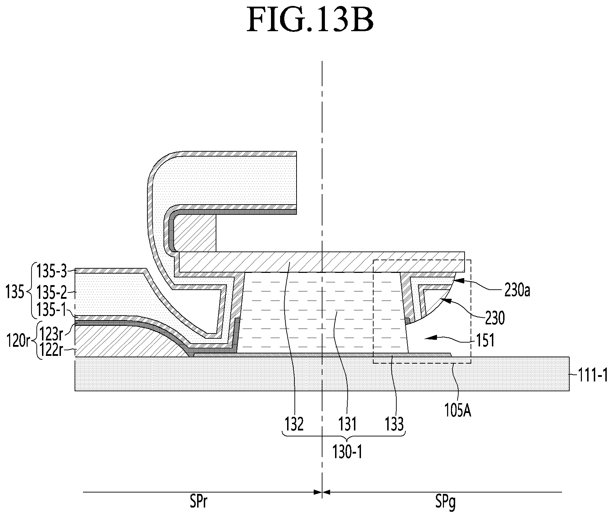

FIG. 13B illustrates an example in which no residual film is generated.

As illustrated in FIG. 13B, the photosensitive pattern (208 of FIG. 13A) may be removed through wet etching, so that the photosensitive pattern 208 does not remain as a residual film 230 **in** the undercut structure of the first protrusion part 130-1 adjacent to the green subpixel SPg.

Nevertheless, the encapsulation layer 135 may still remain as a residual film 230a in the undercut structure of the first protrusion part 130-1 adjacent to the green subpixel SPg. In addition, the red organic light-emitting layer 122r on the first protrusion part 130-1 may be etched in the strip process, which may become a potential cause of poor image quality due to another foreign substance or a new passage for moisture penetration in a subsequent process.

To solve this problem, a just in time (JIT) process technology may be used in the embodiment. The JIT process technology may be a process technology capable of immediately forming the connection structure 105A or the open structure 105B when formation of the connection structure 105A or the open structure 105B is required. That is, by forming the connection structure 105A or the open structure 105B immediately when required without forming it in advance, defects such as the aforementioned dark spots can be prevented. Here, the connection structure 105A or the open structure 105B may have an undercut structure or a U-cave. The JIT process technology of the embodiment may be applied to a series of overall processes for forming the connection structure 105A and/or the open structure 105B immediately when necessary, and for forming the corresponding subpixel after the connection structure 105A and/or the open structure 105B is formed.

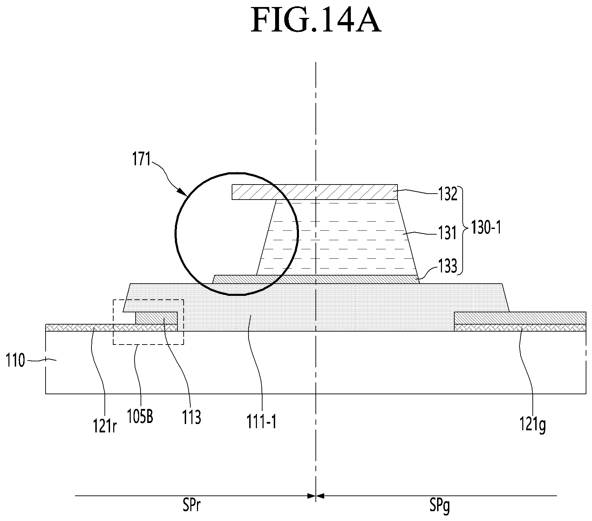

FIGS. 14A to 14D illustrate a process for forming a red subpixel so that a residual film does not occur on the second side portion of the first protrusion part adjacent to the green subpixel. The drawing illustrates a process for forming a red subpixel SPr, but the same may be applied to a process for forming a green subpixel SPg or a blue subpixel SPb. In addition, the drawing illustrates that the connection structure 105A and the open structure 105B are formed using the JIT process technology, but the open structure 105B may be omitted.

As illustrated in FIG. 14A, anode electrodes 121r and 121g may be formed on the red subpixel SPr and the green subpixel SPg of the substrate 110, respectively.

A first bank 111-1 and a first protrusion part 130-1 may be formed on the substrate 110 between the red subpixel SPr and the green subpixel SPg. An open structure 105B may be formed on an edge region of a lower side of the first bank 111-1.

A first connection structure 171 may be formed on a first side portion of the first protrusion part 130-1, that is, a side portion adjacent to the red subpixel SPr, but a second connection structure may not be formed on a second side portion of the first protrusion part 130-1, that is, a side portion adjacent to the green subpixel SPg. This is to prevent a residual film from being generated by the second connection structure when an encapsulation layer 135 or a photosensitive pattern is removed later. The second connection structure on the second side portion of the first protrusion part 130-1 may be formed later when the green subpixel SPg is formed.

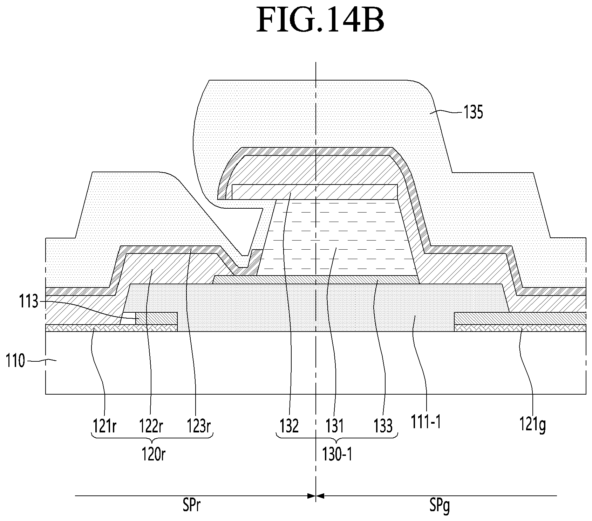

As illustrated in FIG. 14B, a red organic light-emitting layer 122r, a cathode electrode 123r, an encapsulation layer 135, etc. may be formed on the substrate 110.

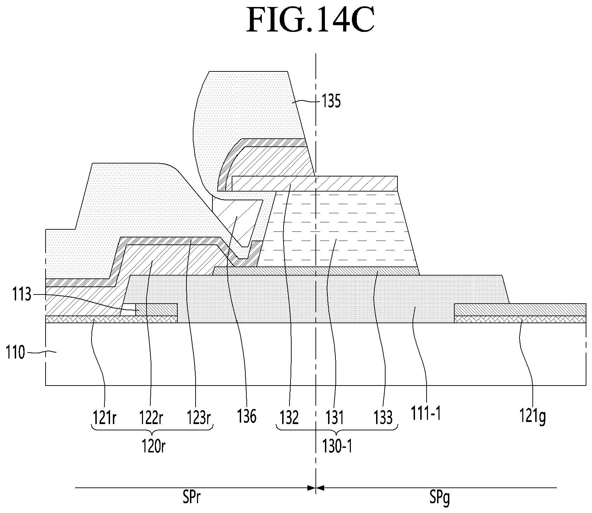

As illustrated in FIG. 14C, a photosensitive film may be formed and patterned on the substrate 110, so that a photosensitive pattern can be formed on the red subpixel SPr and one side region of the first protrusion part 130-1.

The green subpixel SPg and the encapsulation layer 135, the cathode electrode 123r, and the red organic light-emitting layer 122r on the other side region of the first protrusion part 130-1 may be removed through an etching process using a photosensitive pattern. Thereafter, the photosensitive pattern may be removed. Accordingly, a red organic light-emitting element 120r may be formed in the red subpixel SPr.

As illustrated in FIG. 14C, the second connection structure 172 is still not formed on the second side portion of the first protrusion part 130-1. In addition, the second side portion of the first protrusion part 130-1 may have a flat or straight surface. Therefore, as illustrated in FIG. 14B, when the red subpixel SPg is formed, the encapsulation layer 135 or the photosensitive film formed on the second side portion of the first protrusion part 130-1 may be removed without being formed as the residual films.

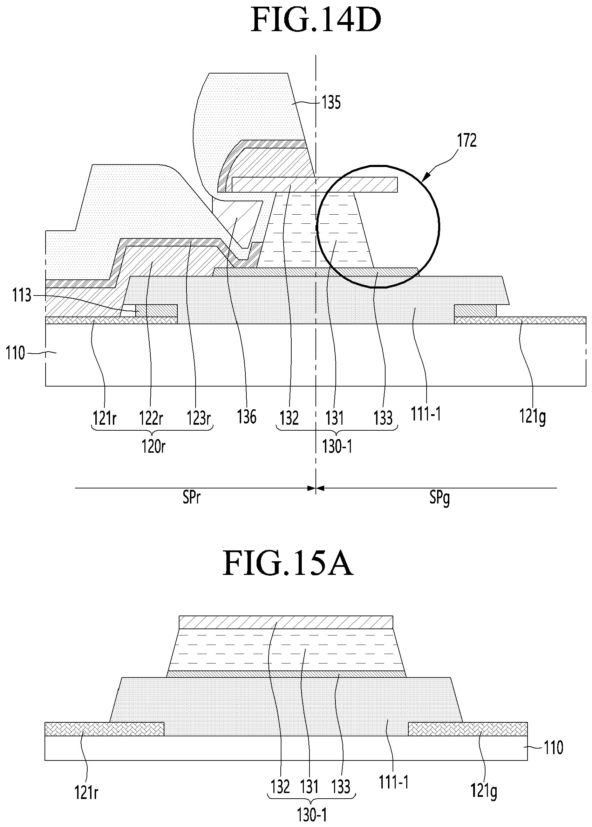

As illustrated in FIG. 14D, after the red subpixel SPr is formed, the green subpixel SPg may be formed. In order to form the green subpixel SPg, the second connection structure 172 formed on the second side portion of the first protrusion part 130-1 is required. Therefore, when the formation of the green subpixel SPg is required, the second connection structure 172 and the open structure may be formed on the second side portion of the first protrusion part 130-1 immediately using the JIT process technology.

Thereafter, the green organic light-emitting layer 122g, the cathode electrode 123g, the encapsulation layer 135, etc. may be formed on the substrate 110, and then the encapsulation layer 135, the cathode electrode 123g, and the green organic light-emitting layer 122g on the remaining region except for the green subpixel SPg and the other side region of the first protrusion part 130-1 may be removed using a photosensitive pattern. The photosensitive pattern may be removed. Accordingly, a green organic light-emitting element 120g may be formed in the green subpixel SPg.

In summary, the JIT process technology may be a process technology that forms the connection structure 105A and/or the open structure 105B of the embodiment at a 'necessary location' at a 'necessary time.'

As illustrated in FIG. 5D, when the connection structures 105A are formed in advance on both side portions of the first protrusion part 130-1 and both side portions of the second protrusion part 130-2, as illustrated in FIGS. 5F to 5G, residual films (230, 230a in FIG. 12D) may be generated on the connection structure 105A, etc. on both side portions of the first protrusion part 130-1 during the process of forming the blue organic light-emitting element 120b in the blue subpixel SPb. In addition, as illustrated in FIGS. 5I and 5J, during the process of forming the green organic light-emitting element 120g in the green subpixel SPg, residual films 230 and 230a may be generated on the connection structure 105A on one side of the first protrusion part 130-1. Due to the occurrence of dark spots caused by these residual films 230 and 230a, the yield may be reduced, and additional dark spots may be generated during the product usage period, which may lower the reliability of the product.

Although FIGS. 5A to 5O illustrate that the blue organic light-emitting element 120b, the green organic light-emitting element 120g, and the red organic light-emitting element 120r are formed in that order, the order may be changed.

However, according to an embodiment, at the time when the corresponding subpixel SPr, SPg, and SPb is formed, the connection structure 105A may be formed on the side portion of the protrusion parts 130-1 and 130-2 adjacent to the corresponding subpixel SPr, SPg, and SPb using the JIT process technology. In this instance, since the connection structure 105A is not formed on the side portion of the corresponding protrusion part when another subpixel is formed, residual films may not be generated on the side portion of the corresponding protrusion part. Accordingly, the occurrence of dark spots due to the residual films 230 and 230a can be prevented in advance, so that the yield can be improved and the product reliability can be enhanced.

Specifically, at the time when the formation of the red subpixel SPr is required, a first connection structure 171 may be formed on the first side portion of the first protrusion part 130-1 using the JIT process technology, and then the red subpixel SPr may be formed.

After the first connection structure 171 is formed and the red organic light-emitting element 120r is formed on the red subpixel SPr, it may now be time to form the green subpixel SPg. At this time, a second connection structure 172 may be formed on the second side portion of the first protrusion part 130-1 using the JIT process technology, and then the green subpixel SPg may be formed.

After the second connection structure 172 is formed and the green organic light-emitting element 120g is formed on the green subpixel SPg, it may now be time for the blue subpixel SPb to be formed. At this time, a third connection structure 173 may be formed on the second side portion of the second protrusion part 130-2, i.e., the side portion adjacent to the blue subpixel SPb, using the JIT process technology. After the third connection structure 173 is formed, the blue organic light-emitting element 120b may be formed on the blue subpixel SPb.

Referring to FIGS. 15A to 15K, FIGS. 16A to 16J, and FIGS. 17A to 17K, the entire process of forming a red subpixel SPr, a green subpixel SPg, and a blue subpixel SPb using a first **JIT** process technology is described. Although the open structure 105B is not illustrated in FIGS. 15A to 15K, FIGS. 16A to 16J, and FIGS. 17A to 17K, the open structure 105B may also be formed when the connection structure 105A is formed using the first **JIT** process technology.

**In** the following description, shapes, structures, functions, processes, etc. that overlap with those described above are omitted.

FIGS. 15A to 15K illustrate a detailed process of forming a red subpixel using the first JIT process technology.

As illustrated in FIG. 15A, anode electrodes 121r, 121g, and 121b may be formed on the red subpixel SPr, the green subpixel SPg, and the blue subpixel SPb of the substrate 110, respectively.

A first bank 111-1 and a first protrusion part 130-1 may be formed on the substrate 110 between the red subpixel SPr and the green subpixel SPg. A second bank 111-2 and a second protrusion part 130-2 may be formed on the substrate 110 between the green subpixel SPg and the blue subpixel SPb.

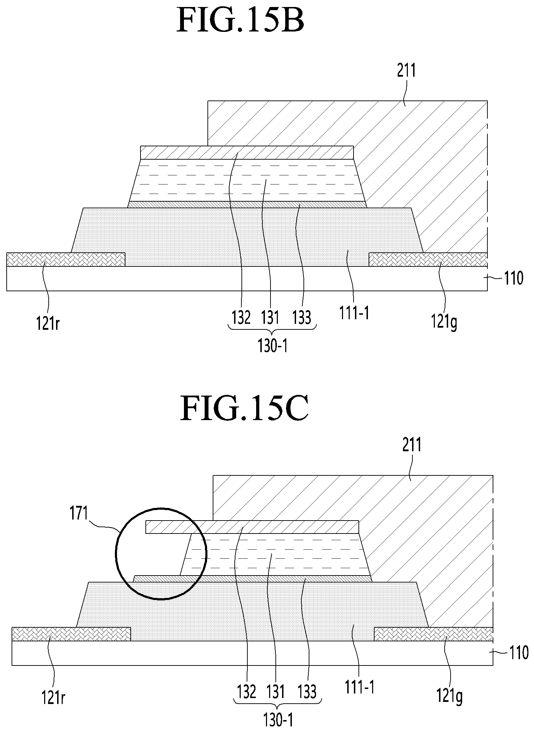

As illustrated **in** FIG. 15B, a photosensitive pattern 211 may be formed on the green subpixel SPg, the other side region of the first protrusion part 130-1, the blue subpixel SPb, and the second protrusion part 130-2.

As illustrated in FIG. 15C, the first protrusion part 130-1 may be etched using the photosensitive pattern 211, so that a first connection structure 171 can be formed on the first side portion of the first protrusion part 130-1, that is, the side portion adjacent to the red subpixel SPr. The first connection structure 171 may have an undercut structure in which the side portion of the first layer 131 is inwardly recessed from the side portion of the second layer 132 or the third layer 133.

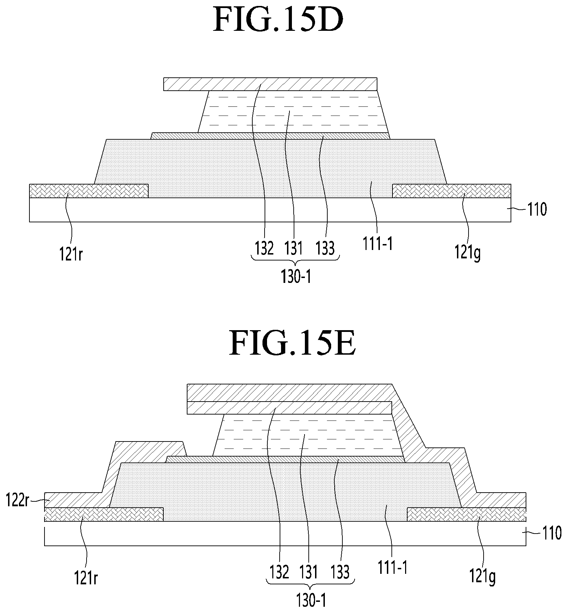

As illustrated **in** FIG. 15D, the photosensitive pattern 211 may be removed.

As illustrated in FIG. 15E, a red organic light-emitting layer 122r may be deposited on the substrate 110.

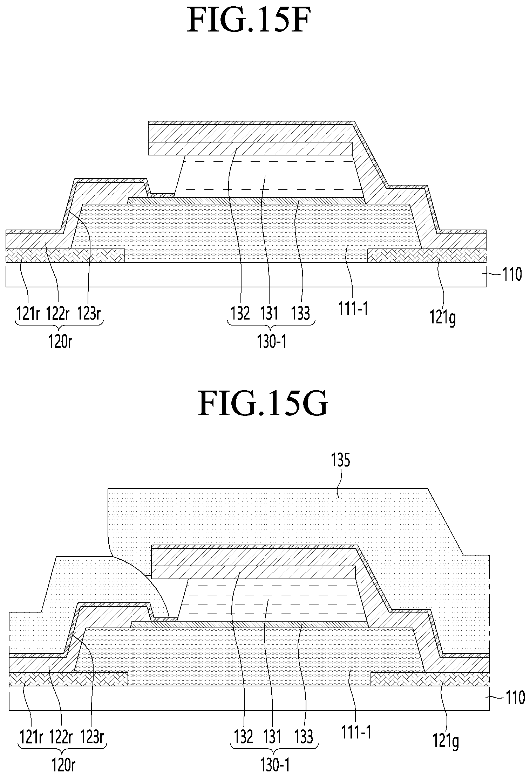

As illustrated in FIG. 15F, a cathode electrode 123r may be deposited on the red organic light-emitting layer 122r. The cathode electrode 123r may be electrically connected to an auxiliary electrode, for example, at least one of the first layer 131, the second layer 132, or the third layer 133, through the side portion of the first protrusion part 130-1.

As illustrated in FIG. 15G, an encapsulation layer 135 may be deposited on the cathode electrode 123r.

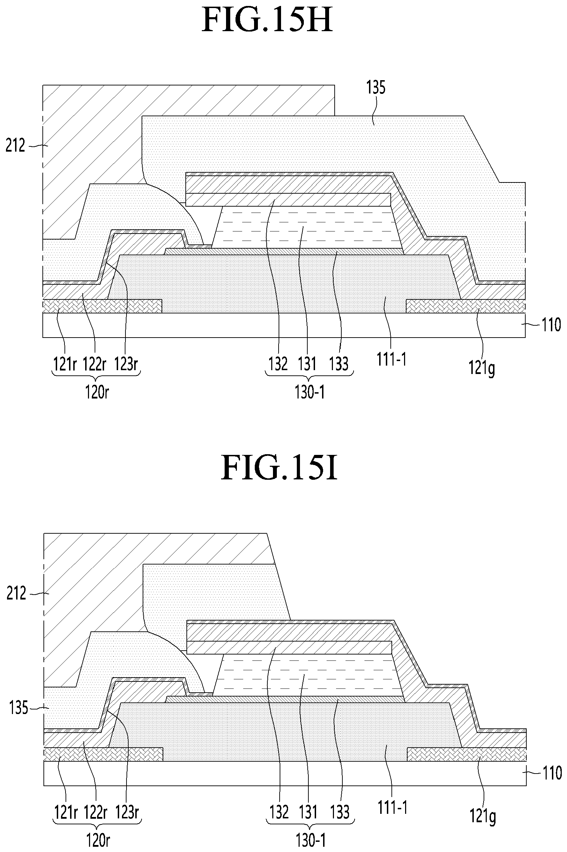

As illustrated in FIG. 15H, a photosensitive pattern 212 may be formed on the red subpixel SPr and one side region of the first protrusion part 130-1.

As illustrated in FIG. 15I, the encapsulation layer 135 may be dry etched using the photosensitive pattern 212, so that the green subpixel SPg, the other side region of the first protrusion part 130-1, the blue subpixel SPb, and the encapsulation layer 135 on the second protrusion part 130-2 may be removed.

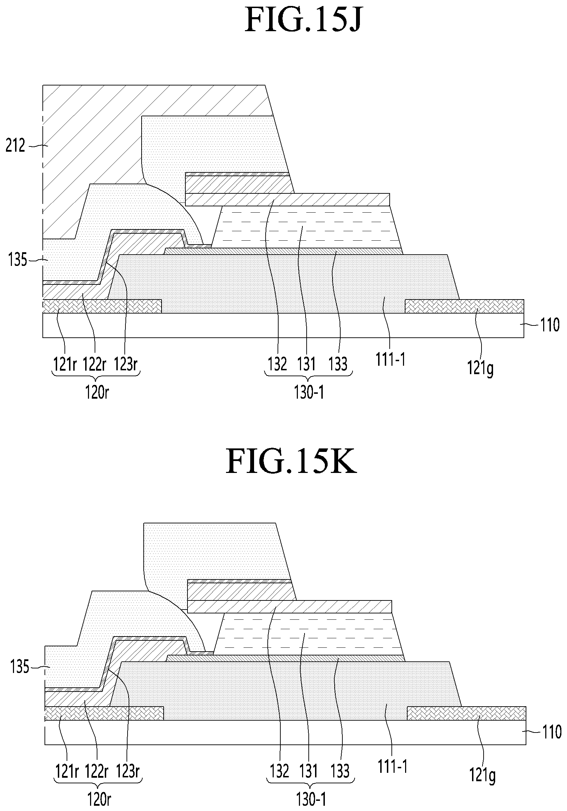

As illustrated in FIG. 15J, the cathode electrode 123r and the red organic light-emitting layer 122r may be dry etched using the photosensitive pattern 212, so that the green subpixel SPg, the other side region of the first protrusion part 130-1, the blue subpixel SPb, and the cathode electrode 123r and the red organic light-emitting layer 122r on the second protrusion part 130-2 may be removed.

As illustrated in FIG. 15K, the photosensitive pattern 212 may be removed. Accordingly, a red organic light-emitting element 120r and an encapsulation layer 135 may be formed on the red subpixel SPr.

Accordingly, while the red organic light-emitting element 120r is formed, the connection structure 105A may not be formed on the second side portion of the first protrusion part 130-1, that is, the side portion adjacent to the green subpixel SPg. The second side portion of the first protrusion part 130-1 may have a flat surface or a straight surface. Accordingly, the organic light-emitting layer, the cathode electrodes 123r, 123g, and 123b, and the encapsulation layer 135 formed on the second side portion of the first protrusion part 130-1 may be easily removed without remaining as residual films.

Thereafter, an inspection is performed on whether the red subpixel SPr is completed, and a defect in the red subpixel SPr may be detected.

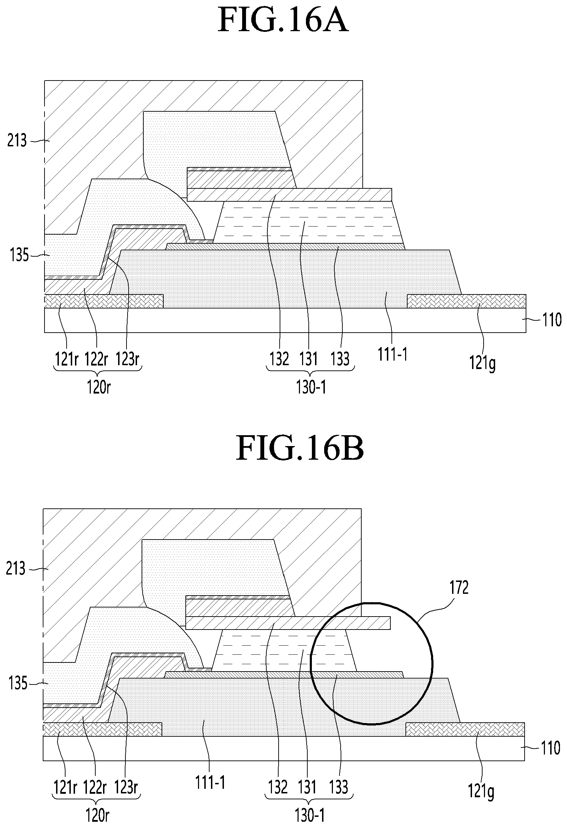

FIGS. 16A to 16J illustrate a detailed process for forming a green subpixel using the first JIT process technology.

As illustrated in FIG. 16A, a photosensitive pattern 213 may be formed on a red subpixel SPr, one side region of the first protrusion part 130-1, a blue subpixel SPb, and the other side region of the second protrusion part 130-2.

As illustrated in FIG. 16B, the first protrusion part 130-1 may be etched using the photosensitive pattern 213, so that a second connection structure 172 can be formed on a second side portion of the first protrusion part 130-1, that is, a side portion adjacent to the green subpixel SPg. The second connecting structure 172 may have an undercut structure in which the side portion of the first layer 131 is inwardly recessed from the side portion of the second layer 132 or the third layer 133.

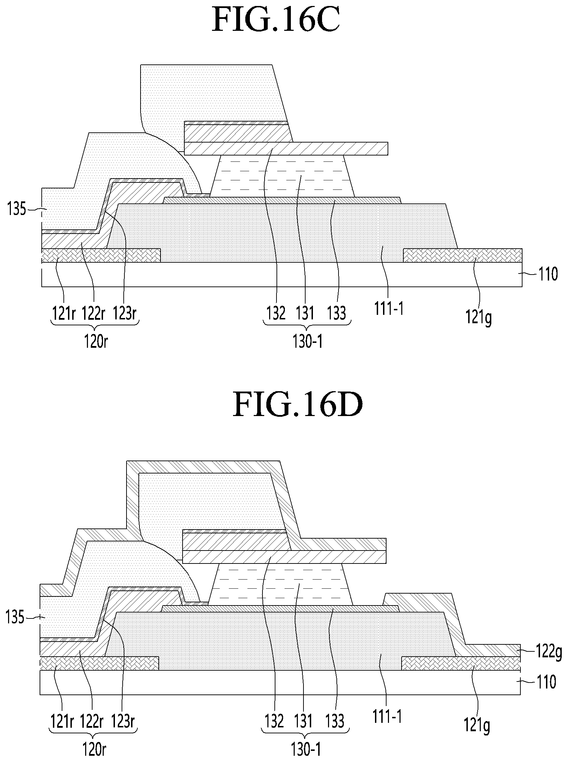

As illustrated in FIG. 16C, the photosensitive pattern 213 may be removed.

As illustrated in FIG. 16D, a green organic light-emitting layer 122g may be deposited on the substrate 110.

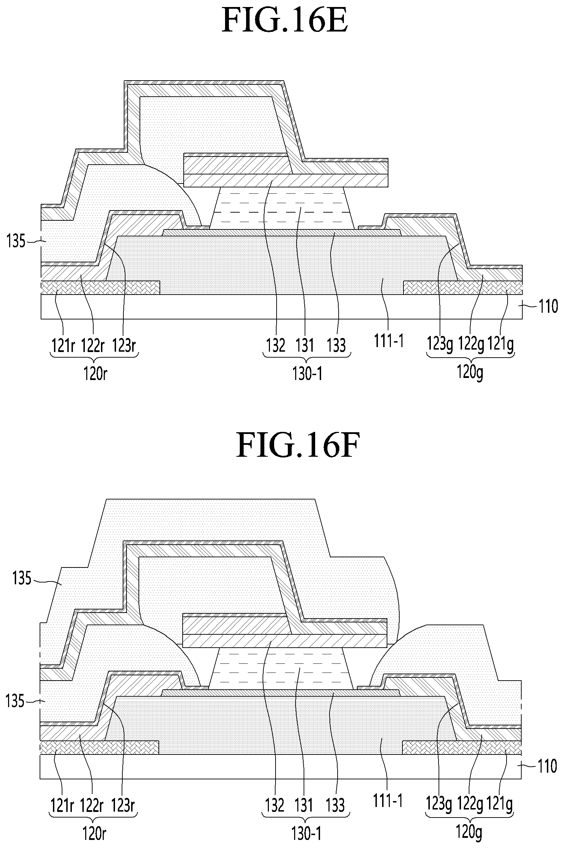

As illustrated in FIG. 16E, a cathode electrode 123g may be deposited on the green organic light-emitting layer 122g. The cathode electrode 123g may be electrically connected to an auxiliary electrode, for example, at least one of the first layer 131, the second layer 132, or the third layer 133, through the side portion of the first protrusion part 130-1.

As illustrated in FIG. 16F, an encapsulation layer 135 may be deposited on the cathode electrode 123g.

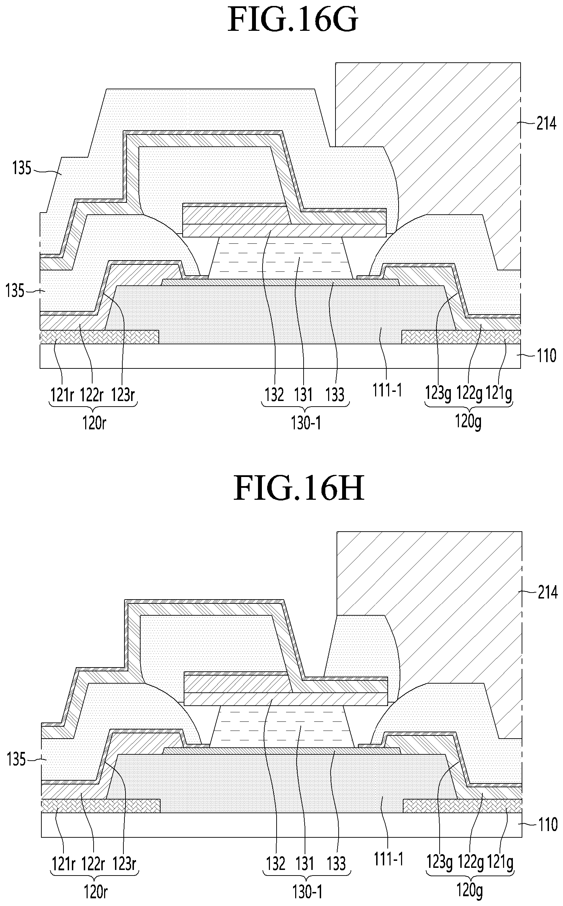

As illustrated in FIG. 16G, a photosensitive pattern 214 may be formed on the green subpixel SPg and the other side region of the first protrusion part 130-1.

As illustrated in FIG. 16H, the encapsulation layer 135 may be dry etched using the photosensitive pattern 214, so that the encapsulation layer 135 on the red subpixel SPr, the one side region of the first protrusion part 130-1, the blue subpixel SPb, and the second protrusion part 130-2 may be removed.

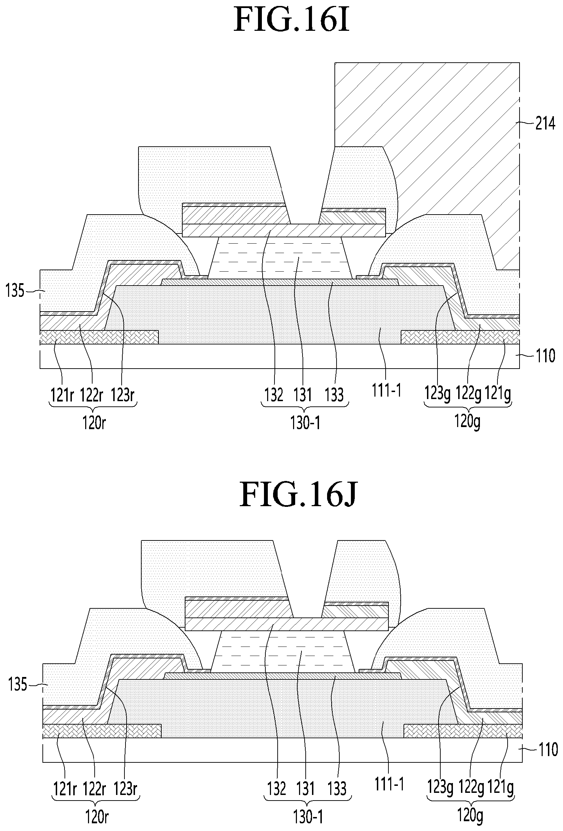

As illustrated in FIG. 16I, the cathode electrode 123g and the green organic light-emitting layer 122g may be dry-etched using the photosensitive pattern 214, so that the cathode electrode 123g and the green organic light-emitting layer 122g on the red subpixel SPr, one side region of the first protrusion part 130-1, the blue subpixel SPb, and the second protrusion part 130-2 may be removed.

As illustrated in FIG. 16J, the photosensitive pattern 214 may be removed. Accordingly, the green organic light-emitting element 120g and the encapsulation layer 135 may be formed on the green subpixel SPg.

Therefore, while the green organic light-emitting element 120g is formed, the connection structure 105A may not be formed on the second side portion of the second protrusion part 130-2, that is, the side portion adjacent to the blue subpixel SPb. The second side portion of the second protrusion part 130-2 may have a flat surface or a straight surface. Therefore, the organic light-emitting layer, the cathode electrode 123g, and the encapsulation layer 135 formed on the second side portion of the second protrusion part 130-2 may be easily removed without remaining as the residual films.

In the drawing, the area of the red organic light-emitting layer 122r on the upper side of the first protrusion part 130-1 is illustrated as being greater than the area of the green organic light-emitting layer 122g, but they may have the same area.

Thereafter, an inspection is performed on whether the green subpixel SPg is completed, and a defect in the green subpixel SPg may be detected.

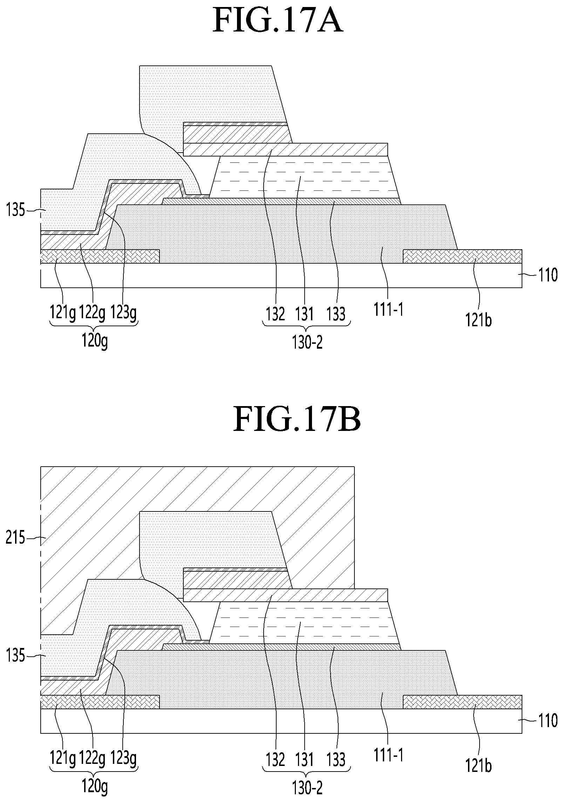

FIGS. 17A to 17K illustrate a detailed process for forming a blue subpixel using the first JIT process technology.

As illustrated in FIG. 17A, a substrate 110 on which a red subpixel SPr and a green subpixel SPg are formed may be prepared.

As illustrated in FIG. 17B, a photosensitive pattern 215 may be formed on one side region of the red subpixel SPr, the first protrusion part 130-1, the green subpixel SPg, and the second protrusion part 130-2.

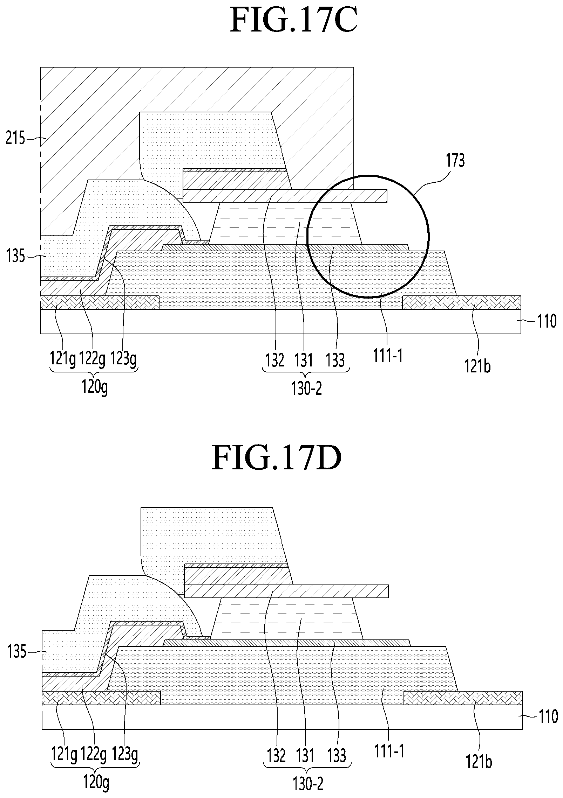

As illustrated in FIG. 17C, the second protrusion part 130-2 may be etched using the photosensitive pattern 215, so that a third connection structure 173 can be formed on the second side portion of the second protrusion part 130-2, that is, the side portion adjacent to the blue subpixel SPb. The third connecting structure 173 may have an undercut structure in which the side portion of the first layer 131 is inwardly recessed from the side portion of the second layer 132 or the third layer 133.

As illustrated in FIG. 17D, the photosensitive pattern 215 may be removed.

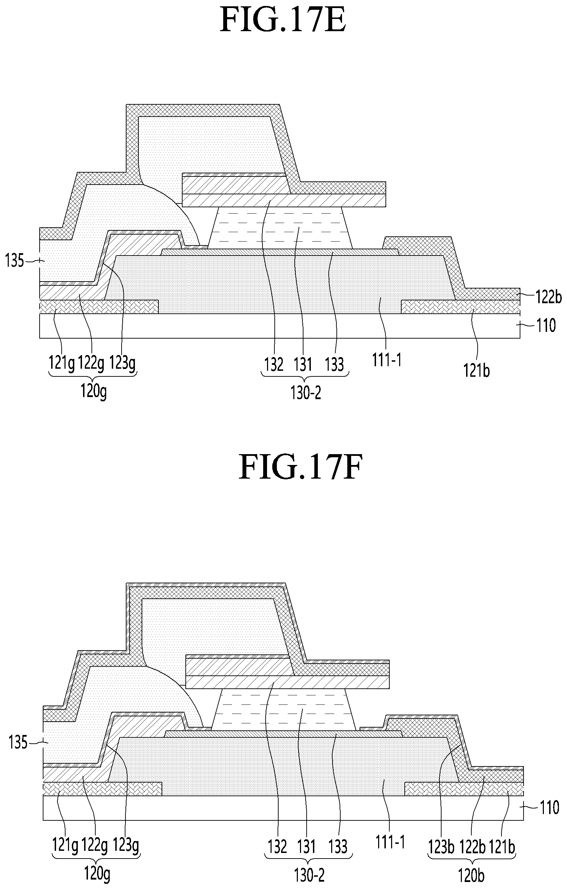

As illustrated in FIG. 17E, a blue organic light-emitting layer 122b may be deposited on the substrate 110.

As illustrated in FIG. 17F, a cathode electrode 123b may be deposited on the blue organic light-emitting layer 122b. The cathode electrode 123b may be electrically connected to an auxiliary electrode, for example, at least one of the first layer 131, the second layer 132, or the third layer 133, through the side portion of the second protrusion part 130-2.

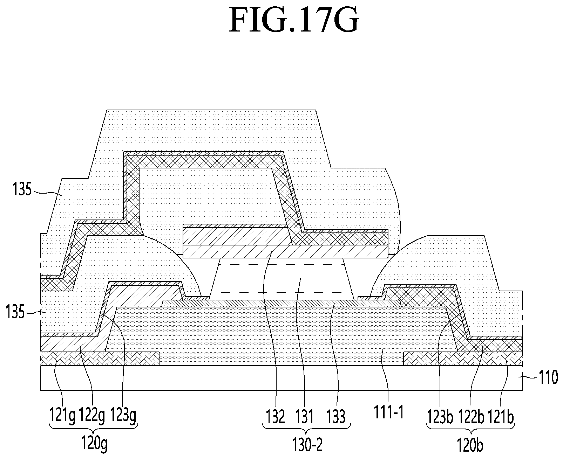

As illustrated in FIG. 17G, an encapsulation layer 135 may be deposited on the cathode electrode 123b.

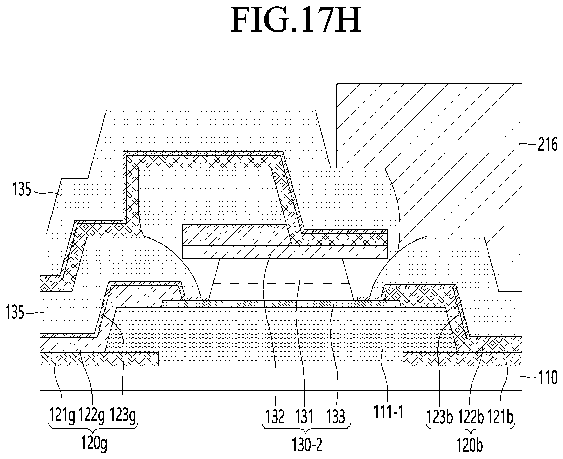

As illustrated in FIG. 17H, a photosensitive pattern 216 may be formed on the other side region of the blue subpixel SPb and the second protrusion part 130-2.

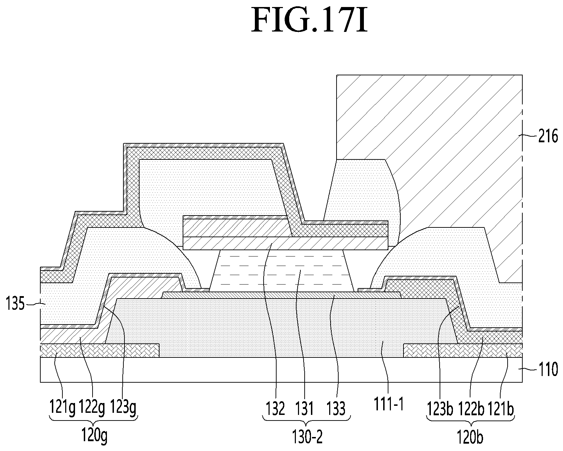

As illustrated in FIG. 17I, the encapsulation layer 135 may be dry etched using the photosensitive pattern 216, so that the encapsulation layer 135 on one side region of the red subpixel SPr, the first protrusion part 130-1, the green subpixel SPg, and the second protrusion part 130-2 may be removed.

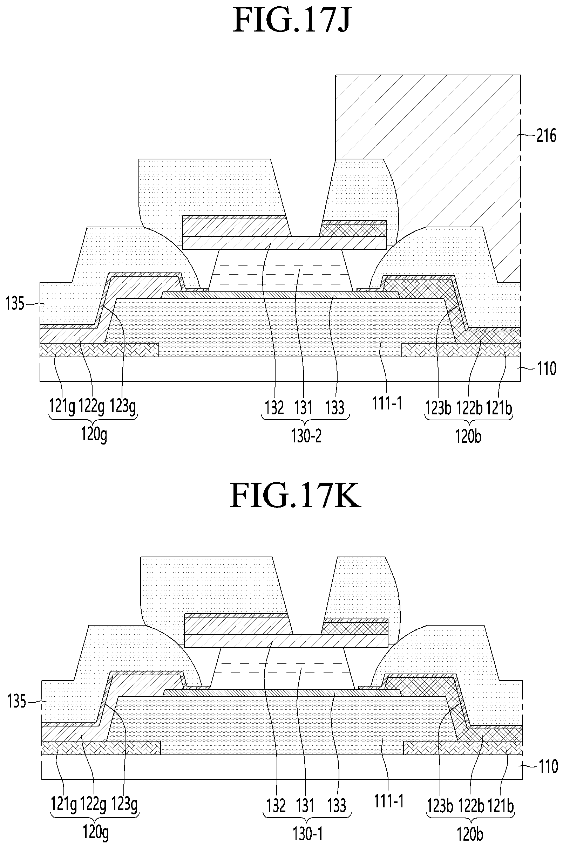

As illustrated in FIG. 17J, the cathode electrode 123b and the blue organic light-emitting layer 122b may be dry etched using the photosensitive pattern 216, so that the cathode electrode 123b and the blue organic light-emitting layer 122b on one side region of the red subpixel SPr, the first protrusion part 130-1, the green subpixel SPg, and the second protrusion part 130-2 may be removed.

As illustrated in FIG. 17K, the photosensitive pattern 216 may be removed. Accordingly, the blue organic light-emitting element 120b and the encapsulation layer 135 may be formed in the blue subpixel SPb.

In the drawing, the area of the green organic light-emitting layer 122g on the upper side of the first protrusion part 130-1 is illustrated to be greater than the area of the blue organic light-emitting layer 122b, but they may have the same area.

Thereafter, an inspection is performed on whether the blue subpixel SPb is complete, and a defect in the blue subpixel SPb may be detected.

As illustrated in FIGS. 15A to 15K, 16A to 16J, and 17A to 17K, **in** a substrate structure using a first **JIT** process, a first bank 111-1 and a first protrusion part 130-1 are formed, and a first connection structure 171 may be formed on a side portion adjacent to a red subpixel SPr in the first protrusion part 130-1 before a red organic light-emitting element 120r is formed.

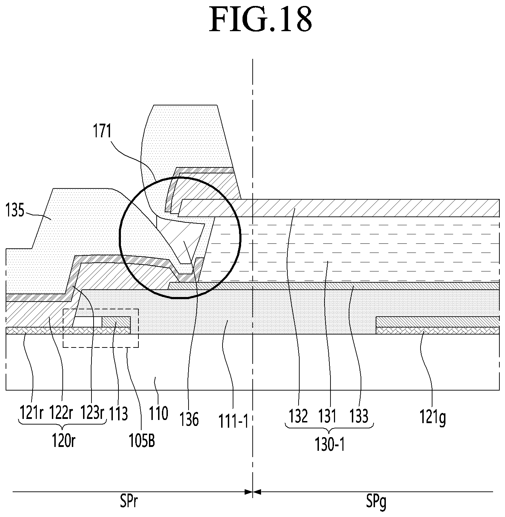

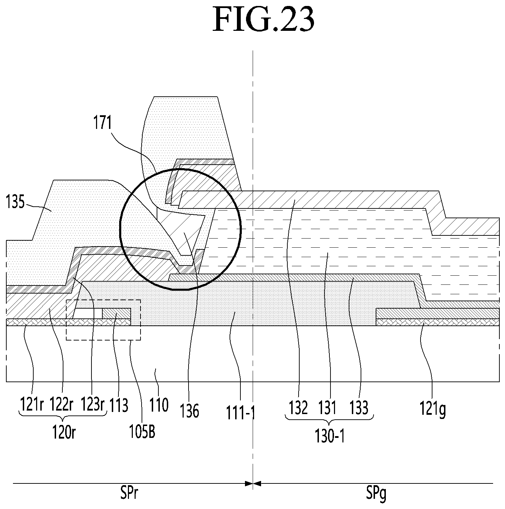

In contrast, as illustrated in FIG. 18, in a substrate structure using a second JIT process technology, the first bank 111-1 and the first connection structure 171 may be formed before a red organic light-emitting element 120r is formed. In addition, as illustrated in FIG. 23, **in** the substrate structure using the third **JIT** process technology, the first bank 111-1 is formed, and the first connection structure 171 may be formed before the red organic light-emitting element 120r is formed.

The open structure 105B formed using the blocking layer 113 is illustrated in FIG. 18 and FIG. 23, but the open structure 105B may be omitted.

Hereinafter, the manufacturing process using the second JIT process technology and the third JIT process technology will be described in more detail.

FIG. 18 illustrates the substrate structure immediately before performing a second JIT process technology. The red subpixel SPr is illustrated in the drawing, but the same may be applied to the green subpixel SPg and the blue subpixel SPb.

As illustrated in FIG. 18, an inorganic film 111a, a third layer 133, a first layer 131, and a second layer 132 may be formed on a substrate 110.

Thereafter, at a time when a red subpixel SPr is formed, the third layer 133, the first layer 131, and the second layer 132 may be etched using a second JIT process technology to form a first connection structure 171, and the inorganic film 111a and the blocking layer 113 may be etched to form a first bank 111-1 and an open structure 105B. At this time, the inorganic film 111a may be etched until the anode electrodes 121r, 121g, and 121b are exposed in the red subpixel SPr.

Thereafter, the red organic light-emitting layer 122r, the cathode electrodes 123r, 123g and 123b, the encapsulation layer 135, etc. may be deposited and patterned, so that the red organic light-emitting element 120r and the encapsulation layer 135 may be formed in the red subpixel SPr.

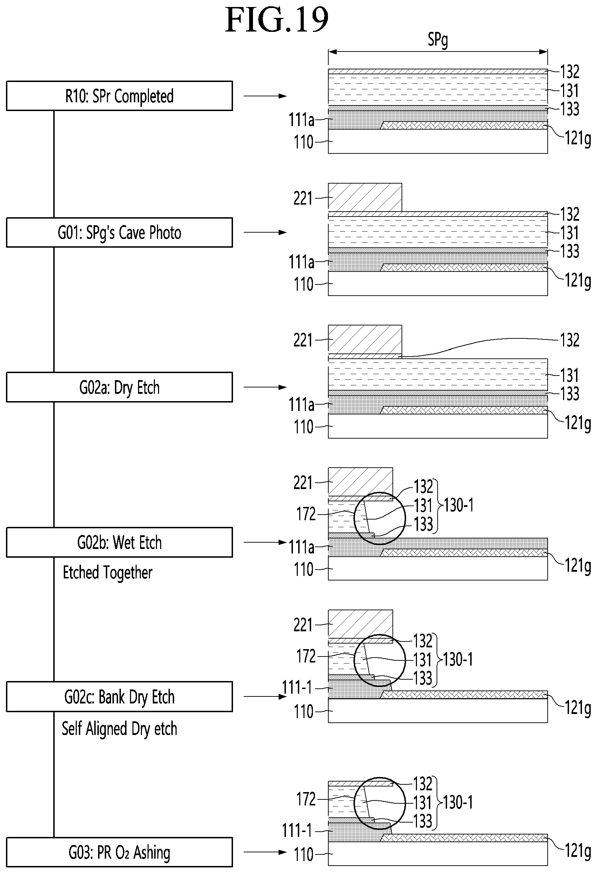

FIG. 19 illustrates a first process of forming a connection structure using the second JIT process technology before forming the green organic light-emitting element. The green subpixel SPg is illustrated in the drawing, but the same may be applied to the red subpixel SPr and the blue subpixel SPb.

In step R10, the red organic light-emitting element 120r may be formed **in** the red subpixel SPr of the substrate 110 (see FIG. 18). At this time, the anode electrodes 121r, 121g, and 121b, the inorganic film 111a, the third layer 133, the first layer 131, and the second layer 132 may be formed on the substrate 110 in the green subpixel SPg. The etching rate of the first layer 131 may be greater than the etching rates of the second layer 132 or the third layer 133.

In step G01, a photosensitive pattern 221 may be formed on the remaining region of the substrate 110 excluding the green subpixel SPg.

In step G02a, the second layer 132 may be dry etched using the photosensitive pattern 221, so that the second layer 132 in the green subpixel SPg may be removed.

In step G02b, the first layer 131 and the third layer 133 may be wet-etched in batch using the photosensitive pattern 221, so that the first layer 131 and the third layer 133 in the green subpixel SPg may be removed. In this instance, the first layer 131 may be etched faster than the third layer 133, so that a first protrusion part 130-1 having a second connecting structure 172 in which a side portion of the first layer 131 is inwardly recessed from a side portion of the second layer 132 or the third layer 133 can be formed. In the drawing, the side portion of the third layer 133 has a shape in which it inwardly recesses further than a side portion of the second layer 132, but is not limited thereto.

In step G02c, the inorganic film 111a may be dry-etched in a self-aligning manner using the photosensitive pattern 221, so that the first bank 111-1 may be formed. Through this self-aligning dry-etching, the end of the first bank 111-1 may be vertically the same with the end of the photosensitive pattern 221 or the second layer 132.

In step G03, the photosensitive pattern 221 may be removed.

Thereafter, a green organic light-emitting element may be formed in the green subpixel SPg.

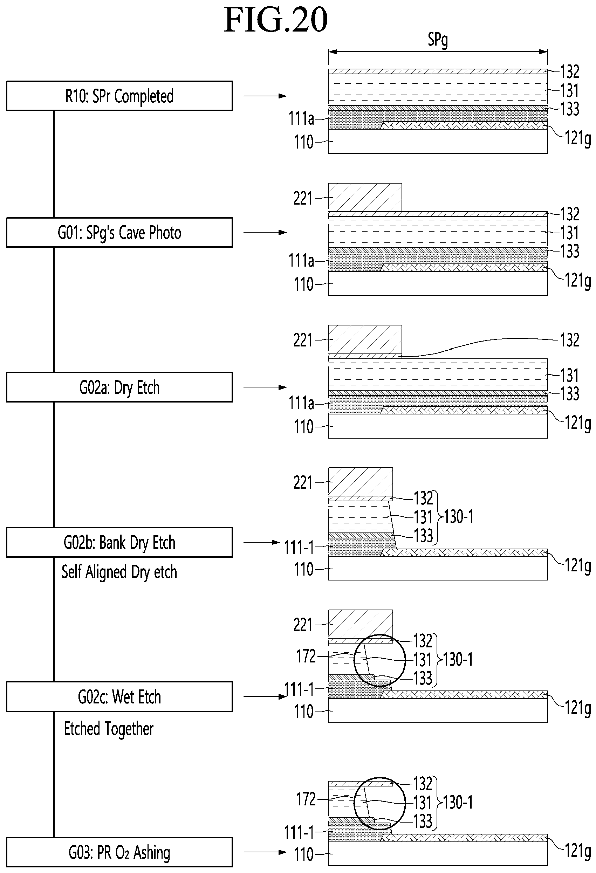

FIG. 20 illustrates a second process of forming a connection structure using a second JIT process technology before forming the green organic light-emitting element. The green subpixel SPg is illustrated in the drawing, but the same may be applied to the red subpixel SPr and the blue subpixel SPb.

Since Step R10, Step G01 and Step G02a are the same as Step R10, Step G01 and Step G02a illustrated in FIG. 19, descriptions thereof are omitted.

In Step G02b, the first layer 131, the third layer 133 and the inorganic film 111a may be dry-etched in a self-aligning manner using the photosensitive pattern 221, so that the first protrusion part 130-1 and the first bank 111-1 may be formed. Due to the dry-etching in a self-aligning manner, the side portion of the first layer 131 may be positioned on the same vertical line or diagonal line as the side portion of the second layer 132 and/or the side portion of the third layer 133.

In Step G02c, the first layer 131 and the third layer 133 may be wet-etched in batch using the photosensitive pattern 221. Accordingly, the first layer 131 may be etched faster than the third layer 133, so that a first protrusion part 130-1 having a second connecting structure 172 inwardly recessed from the side portion of the first layer 131 or the side portion of the third layer 133 may be formed.

In step G03, the photosensitive pattern may be removed.

Thereafter, a green organic light-emitting element may be formed in the green subpixel SPg.

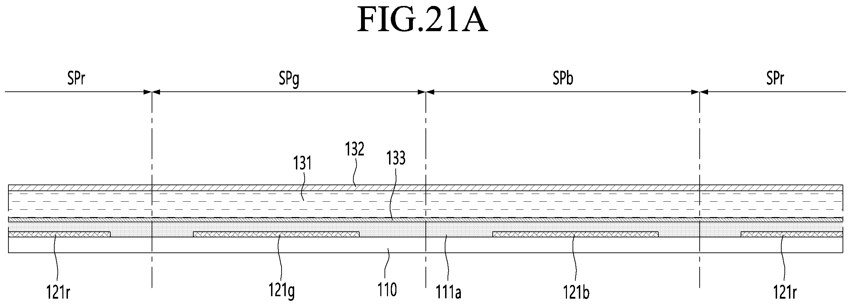

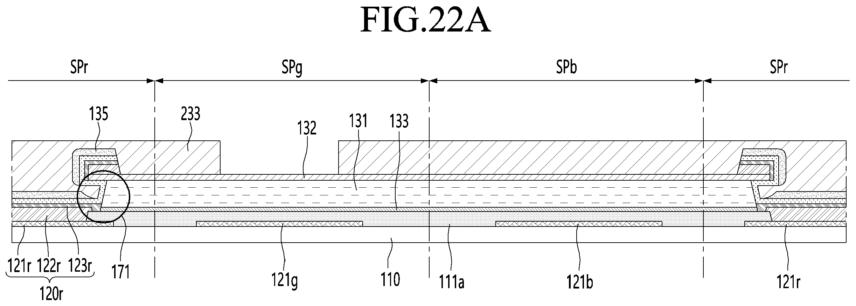

Referring to FIGS. 21A to 21K and FIGS. 22A to 22M, the entire process of forming a red subpixel SPr, a green subpixel SPg, and a blue subpixel SPb using the second JIT process technology will be described. Although the open structure is not illustrated in FIGS. 21A to 21K and FIGS. 22A to 22M, the open structure may be provided.

In the following description, shapes, structures, functions, processes, etc. that overlap with those described above are omitted.

FIGS. 21A to 21K illustrate detailed processes for forming red subpixels using the second JIT process technology.

As illustrated in FIG. 21A, an inorganic film 111a, a third layer 133, a first layer 131, and a second layer 132 may be formed on a substrate 110 comprising a red subpixel SPr, a green subpixel SPg, and a blue subpixel SPb.

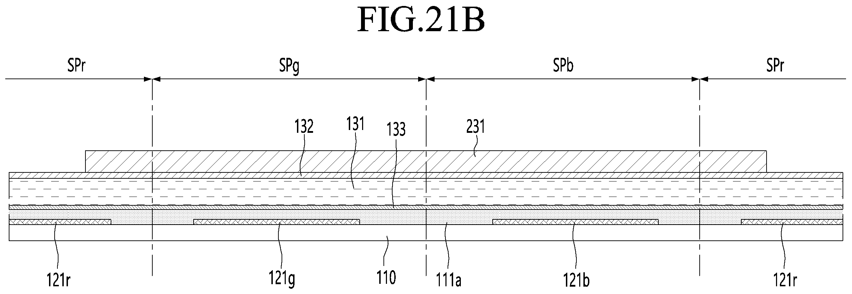

As illustrated in FIG. 21B, a photosensitive pattern 231 may be formed on the remaining region of the substrate 110 excluding the red subpixel SPr. The photosensitive pattern 231 may be formed on the green subpixel SPg and the blue subpixel SPb of the substrate 110. The photosensitive pattern 231 may also be formed on the region between the red subpixel SPr and the green subpixel SPg and the region between the green subpixel SPg and the blue subpixel SPb in the substrate 110.

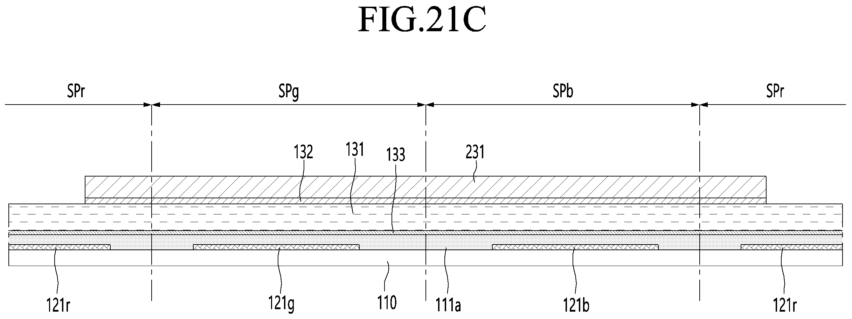

As illustrated in FIG. 21C, the second layer 132 may be dry etched using the photosensitive pattern 231.

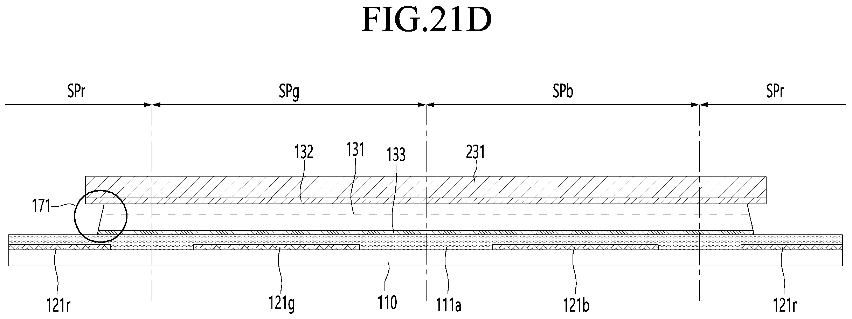

As illustrated in FIG. 21D, the first layer 131 and the third layer 133 may be wet etched in batch using the photosensitive pattern 231, thereby forming the first connection structure 171 in the region contacting the red subpixel SPr. The first connection structure 171 may have an undercut structure or a U-cave.

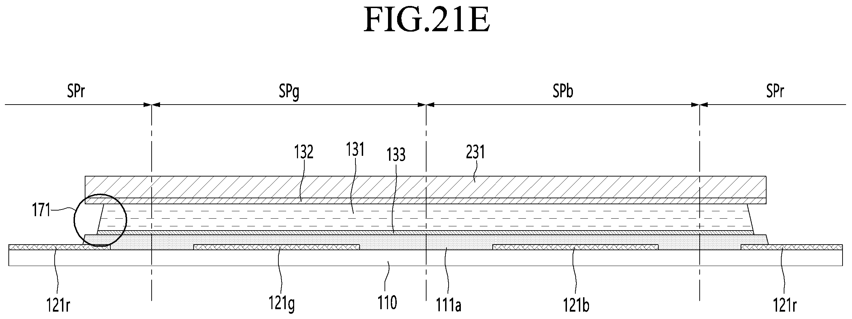

As illustrated in FIG. 21E, the inorganic film 111a may be dry etched using the photosensitive pattern 231 to expose the anode electrode 121r to the red subpixel SPr.

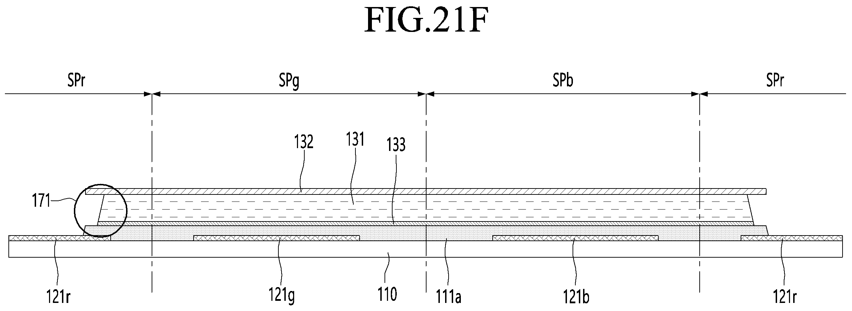

As illustrated in FIG. 21F, the photosensitive pattern 231 may be removed.

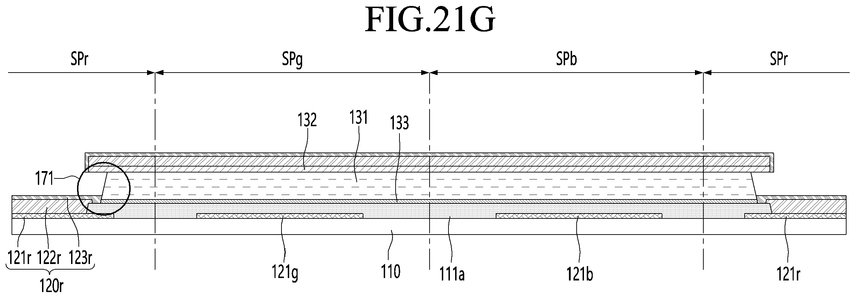

As illustrated in FIG. 21G, a red organic light-emitting layer 122r and a cathode electrode 123r may be deposited on the substrate 110.

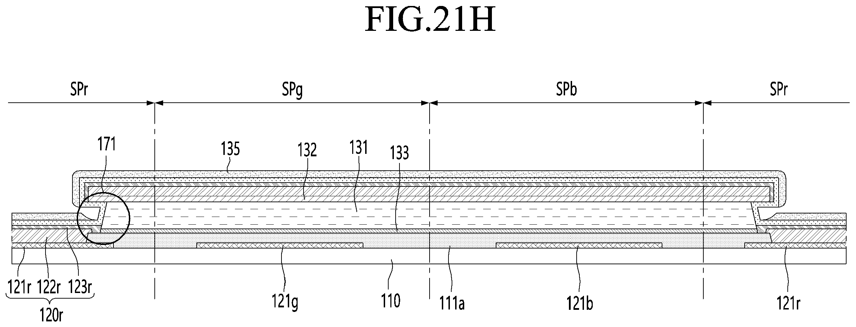

As illustrated in FIG. 21H, an encapsulation layer 135 may be deposited on the cathode electrode 123r. The encapsulation layer 135 may comprise, but is not limited to, a first-first insulating layer comprising an inorganic material such as SiO₂ and a first-second insulating layer comprising an inorganic material such as SiNx.

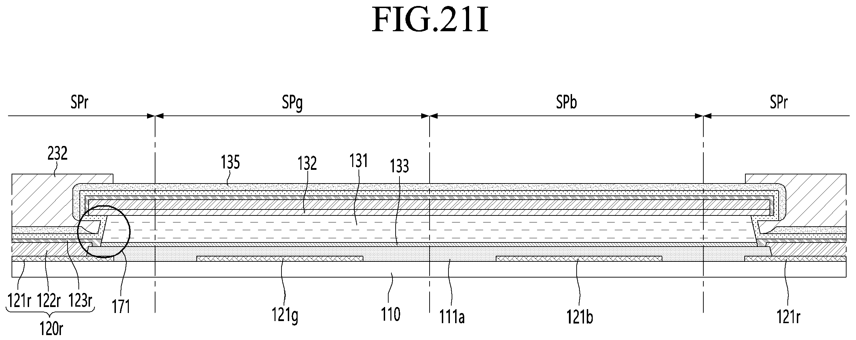

As illustrated in FIG. 21I, a photosensitive pattern 232 may be formed on a red subpixel SPr of the substrate 110. The photosensitive pattern 232 may also be formed on a part of the substrate 110 between the red subpixel SPr and the green subpixel SPg and a part of the substrate 110 between the green subpixel SPg and the blue subpixel SPb.

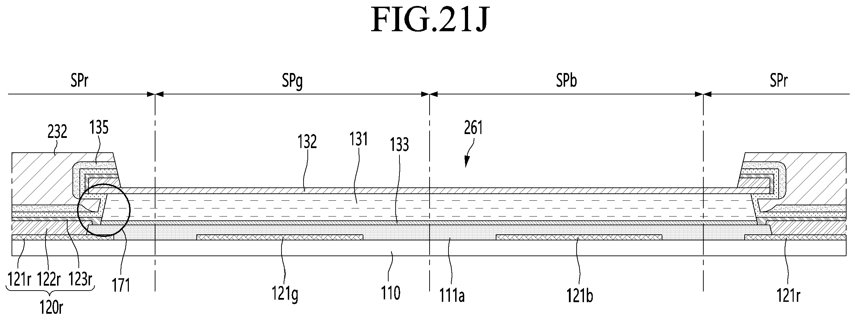

As illustrated in FIG. 21J, the encapsulation layer 135, the cathode electrode 123r, and the red organic light-emitting layer 122r may be dry-etched using the photosensitive pattern 232, so that the encapsulation layer 135, the cathode electrode 123r, and the red organic light-emitting layer 122r in the green subpixel SPg and the blue subpixel SPb may be removed. Accordingly, an opening 261 may be formed in which the second layer 132 is exposed in the green subpixel SPg and the blue subpixel SPb. The encapsulation layer 135, the cathode electrode 123r, and the red organic light-emitting layer 122r on the other part of the substrate 110 between the red subpixel SPr and the green subpixel SPg and on the other part of the substrate 110 between the green subpixel SPg and the blue subpixel SPb may be removed.

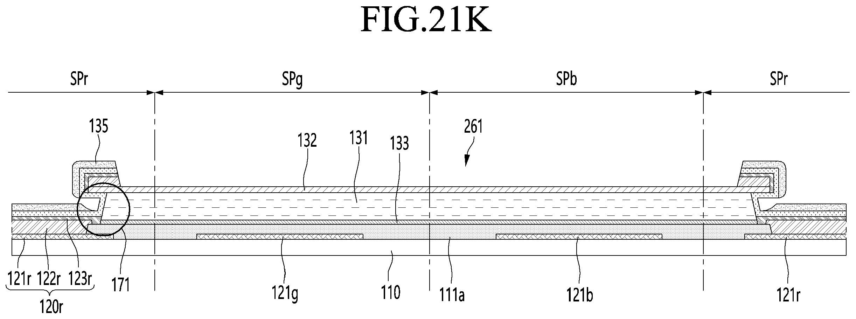

As illustrated in FIG. 21K, the photosensitive pattern 232 may be removed, so that the red subpixel SPr comprising the red organic light-emitting element 120r can be formed.

Thereafter, the green subpixel SPg and the blue subpixel SPb may be formed using the second JIT process technology as illustrated in FIGS. 22A to 22M.

FIGS. 22A to 22M illustrate detailed processes for forming the green subpixel and the blue subpixel using the second JIT process technology.

As illustrated in FIG. 22A, a photosensitive pattern 233 may be formed on the remaining region of the substrate 110 except for the green subpixel SPg. The photosensitive pattern 233 may be formed on the red subpixel SPr and the blue subpixel SPb of the substrate 110. The photosensitive pattern 233 may also be formed on a region between the red subpixel SPr and the green subpixel SPg and a region between the green subpixel SPg and the blue subpixel SPb in the substrate 110.

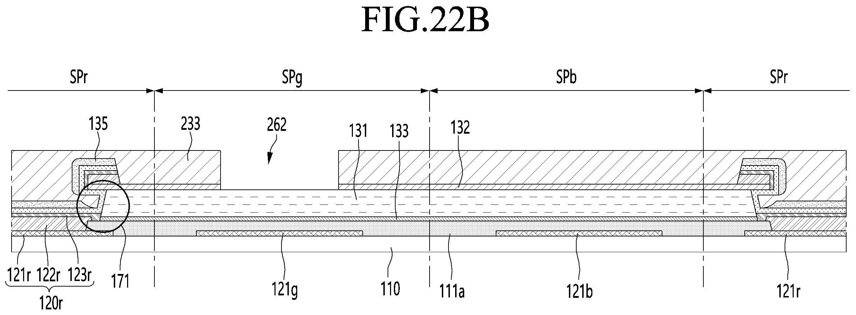

As illustrated in FIG. 22B, the second layer 132 may be dry-etched using the photosensitive pattern 233.

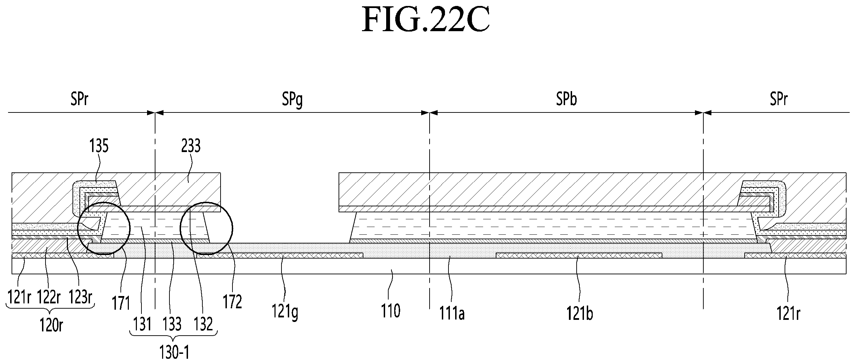

As illustrated in FIG. 22C, the first layer 131 and the third layer 133 may be wet-etched in batch using the photosensitive pattern 233. Accordingly, a second connection structure 172 may be formed in which the side portion of the first layer 131 is inwardly recessed from the side portion of the second layer 132. A first protrusion part 130-1 having the first connection structure 171 and the second connection structure 172 may be formed between the red subpixel SPr and the green subpixel SPg.

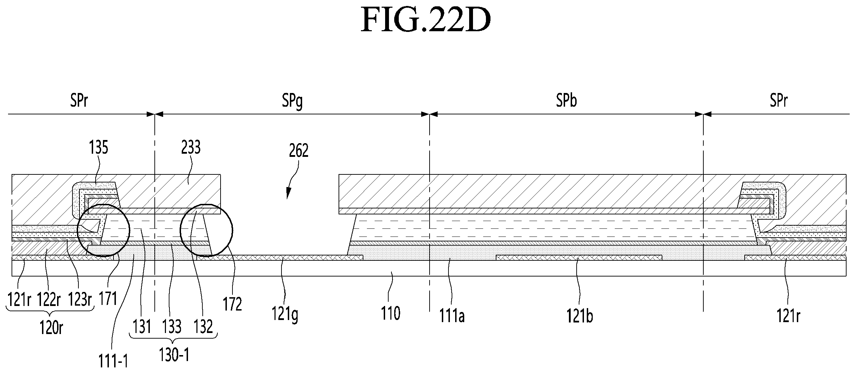

As illustrated in FIG. 22D, the inorganic film 111a may be dry etched using the photosensitive pattern 233. Accordingly, a first bank 111-1 may be formed between the red subpixel SPr and the green subpixel SPg. In this instance, the first protrusion part 130-1 may be formed on the upper side of the first bank 111-1.

Accordingly, an opening 262 may be formed in which the anode electrode 121g is exposed in the green subpixel SPg.

Meanwhile, since the third layer 133 is not etched by the CF₄ and He gases used for dry etching of the inorganic film 111a, the area where the inorganic film 111a is removed may be the same as the area of the removed third layer 133. That is, the side portion of the third layer 133 and the side portion of the first bank 111-1 may be positioned on the same vertical line or diagonal line. Accordingly, the width of the first bank 111-1 may become narrower, and inversely, the aperture region of the green subpixel SPg may become larger.

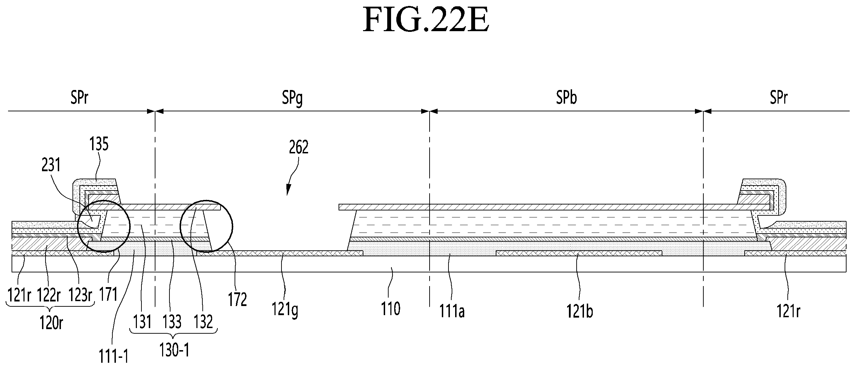

As illustrated in FIG. 22E, the photosensitive pattern 233 may be removed. In this instance, the photosensitive pattern 233 formed on the first connecting structure 171 may not be removed and may remain as a residual film 241.

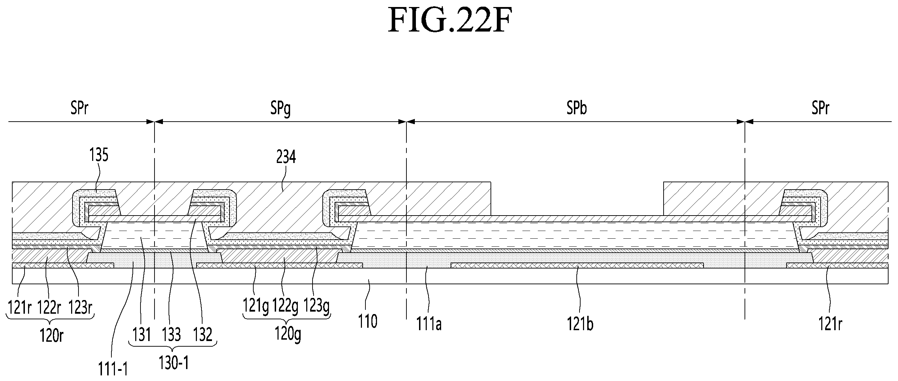

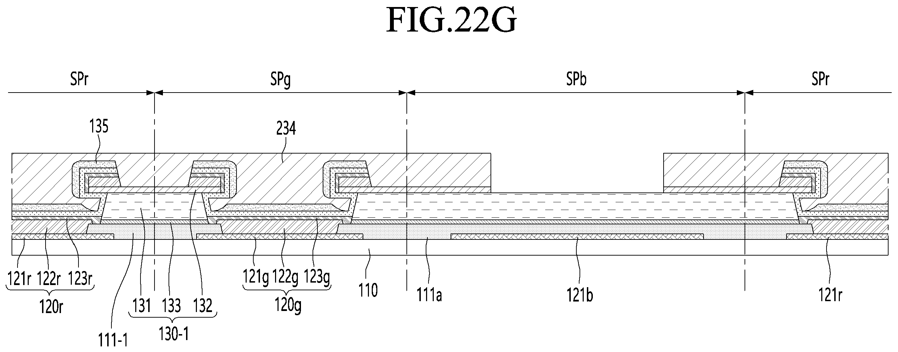

As illustrated in FIG. 22F, a green subpixel SPg comprising a green organic light-emitting element 120g may be formed. Since the process of forming the green organic light-emitting element 120g is the same as the process of forming the red organic light-emitting element 120r described above (FIGS. 22G to 22K), a detailed description thereof will be omitted.

Meanwhile, after the green subpixel SPg is formed, a photosensitive pattern 234 may be formed on the remaining region of the substrate 110 excluding the blue subpixel SPb. The photosensitive pattern 234 may be formed on the red subpixel SPr and the green subpixel SPg of the substrate 110. The photosensitive pattern 234 may also be formed on a region between the red subpixel SPr and the green subpixel SPg and a region between the green subpixel SPg and the blue subpixel SPb on the substrate 110.

As illustrated in FIG. 22G, the second layer 132 may be dry-etched using the photosensitive pattern 234.

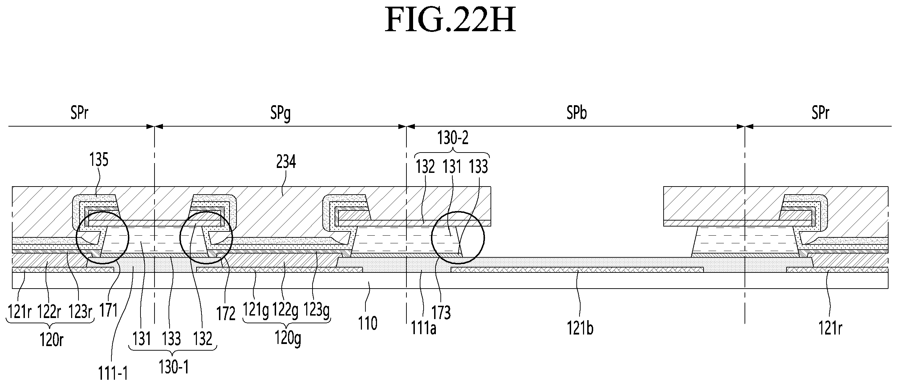

As illustrated in FIG. 22H, the first layer 131 and the third layer 133 may be wet-etched in batch using the photosensitive pattern 234. Accordingly, a third connection structure 173 may be formed in which the side portion of the first layer 131 is inwardly recessed from the side portion of the second layer 132. A second protrusion part 130-2 having the second connection structure 172 and the third connection structure 173 may be formed between the green subpixel SPg and the blue subpixel SPb.

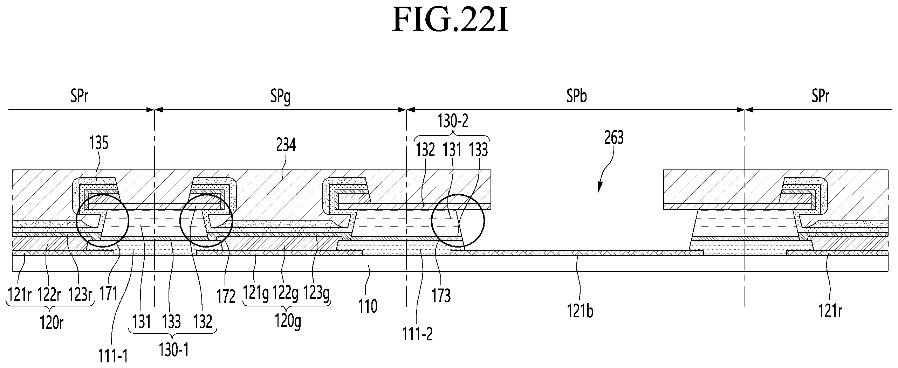

As illustrated in FIG. 22I, the inorganic film 111a may be dry-etched using the photosensitive pattern 234. Accordingly, a second bank 111-2 may be formed between the green subpixel SPg and the blue subpixel SPb. In this instance, a second protrusion part 130-2 may be formed on an upper side of the second bank 111-2.

Accordingly, an opening 263 may be formed in which the anode electrode 121b is exposed in the blue subpixel SPb.

Meanwhile, since the third layer 133 is not etched by the CF₄ and He gases used for dry etching of the inorganic film 111a, the area from which the inorganic film 111a is removed may be the same as the area of the removed third layer 133. That is, the side portion of the third layer 133 and the side portion of the second bank 111-2 may be positioned on the same vertical line or diagonal line. Accordingly, the width of the second bank 111-2 may become narrower, and inversely, the aperture region of the blue subpixel SPb may become larger.

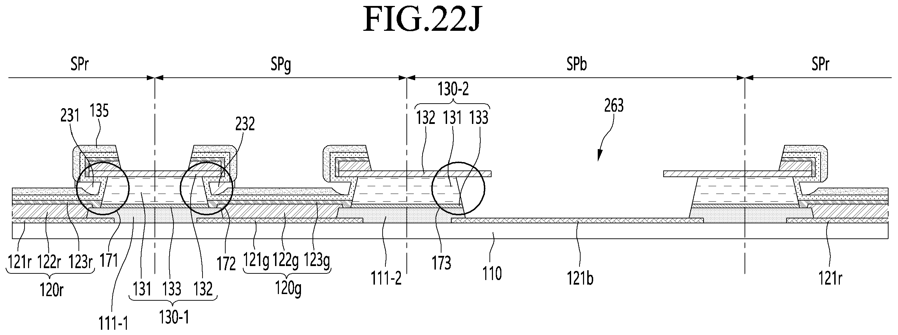

As illustrated in FIG. 22J, the photosensitive pattern 234 may be removed. In this instance, the photosensitive pattern 234 formed in the second connection structure 172 may not be removed and may remain as a residual film 242.

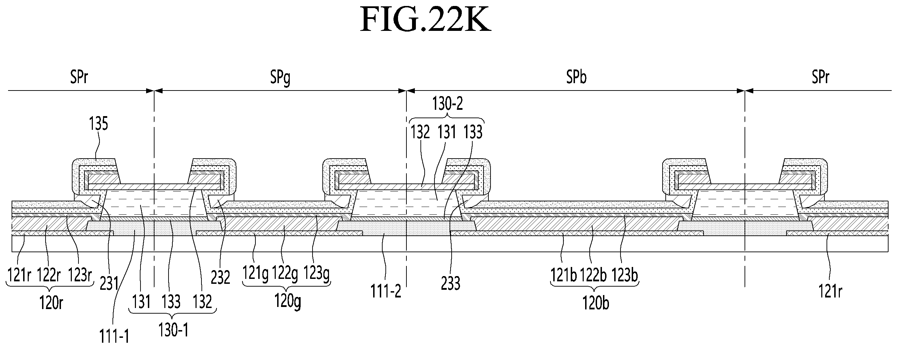

As illustrated in FIG. 22K, a blue subpixel SPb comprising a blue organic light-emitting element 120b may be formed. The process of forming the blue organic light-emitting element 120b is the same as the process of forming the red organic light-emitting element 120r described above (FIGS. 22G to 22K), and therefore, a detailed description thereof will be omitted.

When the photosensitive pattern (not illustrated) is removed after the blue organic light-emitting element 120b is formed on the blue subpixel SPb, the photosensitive pattern formed on the third connection structure 173 may not be removed and may remain as a residual film 243.

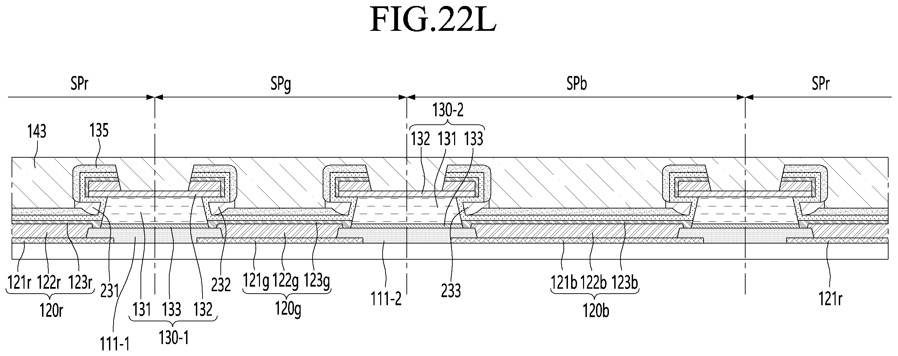

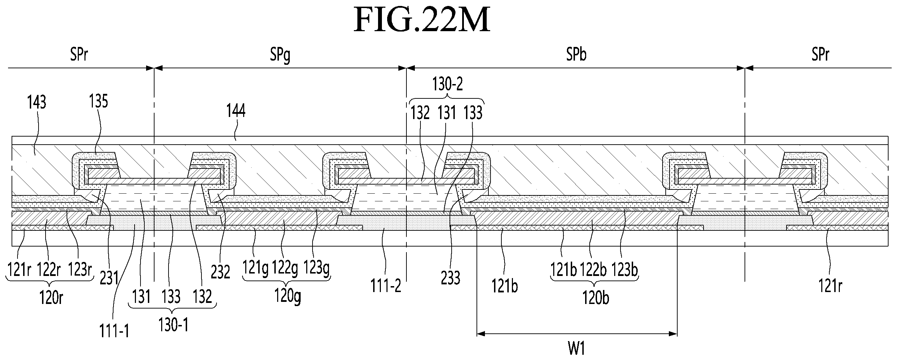

As illustrated in FIGS. 22L and 22M, a plurality of encapsulation layers 143 and 144 may be formed on the substrate 110. The encapsulation layers 143 and 144 may comprise organic or inorganic materials having excellent insulation properties and moisture penetration blocking performance.

The encapsulation layer 143 may be formed through an inkjet process, and the encapsulation layer 144 may be formed through a PECVD process, but are not limited thereto.

An organic light-emitting display device may be manufactured through a series of processes as described above.

**In** the above, it is described that the red subpixel SPr, the green subpixel SPg, and the blue subpixel SPb are formed in that order, but the order may be changed.

FIG. 23 illustrates a substrate structure immediately before performing the third JIT process technology. The red subpixel SPr is illustrated in the drawing, but the same may be applied to the green subpixel SPg and the blue subpixel SPb.

As illustrated in FIG. 23, a first bank 111-1 may be formed on the substrate 110. A third layer 133, a first layer 131, and a second layer 132 may be formed on the first bank 111-1.

Thereafter, at the time when the red subpixel SPr is formed, the third layer 133, the first layer 131, and the second layer 132 may be etched using the third JIT process technology to form the first connection structure 171. By etching the third layer 133, the first layer 131, and the second layer 132, the anode electrode 121r, 121g, and 121b in the red subpixel SPr may be exposed.

The blocking layer 113 may be etched using the third JIT process technology to form the open structure 105B.

Thereafter, the red organic light-emitting layer 122r, the cathode electrode 123r, the encapsulation layer 135, etc. may be deposited and patterned, so that the red organic light-emitting element 120r and the encapsulation layer 135 may be formed in the red subpixel SPr.

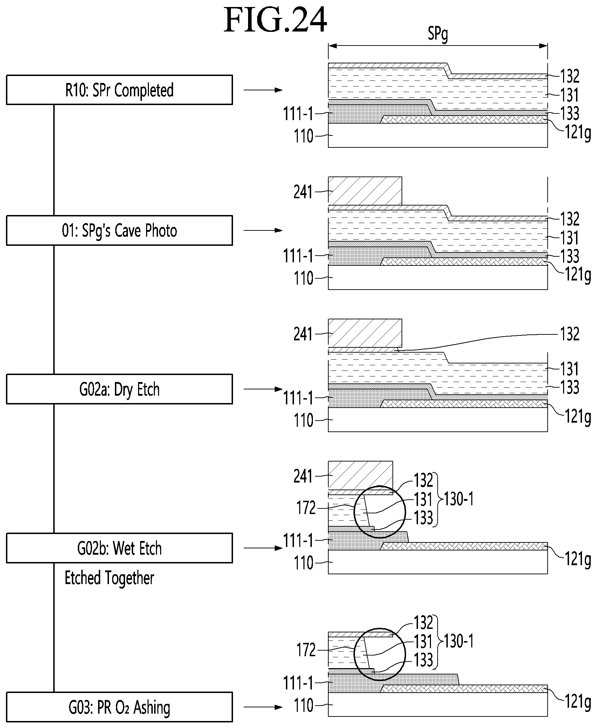

FIG. 24 illustrates a process of forming a connection structure before forming a green organic light-emitting element using a third JIT process technology. The drawing illustrates a green subpixel SPg, but the same may be applied to a red subpixel SPr and a blue subpixel SPb.

In step R10, a red organic light-emitting element 120r may be formed on a red subpixel SPr of a substrate 110 (see FIG. 23). At this time, an anode electrode 121r, 121g, and 121b, a third layer 133, a first layer 131, and a second layer 132 may be formed on the green subpixel SPg on the substrate 110. The etching rate of the first layer 131 may be greater than the etching rates of the second layer 132 or the third layer 133. In addition, a first bank 111-1 may be formed between the red subpixel SPr and the green subpixel SPg.

In step G01, a photosensitive pattern 241 may be formed on the remaining region of the substrate 110 excluding the green subpixel SPg.

In step G02a, a second layer 132 may be dry etched using the photosensitive pattern 241, so that the second layer 132 in the green subpixel SPg may be removed.

In step G02b, the first layer 131 and the third layer 133 may be wet-etched in batch using the photosensitive pattern 241, so that the first layer 131 and the third layer 133 in the green subpixel SPg may be removed. In this instance, the first layer 131 may be etched faster than the third layer 133, so that a first protrusion part 130-1 having a second connecting structure 172 in which a side portion of the first layer 131 is inwardly recessed from a side portion of the second layer 132 or the third layer 133 may be formed. In the drawing, the side portion of the third layer 133 has a shape in which it inwardly recesses further than a side portion of the second layer 132, but is not limited thereto.

In step G03, the photosensitive pattern 241 may be removed.

Thereafter, a green organic light-emitting element may be formed in the green subpixel SPg.

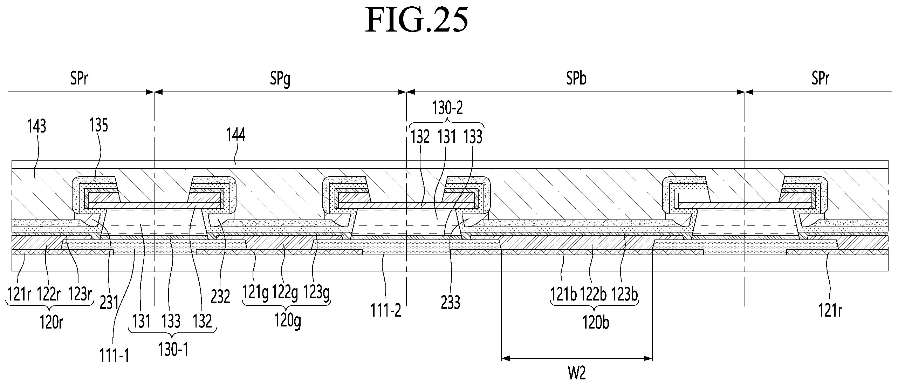

FIG. 25 illustrates an organic light-emitting display device manufactured using the third JIT process technology.

As illustrated in FIG. 25, the width W2 of the aperture region in the organic light-emitting display device manufactured using the third JIT process technology may be smaller than the width W1 of the aperture region in the organic light-emitting display device manufactured using the second JIT process technology (FIG. 22M).

As described above, when the second JIT process technology is used, the width W1 of the aperture region of the green subpixel SPg or the blue subpixel SPb may increase as the width of the first bank 111-1 or the second bank 111-2 formed by the removal of the inorganic film 111a decreases.

From this, it may be seen that the second JIT process technology is more advantageous than the third JIT process technology in expanding the width of the aperture region.

## Claims

1. A method for manufacturing an organic light-emitting display device, comprising:
forming an anode electrode in each of a red subpixel, a green subpixel, and a blue subpixel on a substrate;
forming a first bank between the red subpixel and the green subpixel and a second bank between the green subpixel and the blue subpixel;
forming a first protrusion part and a second protrusion part on each of the first bank and the second bank, respectively;
forming a first connection structure on a first side portion of the first protrusion part adjacent to the red subpixel, and forming a first organic light-emitting element on the red subpixel using a first photolithography process;
forming a second connection structure on a second side portion of the first protrusion part adjacent to the green subpixel and a first side portion of the second protrusion part, and forming a second organic light-emitting element on the green subpixel using a second photolithography process; and
forming a third connection structure on a second side portion of the second protrusion part adjacent to the blue subpixel, and forming a third organic light-emitting element in the blue subpixel using a third photolithography process,
wherein the first organic light-emitting element to the third organic light-emitting element each comprises the anode electrode, an organic light-emitting layer comprising a hole injection layer, and a cathode electrode,
wherein the first connection structure to the third connection structure each comprises an auxiliary electrode electrically connected to the cathode electrode in contact with an end of the hole injection layer, and
wherein the forming of the first bank and the second bank comprises:
forming an open structure configured to isolate the hole injection layer in the first bank and the second bank, respectively.

2. The method of claim 1, wherein the forming of the open structure comprises:
forming a blocking layer that is inwardly recessed from a first side portion and a second side portion of the first bank and a first side portion and a second side portion of the second bank, respectively.

3. The method of claim 1, wherein the forming of the first organic light-emitting element comprises:
depositing and patterning a first organic light-emitting layer comprising a first hole injection layer and a first cathode electrode on the substrate to form the first organic light-emitting layer and the first cathode electrode on the red subpixel and the first bank, and
wherein the first cathode electrode is in contact with an end of the first hole injection layer and the auxiliary electrode of the first connection structure.

4. The method of claim 3, wherein the first organic light-emitting layer is configured to be isolated corresponding to a first open structure formed on the first side portion of the first bank.

5. The method of claim 3, wherein the forming of the second organic light-emitting element comprises:
depositing and patterning a second organic light-emitting layer comprising a second hole injection layer and a second cathode electrode on the substrate to form the second organic light-emitting layer and the second cathode electrode on the green subpixel, the first bank, and the second bank, and
wherein the second cathode electrode is in contact with an end of the second hole injection layer and the auxiliary electrode of the second connection structure.

6. The method of claim 5, wherein the second organic light-emitting layer is configured to be isolated corresponding to a second open structure formed on the second side portion of the first bank and the first side portion of the second bank.

7. The method of claim 5, wherein the forming of the third organic light-emitting element comprises:
depositing and patterning a third organic light-emitting layer comprising a third hole injection layer and a third cathode electrode on the substrate to form the third organic light-emitting layer and the third cathode electrode on the blue subpixel and the second bank, and
wherein the third cathode electrode is in contact with an end of the third hole injection layer and the auxiliary electrode of the third connection structure.

8. The method of claim 7, wherein the third organic light-emitting layer is configured to be isolated corresponding to a third open structure formed on the second side portion of the second bank.

9. The method of claim 1, wherein the forming of the cathode electrode comprises:
forming a first conductive layer configured to electrically connect to the auxiliary electrode, and
wherein the first challenge layer comprises a Mg:Ag alloy.

10. The method of claim 1, wherein the forming of the cathode electrode comprises:
forming a first conductive layer; and
forming a second conductive layer on the first conductive layer to electrically connect to the auxiliary electrode,
wherein the first conductive layer comprises a Mg:Ag alloy, and
wherein the second conductive layer comprises a transparent conductive oxide material.

11. The method of claim 1, further comprising:
forming a first color filter layer to a third color filter layer on the first organic light-emitting element to the third organic light-emitting element.

12. The method of claim 1, further comprising:
forming an encapsulation layer on the first organic light-emitting element, the second organic light-emitting element, and the third organic light-emitting element.
